# EUROPEAN PATENT APPLICATION

(11) **EP 2 320 274 A1**
(43) Date of publication of application: **11.05.2011**
(21) Application number: 09808300.9
(22) Date of filing: 20.08.2009
(51) Int. Cl.: G03F 7/32, G03F 7/00, G03F 7/028, G03F 7/032, G03F 7/11

(54) **PROCESS FOR PRODUCING LITHOGRAPHIC PRINTING PLATE**

(30) Priority: 22.08.2008 JP 2008214507; 04.12.2008 JP 2008309666
(71) Applicant: FUJIFILM Corporation, Tokyo 106-0031 (JP)
(72) Inventor: KAWAUCHI, Ikuo, Haibara-gun,Shizuoka (JP); INNO, Toshifumi, Haibara-gun, Shizuoka (JP); KURAMOTO, Mamoru, Haibara-gun, Shizuoka (JP); ADACHI, Keiichi, Haibara-gun, Shizuoka (JP)
(74) Representative: HOFFMANN EITLE
(86) International application number: PCT/JP2009/064586
(87) International publication number: WO 2010/021364

(57) **Abstract**

According to a method of preparing a lithographic printing plate substantially comprising a step of imagewise exposing a negative lithographic printing plate precursor having an image-recording layer containing (i) a sensitizing dye, (ii) a photopolymerization initiator, (iii) an addition polymerizable compound having an ethylenically unsaturated double bond and (iv) a binder polymer on a support and a step of processing the exposed lithographic printing plate precursor with an aqueous solution containing a carbonate ion, a hydrogen carbonate ion and a surfactant, the processing property is improved, a printing plate free from the tackiness on the surface thereof can be provided, even when the printing plate is stored after the development until printing, deterioration of the printing durability does not occur, and it becomes possible to conduct one solution development with a weak alkaline processing solution.

## Description

### TECHNICAL FIELD

The present invention relates to a method of preparing a lithographic printing plate, in particular, to a method of preparing a lithographic printing plate which is excellent in processing property and enables processing with one solution.

### BACKGROUND ART

In general, a lithographic printing plate is composed of an oleophilic image area accepting ink and a hydrophilic non-image area accepting dampening water in the process of printing. Lithographic printing is a printing method which comprises rendering the oleophilic image area of the lithographic printing plate to an ink-receptive area and the hydrophilic non-image area thereof to a dampening water-receptive area (ink unreceptive area), thereby making a difference in adherence of ink on the surface of the lithographic printing plate, and depositing the ink only on the image area by utilizing the nature of water and printing ink to repel with each other, and then transferring the ink to a printing material, for example, paper.
In order to prepare the lithographic printing plate, a lithographic printing plate precursor (PS plate) comprising a hydrophilic support having provided thereon an oleophilic photosensitive resin layer (a photosensitive layer or an image-recording layer) has heretofore been broadly used. Ordinarily, the lithographic printing plate is obtained by conducting plate making according to a method of exposing the lithographic printing plate precursor through an original, for example, a lith film, and then while leaving the image-recording layer in the portion for forming the image area, removing the unnecessary image-recording layer other than the image area by dissolving with an alkaline developer or an organic solvent thereby revealing the hydrophilic surface of support to form the non-image area.

Thus, in the hitherto known plate making process of lithographic printing plate precursor, after exposure, the step of removing the unnecessary portion of the image-recording layer by dissolving with a developer or the like is required. However, in view of the environment and safety, a processing with a developer closer to a neutral range and a small amount of waste liquid are problems to be solved. Particularly, since disposal of waste liquid discharged accompanying the wet treatment has become a great concern throughout the field of industry in view of the consideration for global environment in recent years, the demand for the resolution of the above-described problems has been increased more and more.

On the other hand, digitalized technique of electronically processing, accumulating and outputting image information using a computer has been popularized in recent years, and various new image outputting systems responding to the digitalized technique have been put into practical use. Correspondingly, attention has been drawn to a computer-to-plate (CTP) technique of carrying digitalized image information on highly converging radiation, for example, laser light and conducting scanning exposure of a lithographic printing plate precursor with the light thereby directly preparing a lithographic printing plate without using a lith film. Thus, it is one of important technical subjects to obtain a lithographic printing plate precursor adaptable to the technique described above.

As described above, the decrease in alkali concentration of developer and the simplification of processing step have been further strongly required from both aspects of the consideration for global environment and the adaptation for space saving and low running cost. However, since conventional development processing step comprises three steps of developing with an aqueous alkali solution having pH of 11 or more, washing of the alkali agent with a water washing bath and then treating with a gum solution mainly comprising a hydrophilic resin as described above, an automatic developing machine per se requires a large space and problems of the environment and running cost, for example, disposal of the development waste liquid, water washing waste liquid and gum waste liquid still remain.

In response to the above situation, for instance, in Patent Document 1, a developing method of processing with a developer having pH from 8.5 to 11.5 and a dielectric constant from 3 to 30 mS/cm and containing an alkali metal carbonate and an alkali metal hydrogen carbonate is proposed. However, since the developing method is required a water washing step and a treatment step with a gum solution, it does not resolve the problems of the environment and running cost.
Also, processing with a processing solution having pH from 11.9 to 12.1 and containing a water-soluble polymer compound is described in the example of Patent Document 2. However, since the printing plate obtained by the processing is left in the state that the alkali of pH 12 adheres on the surface thereof, a problem in view of safety of an operator arises and in addition, with the lapse of long time after the preparation of the printing plate until printing, the image area gradually dissolves to result in deterioration of printing durability and ink-receptive property. In Patent Document 3, processing with a processing solution having pH from 3 to 9 and containing a water-soluble polymer compound is described. However, since the processing solution does not contain a base component, it is necessary to make a binder polymer in the photosensitive layer hydrophilic to enable development thereby causing a problem of severe deterioration of printing durability. In Patent Document 4, a method of preparing a printing plate in which development processing is conducted using an aqueous solution containing substantially a surfactant, a water-soluble film-forming hydrophilic polymer and an alkali agent in an amount necessary for adjusting a pH of the solution to 9.5 to 14 and after that a gum treatment step is not conducted is described. However, there is no description with respect to combination use of a carbonate ion and a hydrogen carbonate ion. Further, the method is still insufficient in view of processing ability, tackiness of a plate surface after development, development scum, repeated running aptitude (image reproducibility when continuously processed) or the like.

### PRIOR ART DOCUMENT

### PATENT DOCUMENT

Patent Document 1: JP-A- 11-65126
Patent Document 2: EP-A-1868036
Patent Document 3: JP-T-2007-538279
Patent Document 4: WO 2007/144096

### DISCLOSURE OF THE INVENTION

### PROBLEMS THAT THE INVENTION IS TO SOLVE

Accordingly, an object of the invention is to provide a method of preparing a lithographic printing plate which overcomes the drawbacks of the prior art described above, specifically to provide a method of preparing a lithographic printing plate which is safe, exhibits excellent processing property, does not cause tackiness of a surface of printing plate, prepares a printing plate which does not cause deterioration of printing durability even when stored after the development until printing, and enables processing with one solution.

### MEANS FOR SOLVING THE PROBLEMS

As a result of the intensive investigation, the inventor has found that the above-described object can be achieved by the constitution described below to complete the invention.
Specifically, the invention is as follows.

(1) A method of preparing a lithographic printing plate substantially comprising a step of imagewise exposing a negative lithographic printing plate precursor having an image-recording layer containing (i), (ii), (iii) and (iv) shown below on a support and a step of processing the exposed lithographic printing plate precursor with an aqueous solution containing a carbonate ion, a hydrogen carbonate ion and a surfactant:
   (i) a sensitizing dye,
   (ii) a photopolymerization initiator,
   (iii) an addition polymerizable compound having an ethylenically unsaturated double bond,
   (iv) a binder polymer.
(2) The method of preparing a lithographic printing plate as described in (1) above, wherein the aqueous solution does not contain a water-soluble polymer compound.
(3) The method of preparing a lithographic printing plate as described in (1) or (2) above, wherein (i) the sensitizing dye has an absorption maximum in a wavelength range from 350 to 450 nm.
(4) The method of preparing a lithographic printing plate as described in (3) above, wherein (i) the sensitizing dye is a sensitizing dye represented by any of formulae (1) to (5) shown below:

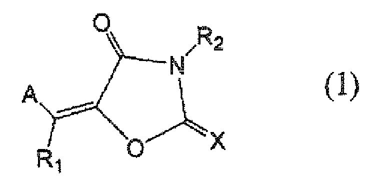

(in formula (1), A represents an aromatic cyclic group which may have a substituent or a heterocyclic group which may have a substituent, X represents an oxygen atom, a sulfur atom or N-(R₃), and R₁, R₂ and R₃ each independently represents a monovalent non-metallic atomic group, or A and R₁ or R₂ and R₃ may be combined with each other to form an aliphatic or aromatic ring);

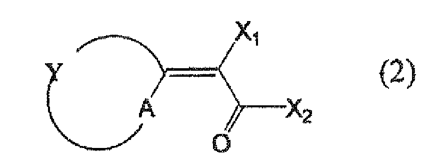

(in formula (2), A represents a sulfur atom or NR₆, R₆ represents a monovalent non-metallic atomic group, Y represents a non-metallic atomic group necessary for forming a basic nucleus of the dye together with adjacent A and the adjacent carbon atom, and X₁ and X₂ each independently represents a monovalent non-metallic atomic group or X₁ and X₂ may be combined with each other to form an acidic nucleus of the dye);

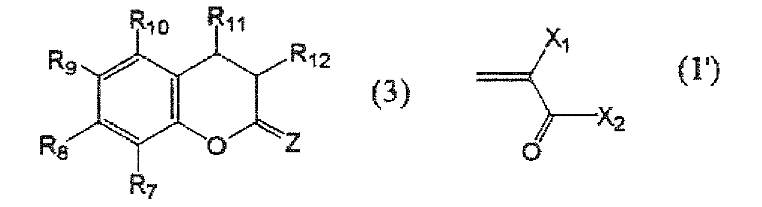

(in formula (3), =Z represents an oxo group, a thioxo group, an imino group or an alkylydene group represented by a partial structural formula (1') described above, X₁ and X₂ have the same meanings as defined in formula (2) respectively, and R₇ to R₁₂ each independently represents a monovalent non-metallic atomic group);

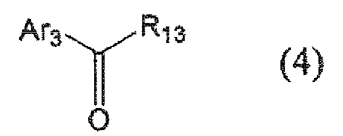

(in formula (4), Ar₃ represents an aromatic group which may have a substituent or a heteroaromatic group which may have a substituent, R₁₃ represents a monovalent non-metallic atomic group, or Ar₃ and R₁₃ may be combined with each other to form a ring);

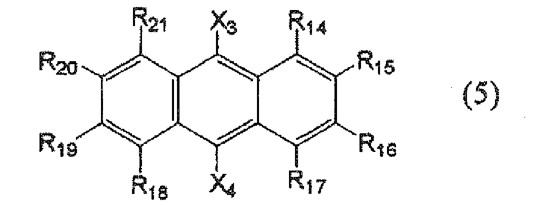

(in formula (5), X₃, X₄ and R₁₄ to R₂₁ each independently represents a monovalent non-metallic atomic group).
(5) The method of preparing a lithographic printing plate as described in (3) above, wherein (i) the sensitizing dye is a sensitizing dye represented by formula (I), (II) or (III) shown below:

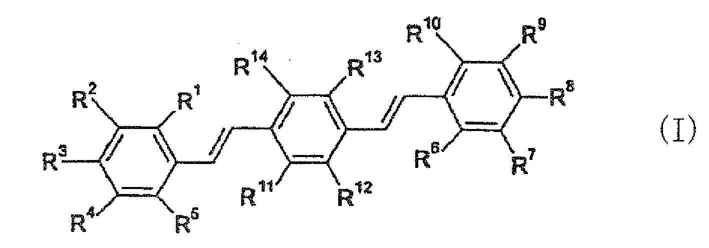

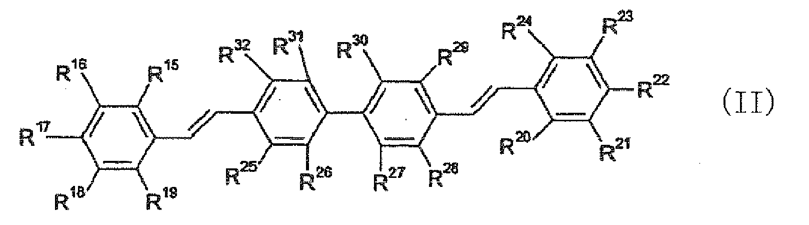

In formula (I), R¹ to R¹⁴ each independently represents a hydrogen atom, an alkyl group, an alkoxy group, a cyano group or a halogen atom, provided that at least one of R¹ to R¹⁰ represents an alkoxy group having 2 or more carbon atoms.
In formula (II), R¹⁵ to R³² each independently represents a hydrogen atom, an alkyl group, an alkoxy group, a cyano group or a halogen atom, provided that at least one of R¹⁵ to R²⁴ represents an alkoxy group having 2 or more carbon atoms.

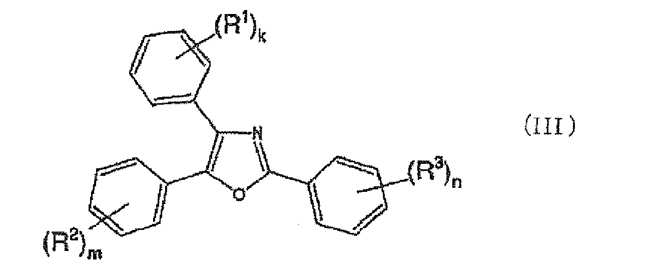

In formula (III), R¹, R² and R³ each independently represents a halogen atom, an alkyl group which may have a substituent, an aryl group which may have a substituent, an aralkyl group which may have a substituent, an -NR⁴R⁵ group or an -OR⁶ group, R⁴, R⁵ and R⁶ each independently represents a hydrogen atom, an alkyl group which may have a substituent, an aryl group which may have a substituent or an aralkyl group which may have a substituent, and k, m and n each represents an integer from 0 to 5.
(6) The method of preparing a lithographic printing plate as described in any one of (1) to (5) above, wherein the step of imagewise exposure is conducted using laser emitting light from 350 to 450 nm.
(7) The method of preparing a lithographic printing plate as described in any one of (1) to (6) above, wherein pH of the aqueous solution is from 8.5 to 10.8.
(8) The method of preparing a lithographic printing plate as described in any one of (1) to (7) above, wherein (iv) the binder polymer has an acid group in its side chain.
(9) The method of preparing a lithographic printing plate as described in (8) above, wherein the acid group is a carboxylic acid group.
(10) The method of preparing a lithographic printing plate as described in any one of (1) to (9) above, wherein the lithographic printing plate precursor has a protective layer on the image-recording layer.
(11) The method of preparing a lithographic printing plate as described in (10) above, wherein the protective layer contains an acid-modified polyvinyl alcohol.
(12) The method of preparing a lithographic printing plate as described in any one of (1) to (11) above, wherein the processing with an aqueous solution is conducted with one solution.
(13) The method of preparing a lithographic printing plate as described in any one of (1) to (11) above, wherein the processing with an aqueous solution is conducted with one bath.
(14) A lithographic printing plate precursor which is used in the method of preparing a lithographic printing plate as described in any one of (1) to (13) above.

### ADVANTAGE OF THE INVENTION

The method of preparing a lithographic printing plate according to the invention is excellent in the processing property and provides a printing plate free from the tackiness on the surface thereof Further, even when the printing plate is preserved after the development until printing, deterioration of the printing durability does not occur. Moreover, since it becomes possible to conduct one solution development with a weak alkaline processing solution, advantages, for example, simplification of processing steps, consideration for global environment and adaptation for space saving and low running cost can be provided.

### BRIEF DESCRIPTION OF THE DRAWING

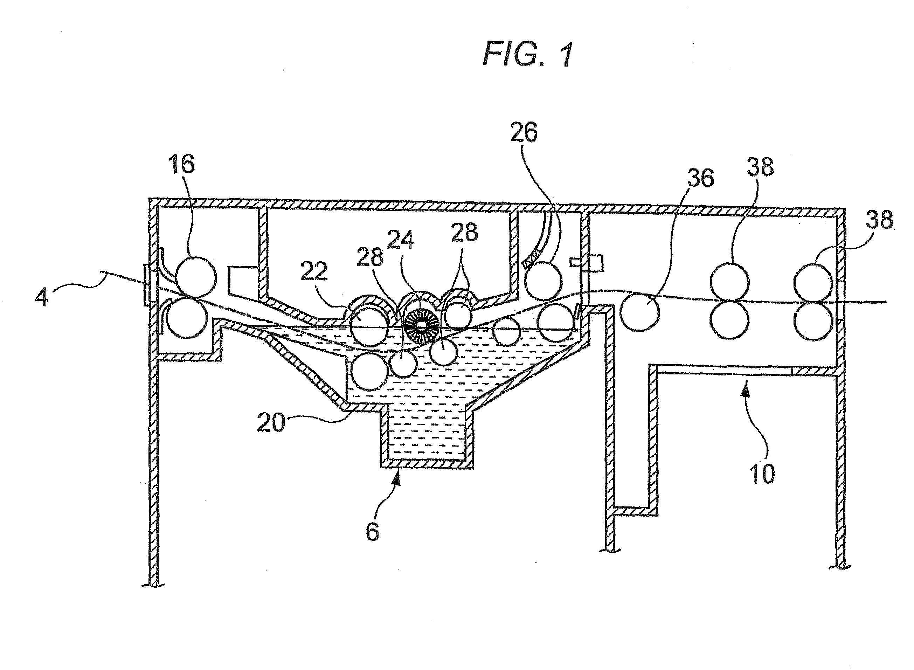

Fig. 1 is a view schematically showing a configuration of an automatic development processor.

### MODE FOR CARRYING OUT THE INVENTION

### [Negative lithographic printing plate precursor]

With the negative lithographic printing plate precursor for use in the invention, the constitution thereof will be described in turn below.

### [Support]

At the beginning, a support for the lithographic printing plate precursor used in the invention is described.
Although any support having a hydrophilic surface may be used, a dimensionally stable plate-like material is preferably used for the support. The support includes, for example, paper, paper laminated with plastic (for example, polyethylene, polypropylene or polystyrene), a plate of metal, for example, aluminum, zinc or copper or its alloy (for example, as aluminum alloy, alloy including silicon, copper, manganese, magnesium, chromium, zinc, lead, bismuth, nickel or the like), a plastic film, for example, cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate or polyvinyl acetal, and paper or a plastic film having laminated with or vapor-deposited thereon the metal or alloy as described above. Of the supports, an aluminum plate (including an aluminum alloy plate) is particularly preferred, because it has extremely dimensional stability and is inexpensive. Further, a composite sheet comprising a polyethylene terephthalate film having bonded thereon an aluminum sheet described in JP-B-48-18327 is also preferred. Ordinarily, the thickness of the support is approximately from 0.05 to 1 mm.

In case of using a support having a metal surface, particularly, an aluminum surface, the support is preferably subjected to a surface treatment, for example, a graining treatment, an immersion treatment in an aqueous solution of sodium silicate, potassium fluorozirconate, a phosphate or the like, or anodizing treatment described below.

### [Graining treatment]

As a method for the graining treatment, an electrochemical graining method wherein surface graining is electrochemically conducted in an electrolytic solution of hydrochloric acid or nitric acid or a mechanical graining method, for example, a wire brush graining method wherein a surface of aluminum plate is scratched with a metal wire, a ball graining method wherein a surface of aluminum plate is grained with abrasive balls and an abrasive or a brush graining method wherein a surface of aluminum plate is grained with a nylon brush and an abrasive can be employed. The graining methods may be used individually or in combination of two or more thereof. For instance, a method of conducting mechanical graining, chemical etching and electrolytic graining is described in JP-A-56-28893.
Specifically, a method of forming useful surface roughness is an electrochemical graining method wherein surface graining is electrochemically conducted in an electrolytic solution of hydrochloric acid or nitric acid and suitable current density is in a range from 100 to 400 C/dm². More specifically, it is preferred to perform electrolysis in an electrolytic solution containing from 0.1 to 50% of hydrochloric acid or nitric acid under the conditions of temperature from 20 to 100°C, time from one second to 30 minutes and current density from 100 to 400 C/dm².

The aluminum support subjected to the graining treatment is then chemically etched with an acid or an alkali. The method of using an acid as an etching agent takes time for destroying fine structures. Such a problem may be resolved by using an alkali as the etching agent.
Examples of the alkali agent preferably used include sodium hydroxide, sodium carbonate, sodium aluminate, sodium metasilicate, sodium phosphate, potassium hydroxide and lithium hydroxide. Preferable ranges of the concentration and temperature are form 1 to 50% and from 20 to 100°C, respectively. The conditions for providing a dissolution amount of aluminum in a range from 5 to 20 g/m³ are preferred.
After the etching procedure, the aluminum support is subj ected to washing with an acid for removing stain (smut) remaining on the surface thereof. Examples of the acid for use in the acid-washing step include nitric acid, sulfuric acid, phosphoric acid, chromic acid, hydrofluoric acid and hydrofluoroboric acid. As the method for removing smut after the electrochemical graining treatment, a method of bringing the aluminum support into contact with a 15 to 65% by weight aqueous sulfuric acid solution having a temperature from 50 to 90°C as described in JP-A-53-12739 and a method of performing alkali etching as described in JP-B-48-28123 are preferred.
Surface roughness (Ra) of the aluminum support is preferably from 0.3 to 0.7 µm.

### [Anodizing treatment]

The aluminum support subjected to the graining treatment described above may further be subjected to anodizing treatment. The anodizing treatment can be conducted in a manner conventionally used in the field of art.
Specifically, it is performed by applying direct current or alternating current to the aluminum support in an aqueous solution or non-aqueous solution containing sulfuric acid, phosphoric acid, chromic acid, oxalic acid, sulfamic acid, benzenesulfonic acid, or a combination of two or more thereof to form an anodic oxide film on the surface of aluminum support.
The conditions of anodizing treatment cannot be determined generally, since they vary widely depending on the electrolytic solution to be used. However, it is ordinarily suitable that a concentration of the electrolytic solution is in a range from 1 to 80%, a temperature of the electrolytic solution is in a range from 5 to 70°C, a current density is in a range from 0.5 to 60 Ampere/dm², a voltage is in a range from 1 to 100 V, and a period of electrolysis is in a range from 10 to 100 seconds.
Of the anodizing treatments, a method of anodizing in a sulfuric acid solution with a high current density described in British Patent 1,412,768 and a method of anodizing using phosphoric acid as an electrolytic bath described in U.S. Patent 3,511,661 are particularly preferred.
The amount of anodic oxide film is preferably from 1 to 10 g/m². When the amount is less than 1 g/m², the printing plate is apt to be scratched. When the amount exceeds 10 g/m², a large quantity of electric power is necessary and thus it is economically disadvantageous, The amount of anodic oxide film is more preferably from 1.5 to 7 g/m², and still more preferably from 2 to 5 g/m².

The aluminum support may further be subjected to a sealing treatment of the anodic oxide film after the graining treatment and anodizing treatment. The sealing treatment is performed by immersing the aluminum support in hot water or a hot aqueous solution containing an inorganic salt or an organic salt, or in a water vapor bath. Moreover, the aluminum support may be subjected to a surface treatment, for example, silicate treatment with an alkali metal silicate or immersion treatment in an aqueous solution of potassium fluorozirconate, a phosphate or the like.

On a support (in case of an aluminum support, the aluminum support appropriately subjected to the surface treatment as described above is preferred), for example, an image-recording layer comprising a photopolymerizable photosensitive composition is coated and, if desired, a protective layer is coated on the image-recording layer to prepare a lithographic printing plate precursor. In advance of the coating of image-recording layer, an organic or inorganic undercoat layer may be provided on the support, if desired. A sol-gel treatment where a functional group capable of initiating an addition reaction upon a radical is covalently bonded on the surface of support as described in JP-A-7-159983 may be performed.

As a substance for forming the organic undercoat layer, for instance, a water-soluble resin, for example, polyvinylphosphonic acid, a polymer or copolymer having a sulfonic acid group in its side chain or polyacrylic acid, a yellow dye or an amine salt is exemplified.
Specifically, the organic compound used in the organic undercoat layer is selected form, for example, carboxymethyl cellulose, dextrin, gum arabic, a phosphonic acid having an amino group, for example, 2-aminoethylphosphonic acid, an organic phosphonic acid, for example, phenylphosphonic acid, naphthylphosphonic acid, alkylphosphonic acid, glycerophosphonic acid, polyvinylphosphonic acid, methylenediphosphonic acid or ethylenediphosphonic acid, each of which may have a substituent, an organic phosphoric acid, for example, phenylphosphoric acid, naphthylphosphoric acid, alkylphosphoric acid or glycerophosphoric acid, each of which may have a substituent, an organic phosphinic acid, for example, phenylphosphinic acid, naphthylphosphinic acid, alkylphosphinic acid or glycerophosphinic acid, each of which may have a substituent, an amino acid, for example, glycine or β-alanine, and a hydrochloride of amine having a hydroxy group, for example, triethanolamine hydrochloride. The organic compounds may be used as a mixture of two or more thereof.

The organic undercoat layer can be provided by the following methods. Specifically, there are a method of dissolving the organic compound described above in water, an organic solvent, for example, methanol, ethanol or methyl ethyl ketone, or a mixed solvent thereof, coating the resulting solution on a support and drying it to provide the organic undercoat layer, and a method of dissolving the organic compound described above in water, an organic solvent, for example, methanol, ethanol or methyl ethyl ketone, or a mixed solvent thereof, immersing a support in the resulting solution to adsorb the organic compound, washing the support with water or the like, and drying it to provide the organic undercoat layer. In the former method, the solution containing the organic compound in a concentration from 0.005 to 10% by weight can be coated by various methods. Any method including, for example, bar coater coating, spin coating, spray coating or curtain coating may be used. In the latter method, the concentration of the organic compound in the solution is from 0.01 to 20% by weight, preferably from 0.05 to 5% by weight, the immersion temperature is from 20 to 90°C, preferably from 25 to 50°C, and the immersion time is from 0.1 second to 20 minutes, preferably from 2 seconds to 1 minute.
The solution used may also be used by adjusting its pH to a range from 1 to 12 with a basic substance, for example, ammonia, triethylamine or potassium hydroxide or an acidic substance, for example, hydrochloric acid or phosphoric acid. Moreover, a yellow dye may also be added to the solution in order to improve the tone reproducibility of the lithographic printing plate precursor.
The coverage of the organic undercoat layer after drying is suitably from 2 to 200 mg/m², and preferably from 5 to 100 mg/m². When the coverage of the organic undercoat layer is less than 2 mg/m², sufficient printing durability may not be obtained in some cases. When the coverage thereof is more than 200 mg/m², the same problem may also arise.

Examples of the substance used in the inorganic undercoat layer include an inorganic salt, for example, cobalt acetate, nickel acetate or potassium fluorotitanate. The method of providing the inorganic undercoat layer is similar to that of the organic undercoat layer described above.

From the standpoint of increase in printing durability, the undercoat layer preferably contains a polymer or copolymer having any one of a phosphonic acid group, a phosphoric acid group and a sulfonic acid group in its side chain. In case of the copolymer, it contains a polymerization component having such a group preferably from 10 to 90% by mole, and more preferably from 20 to 50% by mole. Further, the copolymer preferably contains an ethylenically unsaturated bond in its side chain. The copolymer contains a polymerization component having the ethylenically unsaturated bond preferably from 10 to 90% by mole, and more preferably from 15 to 40% by mole.

### [Image-recording layer]

The image-recording layer (hereinafter, also referred to as a photosensitive layer) of the lithographic printing plate precursor for use in the invention contains as the essential components, (i) a sensitizing dye, (ii) a photopolymerization initiator, (iii) an addition polymerizable compound having an ethylenically unsaturated double bond and (iv) a binder polymer.

### [Sensitizing dye]

The sensitizing dye for use in the invention is a dye capable of transmitting the energy of laser beam absorbed at the image exposure to a photopolymerization initiator with energy transfer or electron transfer.
An absorption wavelength of the sensitizing dye is not particularly restricted as long as the sensitizing dye has the above-described function. The sensitizing dye is appropriately selected depending on a wavelength of laser used for the exposure. In the invention, particularly, a sensitizing dye having an absorption maximum in a wavelength range from 350 to 450 nm is preferably used. Such sensitizing dyes include, for example, merocyanine dyes represented by formula (2) shown below, benzopyrans or coumarins represented by formula (3) shown below, aromatic ketones represented by formula (4) shown below and anthracenes represented by formula (5) shown below.

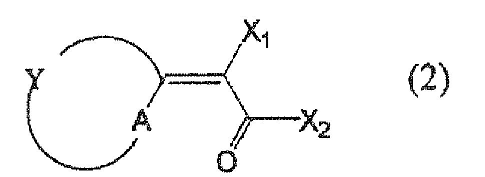

(in formula (2), A represents a sulfur atom or NR₆, R₆ represents a monovalent non-metallic atomic group, Y represents a non-metallic atomic group necessary for forming a basic nucleus of the dye together with adjacent A and the adjacent carbon atom, and X₁ and X₂ each independently represents a monovalent non-metallic atomic group or X₁ and X₂ may be combined with each other to form an acidic nucleus of the dye.)

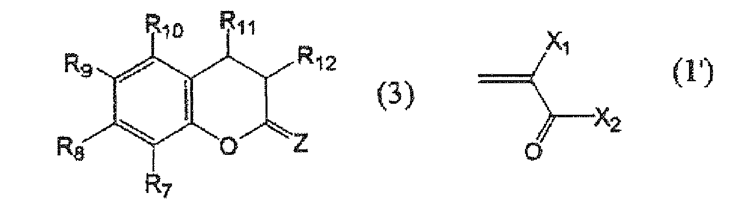

(in formula (3), =Z represents an oxo group, a thioxo group, an imino group or an alkylydene group represented by the partial structural formula (1') described above, X₁ and X₂ have the same meanings as defined in formula (2) respectively, and R₇ to R₁₂ each independently represents a monovalent non-metallic atomic group.)

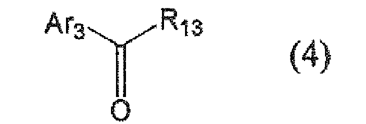

(in formula (4), Ar₃ represents an aromatic group which may have a substituent or a heteroaromatic group which may have a substituent, and R₁₃ represents a monovalent non-metallic atomic group. R₁₃ preferably represents an aromatic group or a heteroaromatic group. Ar₃ and R₁₃ may be combined with each other to form a ring.)

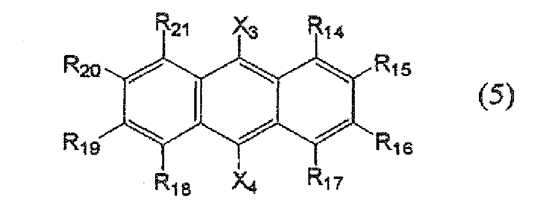

(in formula (5), X₃, X₄ and R₁₄ to R₂₁ each independently represents a monovalent non-metallic atomic group. Preferably, X₃ and X₄ each independently represents an electron-donating group having a negative Hammett substituent constant.)

In formulae (2) to (5), preferable examples of the monovalent non-metallic atomic group represented by any one of X₁ to X₄ and R₆ to R₂₁ include a hydrogen atom, an alkyl group (for example, a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eucosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group, a 2-norbornyl group, a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an α-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group or a 3-butynyl group), an aryl group (for example, a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxycarbonylphenyl group, a phenoxycarbonylphenyl group, an N-phenylcarbamoylphenyl group, a nitrophenyl group, a cyanophenyl group, a sulfophenyl group, a sulfonatophenyl group, a phosphonophenyl group or a phosphonatophenyl group), a heteroaryl group (for example, a group derived from a heteroaryl ring, for example, thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indole, indazole, purine, quinolizine, isoquinoline, phthalazine, naphthylidine, quinazoline, cinnoline, pteridine, carbazole, carboline, phenanthrine, acridine, perimidine, phenanthroline, phthalazine, phenarsazine, phenoxazine, furazane or phenoxazine), an alkenyl group (for example, a vinyl group, a 1-propenyl group, a 1-butenyl group, a cinnamyl group or a 2-chloro-1-ethenyl group), an alkynyl group (for example, an ethynyl group, a 1-propynyl group, a 1-butynyl group or a trimethylsilylethynyl group), a halogen atom (for example, -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamino group, an N,N-didkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diaryl-carbamoyloxy group, an N-alkyl-N-arylcarbamoyloxy group, an akylsulfoxy group, an arylsulfoxy group, an arylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureidogroup, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and its conjugated base group (hereinafter referred to as a "sulfonato group"), an alkoxysulfonyl group, an aryloxysulfonyl group, a sulfinamoyl groups, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group (-PO₃H₂) and its conjugated base group (hereinafter referred to as a "phosphonato group"), a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and its conjugated base group (hereinafter referred to as an "alkylphosphonato group"), a monoarylphosphono group (-PO₃H(aryl)) and its conjugated base group (hereinafter referred to as an "arylphosphonato group"), a phosphonooxy group (-OPO₃H₂) and its conjugated base group (hereinafter referred to as a "phosphonatooxy group"), a dialkylphosphonooxy group (-OPO₃(alkyl)₂), a diarylphosphonooxy group (-OFO₃(aryl)₂), an alkylarylphosphonooxy group (-OPO₃(alkyl)(aryl)), a monoalkylphosphonooxy group (-OPO₃H(alkyl)) and its conjugated base group (hereinafter referred to as an "alkylphosphonatooxy group"), a monoarylphosphonooxy group (-OPO₃H(aryl)) and its conjugated base group (hereinafter referred to as an "arylphosphonatooxy group"), a cyano group, a nitro group and the like. Among the above-described monovalent non-metallic atomic groups, a hydrogen atom, an alkyl group, an aryl group, a halogen atom, an alkoxy group and an acyl group are particularly preferred.

The basic nucleus of the dye formed by Y together with the adjacent A and the adjacent carbon atom in formula (2) includes, for example, a 5-membered, 6-membered or 7-membered, nitrogen-containing or sulfur-containing heterocyclic ring, and is preferably a 5-membered or 6-membered heterocyclic ring.

As the nitrogen-containing heterocyclic ring, for example, those which are know to constitute basic nuclei in merocyanine dyes described in L.G. Brooker et al, J. Am. Chem. Soc., Vol. 73, pp. 5326 to 5358 (1951) and references cited therein can be preferably used. Specific examples thereof include thiazoles (for example, thiazole, 4-methylthiazole, 4-phenylthiazole, 5-methylthiazole, 5-phenylthiazole, 4,5-dimethylthiazole, 4,5-diphenylthiazole, 4,5-di(p-methoxyphenyl)thiazole or 4-(2-thienyl)thiazole), benzothiazoles (for example, benzothiazole, 4-chlorobenzothiazole, 5-chlorobenzothiazole, 6-chlorobenzothiazole, 7-chlorobenzothiazole, 4-methylbenzothiazole, 5-methylbenzothiazole, 6-methylbenzothiazole, 5-bromobenzothiazole, 4-phenylbenzothiazole, 5-phenylbenzathiazole, 4-methoxybenzothiazole, 5-methoxybenzothiazole, 6-methoxybenzothiazole, 5-iodobenzothiazole, 6-iodobenzothiazole, 4-ethoxybenzothiazole, 5-ethoxybenzothiazole, tetrahydrobenzothiazole, 5,6-dimethoxybenzothiazole, 5,6-dioxymethylenebenzothiazole, 5-hydroxybenzothiazole, 6-hydroxybenzothiazole, 6-dimethylaminobenzothiazole or 5-ethoxycarbonybenzothiazole), naphthothiazoles (for example, naphtho[1,2]thiazole, naphtho[2,1]thiazole, 5-methoxynaphtho[2,1]thiazole, 5-ethoxynaphtho[2,1]thiazole, 8-methoxynaphtho[1,2]thiazole or 7-methoxynaphtho[1,2]thiazole), thianapththeno-7',6',4,5-thiazoles (for example, 4'-methoxythianaphtheno-7',6',4,5-thiazole), oxazoles (for example, 4-methyloxazole, 5-methyloxazole, 4-phenyloxazole, 4,5-diphenyloxazole, 4-ethyloxazole, 4,5-dimethyloxazole or 5-phenyloxazole), benzoxazoles (for example, benzoxazole, 5-chlorobenzoxazole, 5-methylbenzoxazole, 5-phenylbenzoxazole, 6-methylbenzoxazole, 5,6-dimethylbenzoxazole, 4,6-dimethylbenzoxazole, 6-methoxybenzoxazole, 5-methoxybenzoxazole, 4-ethoxybenzoxazole, 5-chlarobenzoxazole, 6-methoxybenzoxazole, 5-hydroxybenzoxazole or 6-hydroxybenzoxazole), naphthoxazoles (for example, naphth[1,2]oxazole or naphth[2,1]oxazole), selenazoles (for example, 4-methylselenazole or 4-phenylselenazole), benzoselenazoles (for example, benzoselenazole, 5-chlorobenzoselenazole, 5-methoxybenzoselenazole, 5-hydroxybenzoselenazole or tetrahydrobenzoselenazole), naphthoselenazoles (for examples, naphtho[1,2]selenazole or naphtho[2,1]selenazole), thiazolines (for example, thiazoline or 4-methylthiazoline), quinolines (for example, quinoline, 3-methylquinoline, 5-methylquinoline, 7-methylquinoline, 8-methylquinoline, 6-chloroquinoline, 8-chloroquinoline, 6-methoxyquinoline, 6-ethoxyquinoline, 6-hydroxyquinoline or 8-hydroxyquinoline), isoquinolines (for example, isoquinoline or 3,4-dihydroisoquinoline), benzimidazoles (for example, 1,3-diethylbenzimidazole or 1-ethyl-3-phenylbenzimidazole), 3,3-dialkylindolenines (for example, 3,3-dimethylindolenine, 3,3,5-trimethylindolenine or 3,3,7-trimethylindolenine), pyridines (for example, pyridine or 5-methylpyridine) and the like.

Also, examples of the sulfur-containing heterocyclic ring include dithiol partial structures in dyes described in JP-A-3-296759.
Specific examples thereof include benzodithiols (for example, benzodithiol, 5-tert-butylbenzodithiol or 5-methylbenzodithiol), naphthodithiols (for example, naphtho[1,2]dithiol or naphtho[2,1]dithiol), dithiols (for example, 4.5-dimethyldithiol, 4-phenyldithiol, 4-methoxycarbonyldithiol, 4,5-dimethoxycarbonyldithiol, 4,5-ditrifluoromethyldithiol, 4,5-dicyanodithiol, 4-methoxycarbonylmethyldithiol or 4-carboxymethyldithiol) and the like.

In the description with respect to the heterocyclic ring above, for convenience and by convention, the names of heterocyclic mother skeletons are used. In the case of constituting the basic nucleus partial structure in the sensitizer, the heterocyclic ring is introduced in the form of a substituent of alkylydene type where a degree of unsaturation is decreased one step. For example, a benzothiazole skeleton is introduced as a 3-substituted-2(3H)-benzothiazolilydene group.

Of the sensitizing dyes having an absorption maximum in a wavelength range from 350 to 450 nm, more preferable dyes in view of high sensitivity are dyes represented by formula (1) shown below.

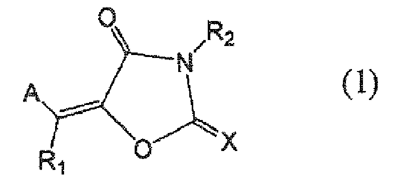

(in formula (1), A represents an aromatic cyclic group which may have a substituent or a heterocyclic group which may have a substituent, X represents an oxygen atom, a sulfur atom or N-(R₃), and R₁, R₂ and R₃ each independently represents a monovalent non-metallic atomic group, or A and R₁ or R₂ and R₃ may be combined with each other to form an aliphatic or aromatic ring.)

The formula (1) will be described in more detail below. R₁, R₂ and R₃ each independently represents a monovalent non-metallic atomic group, preferably a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or unsubstituted alkylthio group, a hydroxy group or a halogen atom.

Preferable examples of R₁, R₂ and R₃ will be specifically described below. Preferable examples of the alkyl group include a straight chain, branched or cyclic alkyl group having from 1 to 20 carbon atoms. Specific examples thereof include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eucosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group and a 2-norbomyl group. Among them, a straight chain alkyl group having from 1 to 12 carbon atoms, a branched alkyl group having from 3 to 12 carbon atoms and a cyclic alkyl group having from 5 to 10 carbon atoms are more preferred.

As the substituent for the substituted alkyl group, a monovalent non-metallic atomic group exclusive of a hydrogen atom is used. Preferable examples thereof include a halogen atom (for example, -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, an acyl group, a carboxyl group, an alkoxycarbonyl group, an aryloxycarbonyl group, a carbamoyl group, an N-alkylcarbarmoylgroup, an N,N-dialkylcarbamoyl group, an N-arylcarbamoyl group, an NN-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and its conjugated base group (hereinafter referred to as a "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group (-PO₃H₂) and its conjugated base group (hereinafter referred to as a "phosphonato group"), a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl))and its conjugated base group (hereinafter referred to as an "alkylphosphonato group"), a monoarylphosphono group (-PO₃H(aryl)) and its conjugated base group (hereinafter referred to as an "arylphosphonato group"), a phosphonooxy group (-OPO₃H₂) and its conjugated base group (hereinafter referred to as a "phosphonatooxy group"), a dialkylphosphonooxy group (-OPO₃(alkyl)₂), a diarylphosphonooxy group (-OPO₃(aryl)₂), an alkylarylphosphonooxy group (-OPO₃(alkyl)(aryl)), a monoalkylphosphonooxy group (-OPO₃H(akyl)) and its conjugated base group (hereinafter referred to as an "alkylphosphonatooxy group,"), a monoarylphosphonooxy group (-OPO₃H(aryl)) and its conjugated base group (hereinafter referred to as an "arylphosphonatooxy group"), a cyano group, a nitro group, an aryl group, a heteroaryl group, an alkenyl group and an alkynyl group.

In the substituents, specific examples of the alkyl group include those described for the alkyl group above. Specific examples of the aryl group include a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxycarbonylphenyl group, a phenoxycarbonylphenyl group, an N-phenylcarbamoylphenyl group, a nitrophenyl group, a cyanophenyl group, a sulfophenyl group, a sulfonatophenyl group, a phosphonophenyl group and a phosphonatophenyl group.

Examples of the heteroaryl group include a monocyclic or polycyclic aromatic cyclic group containing at least one of a nitrogen atom, an oxygen atom and a sulfur atom. Examples of especially preferable heteroaryl group include a group derived from a heteroaryl ring, for example, thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indole, indazole, purine, quinolizine, isoquinoline, phthalazine, naphthylidine, quinazoline, cinnoline, pteridine, carbazole, carboline, phenanthrene, acridine, perimidine, phenanthroline, phthalazine, phenarsazine, phenoxazine, furazane or phenoxazine. These groups may be benzo-fused or may have a substituent.

Examples of the alkenyl group include a vinyl group, a 1-propenyl group, a 1-butenyl group, a cinnamyl group and a 2-chloro-1-ethenyl group. Examples of the alkynyl group include an ethynyl group, a 1-propynyl group, a 1-butynyl group and a trimethylsilylethynyl group. Examples of G₁ in the acyl group (G₁CO-) include a hydrogen atom and the above-described alkyl group and aryl group. Of the substituents, a halogen atom (for example, -F, -Br, -Cl or -I), an alkoxy group, an aryloxy group, an alkylthio group, an arylthio group, an N-alkylamino group, an N,N-dialkylamino group, an acyloxy group, an N-alkylcarbamoyloxy group, an N-arylcarbamoyloxy group, an acylamino group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N-alkyl-N-arylcarbamoyl group, a sulfo group, a sulfonato group, a sulfamoyl group, an N-alkylsulfamoyl group, an N,N-dialkylsulfamoyl group, an N-arylsulfamoyl group, an N-alk-yl-N-arylsulfamoyl group, a phosphono group, a phosphonato group, a dialkylphosphono group, a diarylphosphono group, a monoalkylphosphono group, an alkylphosphonoto group, a monoarylphosphono group, an arylphosphonato group, a phosphonooxy group, a phosphonatooxy group, an aryl group and an alkenyl group are more preferred.

On the other hand, as an alkylene group in the substituted alkyl group, a divalent organic residue resulting from elimination of any one of hydrogen atoms on the above-described alkyl group having from 1 to 20 carbon atoms can be enumerated. Examples of preferable alkylene group include a straight chain alkylene group having from 1 to 12 carbon atoms, a branched alkylene group having from 3 to 12 carbon atoms and a cyclic alkylene group having from 5 to 10 carbon atoms.

Specific examples of the preferable substituted alkyl group represented by any one of R₁, R₂ and R₃, which is obtained by combining the above-described substituent with the arylene group, include a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylalminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonoxypropyl group, a phosphonatooxybutyl group, a benzyl group, a phenethyl group, an α-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group and a 3-butynyl group.

Preferable examples of the aryl group represented by any one of R₁, R₂ and R₃ include a fused ring formed from one to three benzene rings and a fused ring formed from a benzene ring and a 5-membered unsaturated ring. Specific examples thereof include a phenyl group, a naphthyl group, an anthryl group, a phenanthryl group, an indenyl group, an acenaphthenyl group and a fluorenyl group. Among them, a phenyl group and a naphthyl group are more preferred.

Specific examples of the preferable substituted aryl group represented by any one of R₁, R₂ and R₃ include aryl groups having a monovalent non-metallic atomic group exclusive of a hydrogen atom as a substituent on the ring-forming carbon atom of the above-described aryl group. Preferable examples of the substituent include the above-described alkyl groups and substituted alkyl groups, and the substituents described for the above-described substituted alkyl group. Specific examples of the preferable substituted aryl group include a biphenyl group, a tolyl group, a xylyl group, a mesityl group, a cumenyl group, a chlorophenyl group, a bromophenyl group, a fluorophenyl group, a chloromethylphenyl group, a trifluoromethylphenyl group, a hydroxyphenyl group, a methoxyphenyl group, a methoxyethoxyphenyl group, an allyloxyphenyl group, a phenoxyphenyl group,a methylthiophenyl group, a tolylthiophenyl group, an ethylaminophenyl group, a diethylaminophenyl group, a morpholinophenyl group, an acetyloxyphenyl group, a benzoyloxyphenyl group, an N-cyclohexylcarbamoyloxyphenyl group, an N-phenylcarbamoyl-oxyphenyl group, an acetylaminophenyl group, an N-methylbenzoylaminophenyl group, a carboxyphenyl group, a methoxycarbonylphenyl group, an allyloxycarbonylphenyl group, a chlorophenoxycarbonylphenyl group, a carbamoylphenyl group, an N-methylcarbamoylphenyl group, an N,N-dipropylcarbamoylphenyl group, an N-(methoxyphenyl)carbamoylphenyl group, an N-methyl-N-(sulfophenyl)carbamoylphenyl group, a sulfophenyl group, a sulfonatophenyl group, a sulfamoylphenyl group, an N-ethylsulfamoylphenyl group, an N,N-dipropylsulfamoylphenyl group, an N-tolylsulfamoylphenyl group, an N-methyl-N-(phosphonophenyl)sulfamoylphenyl group, a phosphonophenyl group, a phosphonatophenyl group, a diethylphosphonophenyl group, a diphenylphosphonophenyl group, a methylphosphonophenyl group, a methylphosphonatophenyl group, a tolylphosphonophenyl group, a tolylphosphonatophenyl group, an allylphenyl group, a 1-propenylmethylphenyl group, a 2-butenylphenyl group, a 2-methylallylphenyl group, a 2-methylpropenylphenyl group, a 2-propynylphenyl group, a 2-butynylphenyl group, a 3-butynylphenyl group and the like.

Examples of the preferable substituted or unsubstituted alkenyl group and the preferable substituted or unsubstituted aromatic heterocyclic residue represented by any one of R₁, R₂ and R₃ include those described with respect to the alkenyl group and heteroaryl group above, respectively.

Next, A in formula (1) will be described below. A represents an aromatic cyclic group which may have a substituent or heterocyclic group which may have a substituent. Specific examples of the aromatic cyclic group which may have a substituent and heterocyclic group which may have a substituent include those described with respect to the aryl group and heteroaryl group for any one of R₁, R₂ and R₃ in formula (1).

The sensitizing dye represented by formula (1) according to the invention is obtained by a condensation reaction of the above-described acidic nucleus or an active methylene group-containing acidic nucleus with a substituted or unsubstituted, aromatic ring or hetero ring. Specifically, it can be synthesized with reference to the description of JP-B-59-28329.

Preferable specific examples (D1) to (D42) of the compound represented by formula (1) are set forth below. Further, when isomers with respect to a double bond connecting an acidic nucleus and a basic nucleus are present in each of the compounds, the invention should not be construed as being limited to any one of the isomers.

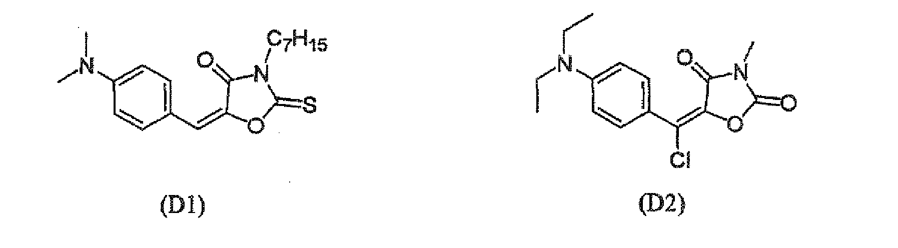

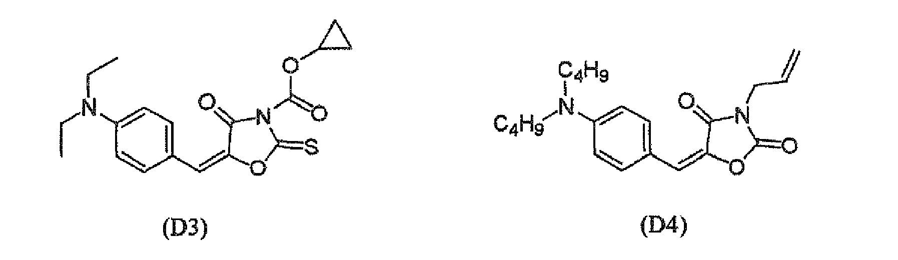

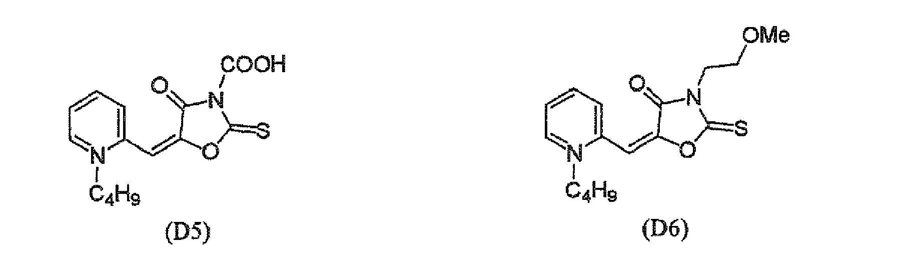

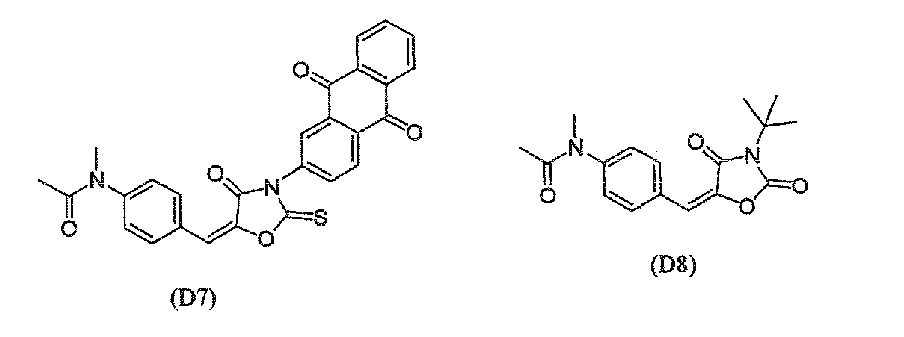

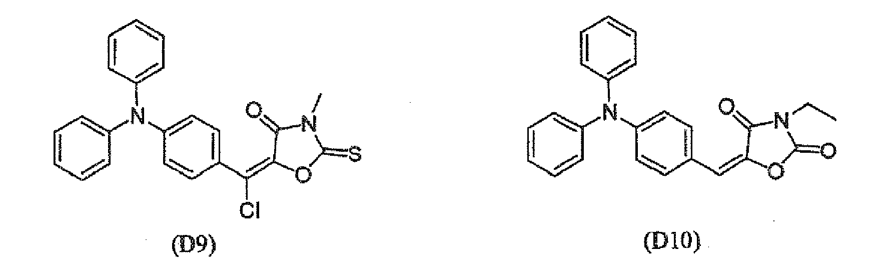

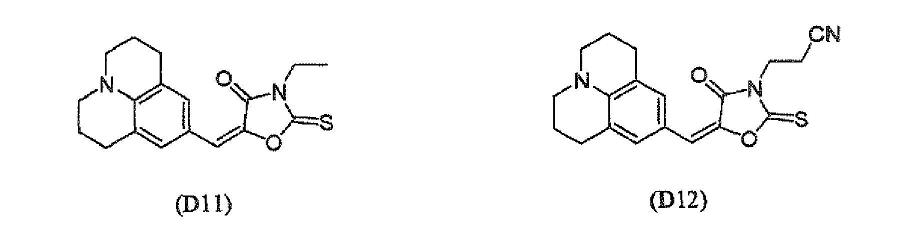

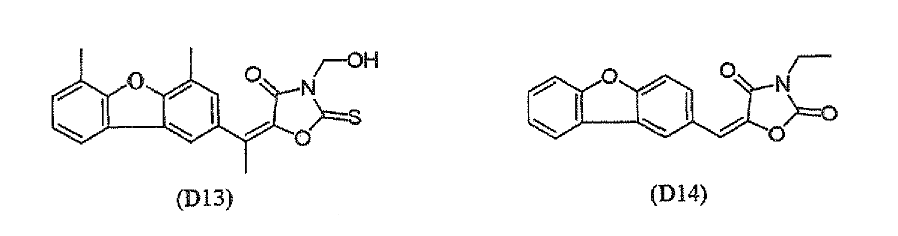

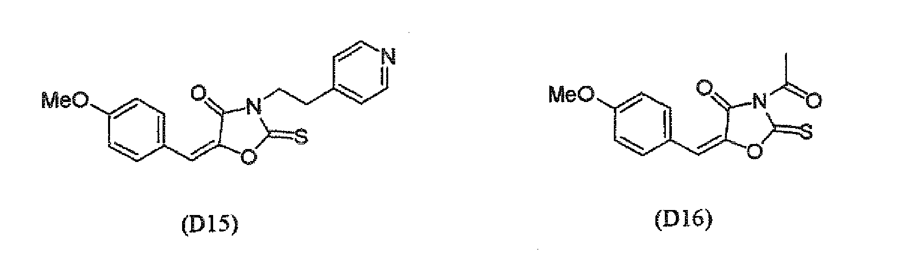

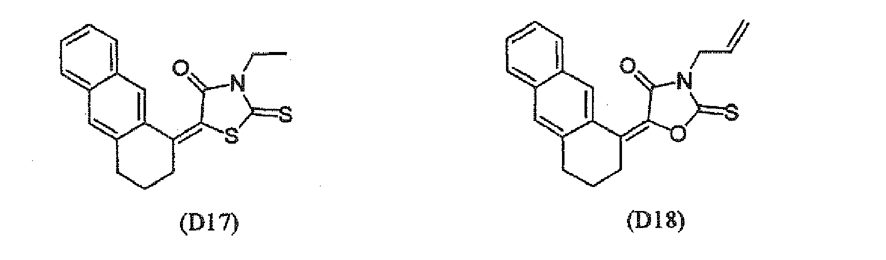

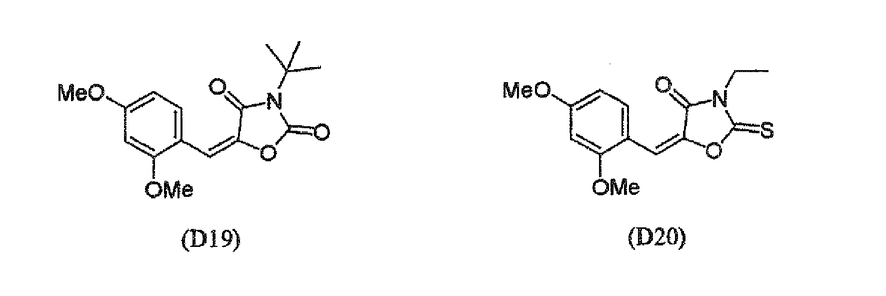

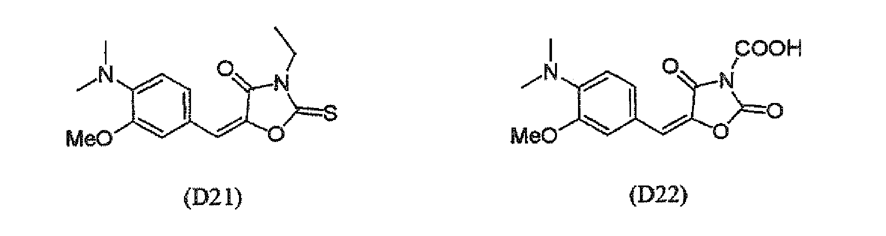

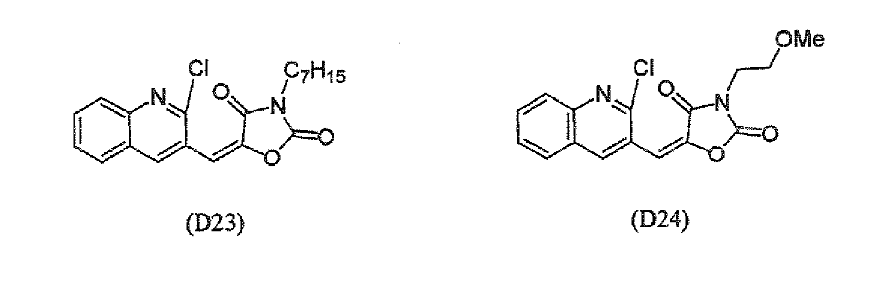

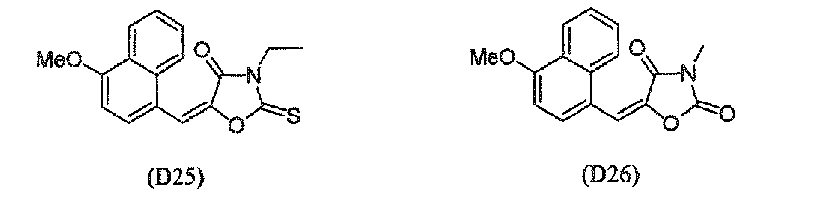

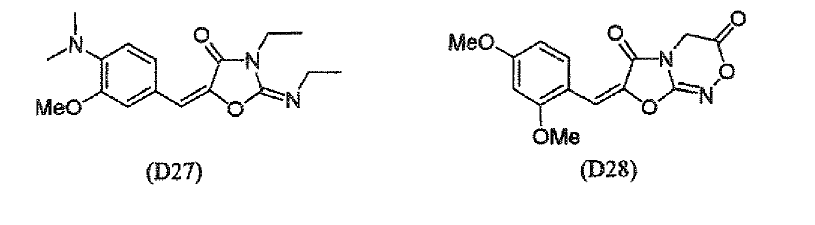

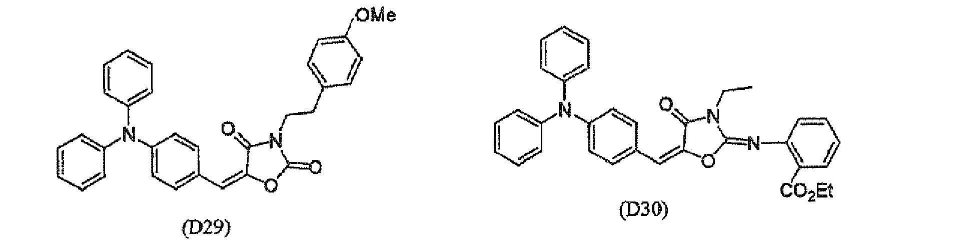

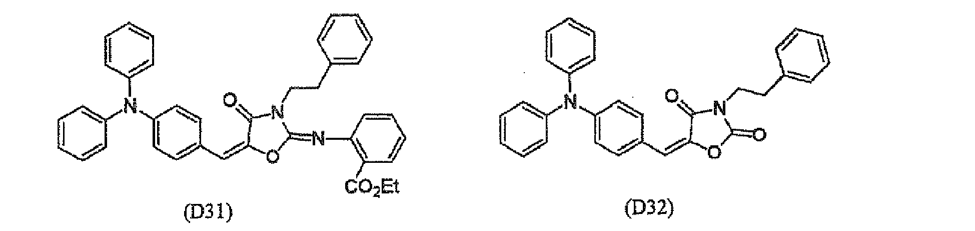

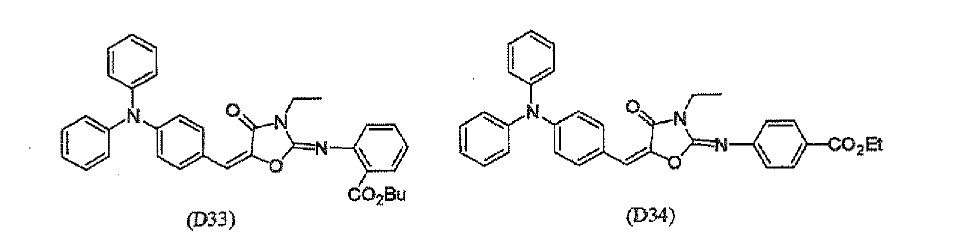

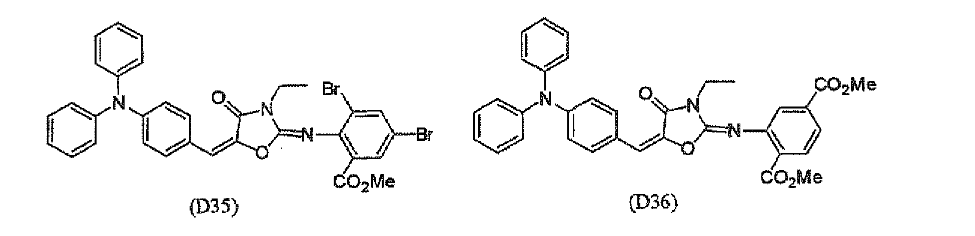

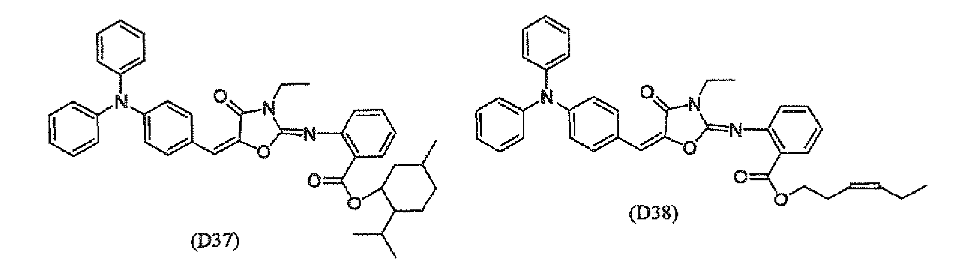

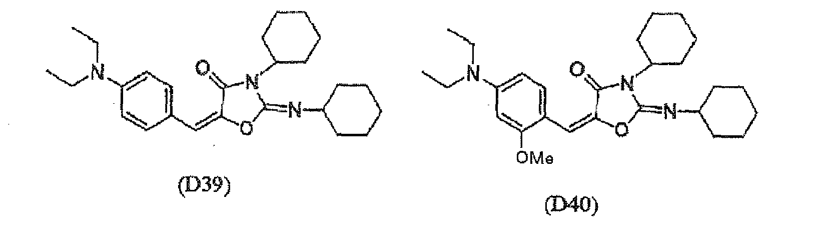

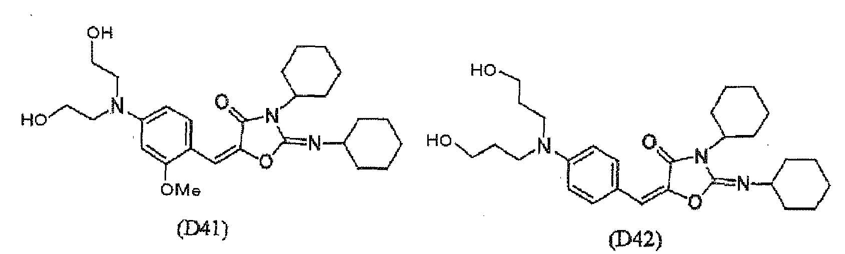

Further, sensitizing dyes represented by formula (I), (II) or (III) shown below are also preferably used.

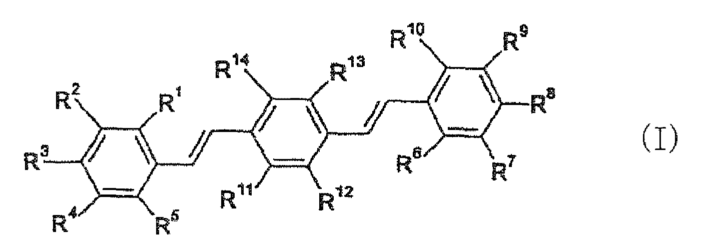

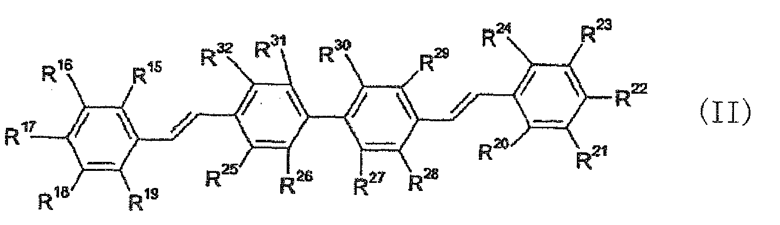

In formula (I), R¹ to R¹⁴ each independently represents a hydrogen atom, an alkyl group, an alkoxy group, a cyano group or a halogen atom, provided that at least one of R¹ to R¹⁰ represents an alkoxy group having 2 or more carbon atoms.
In formula (II), R¹⁵ to R³² each independently represents a hydrogen atom, an alkyl group, an alkoxy group, a cyano group or a halogen atom, provided that at least one of R¹⁵ to R²⁴ represents an alkoxy group having 2 or more carbon atoms.
With respect to the sensitizing dyes represented by formula (I) or (II), the detail descriptions including the specific examples thereof are made in WO 2005/029187 and the descriptions can be referred to.

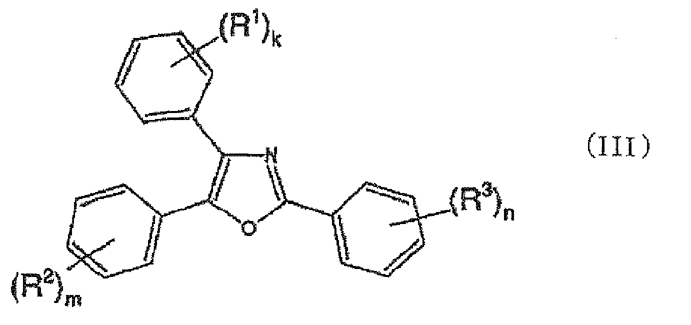

In formula (III), R¹, R² and R³ each independently represents a halogen atom, an alkyl group which may have a substituent, an aryl group which may have a substituent, an aralkyl group which may have a substituent, an -NR⁴R⁵ group or an -OR⁶ group, R⁴, R⁵ and R⁶ each independently represents a hydrogen atom, an alkyl group which may have a substituent, an aryl group which may have a substituent or an aralkyl group which may have a substituent, and k, m and n each represents an integer from 0 to 5.
With respect to the sensitizing dyes represented by formula (III), the detail descriptions including the specific examples thereof are made in WO 2004/074930 and the descriptions can be referred to.

Since the sensitizing dye has a different extinction coefficient depending on the structure thereof, the amount of the sensitizing dye added is varied according to the structure of the sensitizing dye used. The amount thereof is suitably an amount in that absorbance of the photosensitive layer at a laser emitting wavelength is 0.6 or less, preferably in a range from 0.05 to (0.55, more preferably in a range from 0.1 to 0.45, and still more preferably in a range form 0.1 to 0.3.

### [Photopolymerization initiator]

The photopolymerization initiator for use in the invention can be appropriately selected from various photopolymerization initiators or combination systems of two or more photopolymerization initiators (photopolymerization initiation system) know in patents, literatures and the like. In the invention, the photopolymerization initiator individually used and the combination system of two or more photopolymerization initiators are collectively referred to simply as a photopolymerization initiator.
For instance, in case of using light having a wavelength of around 400 nm as the light source, benzyl, benzoyl ether, Michler's ketone, anthraquinone, thioxantone, acridine, phenazine, benzophenone, a hexaarylbisimidazole compound and the like are broadly used.

Also, in case of using visible light having a wavelength of 400 nm or more as the light source, various photopolymerization initiators have also been proposed. For instance, a certain kind of photo-reducing dyes, for example, Rose Bengal, Eosin or erythrosine, described in U.S. Patent 2,850,445, and a combination system comprising a dye and a photopolymerization initiator, for example, a composite initiator system comprising a dye and an amine (described in JP-B-44-20189), a combination system of a hexaarylbiimidazole, a radical generator and a dye (described in JP-B-45-37377), a combination system of a hexaarylbiimidazole and a p-dialkylaminobenzylidene ketone (described in JP-B-47-2528 and JP-A-54-155292), a combination system of a cyclic cis-α-dicarbonyl compound and a dye (described in JP-A-48-84183), a combination system of a cyclic triazine and a merocyanine dye (described in JP-A-54-151024), a combination system of a 3-ketocoumarin and an activator (described in JP-A-52-112581 and JP-A-58-15503), a combination system of a biimidazole, a styrene derivative and a thiol (described in JP-A-59-140203), a combination system of an organic peroxide and a dye (described in JP-A-59-1504, JP-A-59-140203, JP-A-59-189340, JF-A-62-174203, JP-B-62-1641 and U.S. Patent 4,766,055), a combination system of a dye and an active halogen compound (described in JP-A-63-178105, JP-A-63-258903 and JP-A-2-63054), a combination system of a dye and a borate compound (described in JP-A-62-143044, JP-A-62-150242, JP-A-64-13140, JP-A-64-13141, JP-A-64-13142, JP-A-64-13143, JP-A-64-13144, JP-A-64-17048, JP-A-1-229003, JP-A-1-298348 and JP-A-1-138204), and a combination system of a dye having a rhodanine ring and a radical generator (described in JP-A-2-179643 and JP-A-2-244050) are exemplified. As a preferable photopolymerization initiator, an hexaarylbisimidazole compound is exemplified.

As the hexaarylbisimidazole compound, various compounds described in European Patents 24,629 and 107,792, U.S. Patent 4,410,621, European Patent 215,453, German Patent 3,211,312 and the like can be used. Preferable compounds include, for example, 2,4,5,2',4',5'-hexaphenylbisimidazole, 2,2'-bis(2-chlorophenyl)-4,5,4',5'-tetraphenylbisimidazole, 2,2'-bis(2-bromophenyl)-4,5,4',5'-tetraphenylbismidazole, 2,2'-bis(2,4-dichlorophenyl)-4,5,4',5'-tetraphenylbisimidazole, 2,2'-bis(2-chorophenyl)-4,5,4',5'-tetrakis(3-methoxyphenyl)bisimidazole, 2,5,2',5'-tetrakis(2-chlorophenyl)-4,4'-bis(3,4-dimethoxyphenyl)bisimidazole, 2,2'-bis(2,6-dichlorophenyl)-4,5,4',5'-tetraphenylbisimidazole, 2,2'-bis(2-nitrophenyl)-4,5,4',5'-tetraphenylbismidazole, 2,2'-di-o-tolyl-4,5,4',5'-tetraphenylbisimidazole, 2,2'-bis(2-ethoxyphenyl)-4,5,4',5'-tetraphenylbisimidazole and 2,2'-bis(2,6-difluorophenyl)-4,5,4',5'-tetraphenylbisimidazole.
The hexaarylbisimidazole compounds may be used as a mixture of two or more thereof.

The amount of the hexaarylbisimidazole compound used is from 0.05 to 50 parts by weight, preferably from 0.2 to 30 parts by weight, based on 100 parts by weight of the total amount of the addition polymerizable compound described hereinafter. Other photopolymerization initiator may be used together with the hexaarylbisimidazole compound.

It is known that a photo-initiation ability is further enhanced by using the photopolymerization initiator together with a hydrogen donating compound, for example, a thiol compound, e.g., 2-mercaptobenzothiazole, 2-mercaptobenzimidazole or 2-mercaptobenzoxazole, or an amine compound, e.g., N-phenylglycine or N,N-dialkylamino aromatic alkyl ester, if desired. As the hydrogen donating compound having a particularly high photo-initiation ability suitable for the invention, a mercapto group-containing compound is exemplified.

More preferable examples of the hydrogen donating compound include sulfur-containing compounds (mercapto group-containing heterocyclic compounds) represented by formula (2) or (3) shown below. In formulate (2) and (3), the structures of tautomers are indicated respectively.

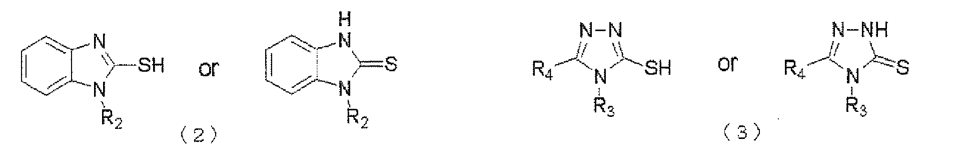

(in formulae (2) and (3), R₂, R₃ and R₄, each independently represents a hydrogen atom, a substituted or unsubstituted, straight-chain or branched alkyl group having from I to 18 carbon atoms, a substituted or unsubstituted alicyclic alkyl group having from 5 to 20 carbon atoms or an aromatic group. The substituent includes a halogen atom, a hydroxy group, an amino group, a thiol group, an acetyl group, a carboxyl group or the like.)

Preferable specific examples (SH1) to (SH20) of the compound represented by formula (2) or (3) are set forth below, but the invention should not be construed as being limited thereto. The structures shown below are indicated by the -SH group-containing structure of the tautomers.

Specific examples of the compound represented by formula (2):

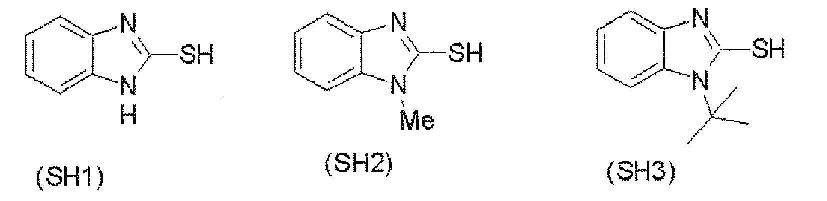

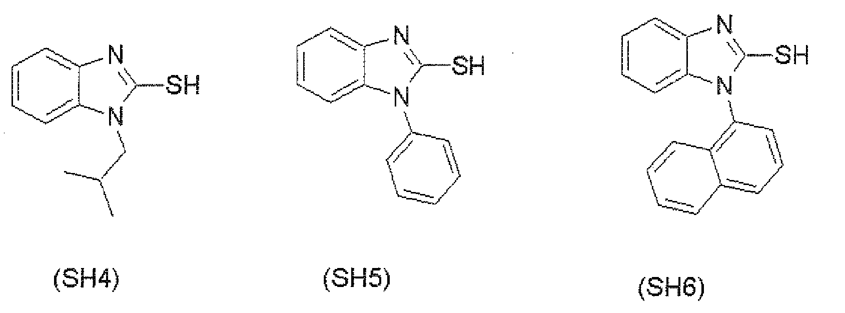

Specific examples of the compound represented by formula (3):

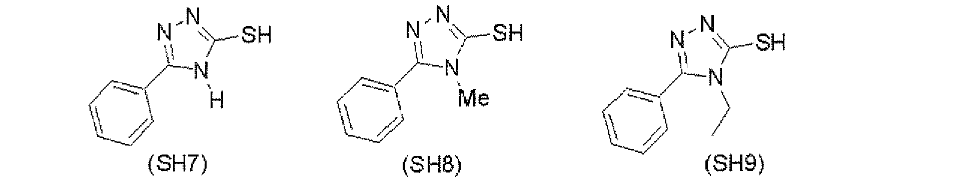

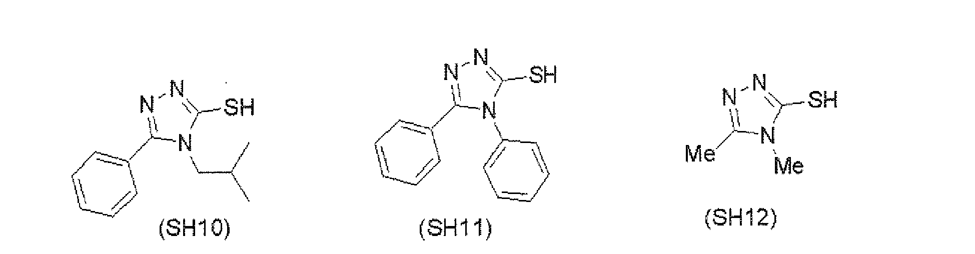

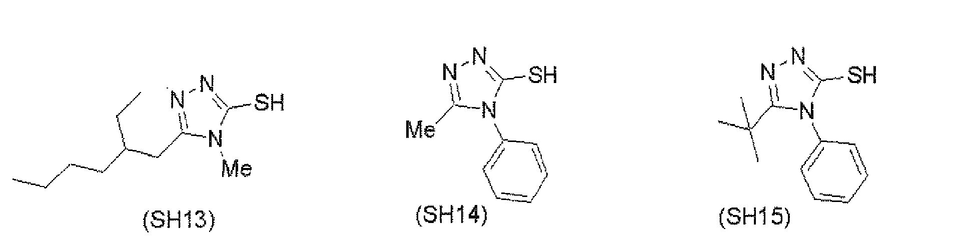

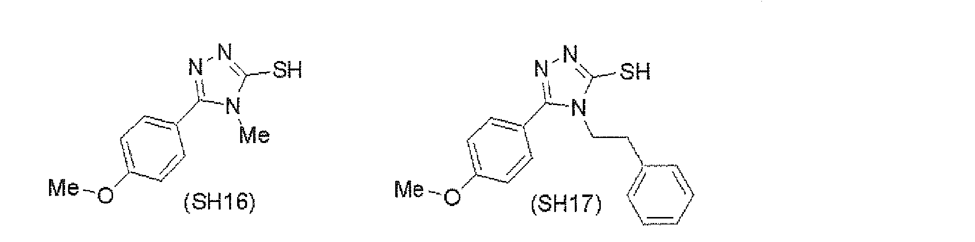

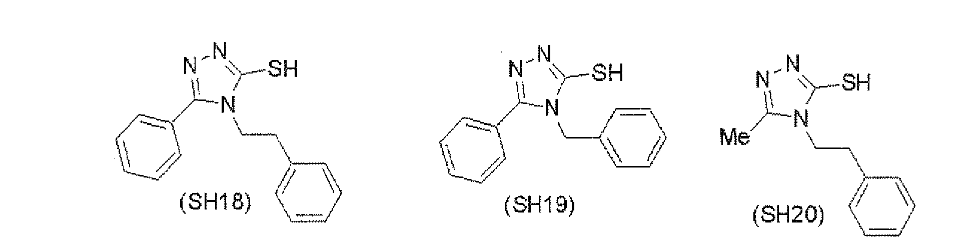

The mercapto group-containing heterocyclic compound is used preferably at a ratio from 0.2 to 10.0 moles, more preferably at a ratio from 0.5 to 6.0 moles, still more preferably at a ratio from 0.5 to 4.0 moles, per mole of the hexaarylbisimidazole compound.

### [Addition polymerizable compound having ethylenically unsaturated double bond]

The addition polymerizable compound (hereinafter, also simply referred to as polymerizable compound) having an ethylenically unsaturated double bond for use in the invention can be appropriately selected from compounds having at least one, preferably two or more ethylenically unsaturated double bond groups. The compound has a chemical form, for example, a monomer, a prepolymer, specifically, a dimmer, a trimer or an oligomer, a copolymer thereof or a mixture thereof. Examples of the monomer include an ester between an unsaturated carboxylic acid (for example, acrylic acid, methacrylic acid, itaconic acid, crotonic acid, isocrotonic acid or maleic acid) and an aliphatic polyhydric alcohol compound and an amide between an unsaturated carboxylic acid and an aliphatic polyvalent amine compound.

Specific examples of the monomer of the ester between an aliphatic polyhydric alcohol compound and an unsaturated carboxylic acid include as an acrylate, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol pentaacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, polyester acrylate oligomer and the like.

As a methacrylate, tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis[p-(3-methacryloxy-2-hydroxypropoxy)phenyl]dimethymethane, bis-[p-(methacryloxyelhoxy)phenyl]dimethymethane and the like are exemplified.

As an itaconate, ethylene glydcol diitaconate, propylene glycol diitaconate, 1,3-butanediol diitaconate, 1,4-butanediol diitaconate, tetramethylene glycol diitaconate, pentaerythritol diitaconate, sorbitol tetraitaconate and the like are exemplified.

As a crotonatate, ethylene glycol dicrotonate, tetramethylene glycol dicrotonate, pentaerythritol dicrotonate, sorbitol tetradicrotonate and the like are exemplified.
As an isocrotonate, ethylene glycol diisocrotonate, pentaerythritol diisocrotonate, sorbitol tetraisocrotonate and the like are exemplified.

As a maleate, ethylene glycol dimaleate, triethylene glycol dimaleate, pentaerythritol dimaleate, sorbitol tetramaleate and the like are exemplified.

Specific examples of the monomer of the amide between an aliphatic polyvalent amine compound and an unsaturated carboxylic acid include methylenebisacrylamide, methylenebismethacrylamide, 1,6-hexamethylenebisacrylamide, 1,6-hexamethylenebismethacrylamide, diethylenetriaminetrisacrylamide, xylylenebisacrylamide and xylylenebismethacrylamide.

Also, urethane type addition polymerizable compounds produced using an addition reaction between an isocyanate and a hydroxy group are also preferably used, and specific examples thereof include vinylurethane compounds having two or more polymerizable vinyl groups per molecule obtained by adding a vinyl monomer containing a hydroxy group represented by formula (A) shown below to a isocyanate compound having two or more isocyanate groups per molecule, described in JP-B-48-41708.

CH₂=C(R₄)COOCH₂CH(R₅)OH (A)

(wherein R₄ and R₅ each represents H or CH₃.)
The isocyanate compound preferably includes hexamethylene diisocyanate, 2,2,4-trimethylhexamethylene diisocyanate and the like.

Also, urethane acrylates as described in JP-A-51-37193, JP-B-2-32293 and JP-B-2-16765, and urethane compounds having an ethylene oxide skeleton described in JP-B-58-49860, JP-B-56-17654, JF-B-62-39417 and JP-B-62-39418 are preferably used. Further, a photopolymerizable composition having remarkably excellent photo-speed can be obtained by using an addition polymerizable compound having an amino structure or a sulfide structure in its molecule described in JP-A-63-277653, JP-A-63-260909 and JP-A-1-105238.

Other examples include polyfunctional acrylates and methacrylates, for example, polyester acrylates and epoxy acrylates obtained by reacting an epoxy resin with (meth)acrylic acid as described in JP-A-48-64183, JP-B-49-43191 and JP-B-52-30490. Also, specific unsaturated compounds described in JP-B-46-43946, JP-B-1-40337 and JP-B-1-40336, and vinylphosphonic acid type compounds described in JP-A-2-25493 can be exemplified. Further, in some cases, structure containing a perfluoroalkyl group described in JP-A-61-22048 can be preferably used. Moreover, photocurable monomers or oligomers described in Nippon Secchaku Kyokaishi, Vol. 20, No. 7, pages 300 to 308 (1984) can also be used.

Specifically, NK OLIGO U-4HA, NK OLIGO U-4H, NK OLIGO U-6HA, NK OLIGO U-6ELH, NK OLIGO U-108A, NK OLIGO U-1084A, NK OLIGO U-200AX, NK OLIGO U-122A, NK OLIGO U-340A, NK OLIGO UA-324A and NK OLIGO UA-100 (produced by Shin-Nakamura Chemical Co., Ltd.), UA-306H, AI-600, UA-101T, UA-101I, UA-306T and UA-306I (produced by Kyoeisha Chemical Co., Ltd.), ART RESIN UN-9200A, ART RESIN UN-3320HA, ART RESIN UN-3320HB, ART RESIN UN-3320HC, ART RESIN SH-380G, ART RESIN SH-500 and ART RESIN SH-9832 (produced by Negami Chemical Industrial Co., Ltd.), PLEX 6661-O (produced by Degussa AG, Germany) and the like are exemplified.

Details of the method of using the polymerizable compound, for example, selection of the structure, individual or combination use or the amount added, can be appropriately determined in accordance with the characteristic design of the final lithographic printing plate precursor. For instance, the compound is selected from the following standpoints.
In view of the sensitivity, a structure having a large content of unsaturated group per molecule is preferred and in many cases, a difunctional or more functional compound is preferred. Also, in order to increase the strength of the image area, that is, cured layer, a trifunctional or more functional compound is preferred. Further, a method for controlling both the sensitivity and the strength by using compounds different in the functional number or in the kind of polymerizable group (for example, an acrylic acid ester, a methacrylic acid ester, a styrene compound or a vinyl ether compound) in combination is also effective.
Also, the selection and use method of the polymerizable compound are also important factors for the compatibility and dispersibility with other components (for example, a binder polymer, a polymerization initiator or a coloring agent) in the photosensitive layer. For instance, the compatibility may be improved in some cases by using the compound of low purity or using two or more kinds of the compounds in combination. Also, a specific structure may be selected for the purpose of improving an adhesion property to the support, a protective layer described hereinafter or the like.

The polymerizable compound is used preferably in a range from 5 to 80% by weight, more preferably in a range from 25 to 75% by weight, based on the total solid content of the photosensitive layer. Also, the polymerizable compounds may be used individually or in combination of two ore more thereof. In addition, in the method of using the polymerizable compound, the structure, blend and amount added can be appropriately selected by taking account of the degree of polymerization inhibition due to oxygen, resolution, fogging property, change in refractive index, surface tackiness and the like.

### [Binder polymer]

The binder polymer for use in the invention is not particularly restricted and from the standpoint of solubility in an aqueous week alkali solution and developing property, an organic polymer having an acid group in its side chain is preferred and an organic polymer having a carboxylic acid is more preferred. Such organic polymers include addition polymers having a carboxylic acid group in their side chains, for example, polymers described in JP-A-59-44615, JP-B-54-34327, JP-B-58-12577, JP-B-54-25957, JP-A-54-92723, JP-A-59-53836 and JP-A-59-71048, specifically, methacrylic acid copolymers, acrylic acid copolymers, itaconic acid copolymers, crotonic acid copolymers, maleic acid copolymers, partially esterified maleic acid copolymers and the like.
Also, an acidic cellulose derivative having a carboxylic acid group in its side chain and a product obtained by adding a cyclic acid anhydride to an addition polymer having a hydroxy group are exemplified.
Further, polyurethane resins described in JP-B-7-120040, JP-B-7-120041, JP-B-7-120042, JP-B-8-12424, JP-A-63-287944, JP-A-63-287947, JP-A-1-271741 and JP-A-11-352691 are also useful as a binder polymer soluble or swellable in an aqueous weak alkali solution.
As the binder polymer, an acrylic resin, a methacrylic resin or a urethane resin is preferably used.

In the invention, the term "acrylic resin" means a (co)polymer containing at least any of acrylic acid, an acrylic acid derivative (for example, an acrylate (an alkyl ester, aryl ester, allyl ester or the like)), acrylamide and an acrylamide derivative. The term "methacrylic resin" means similarly a (co)polymer containing at least any of methacrylic acid, a methacrylic acid derivative, methacrylamide and a methacrylamide derivative. The term "urethane resin" means a polymer formed by a condensation reaction of a compound having plural (preferably two) isocyanate groups with a compound having plural (preferably two) hydroxy groups.

One preferable example of the binder polymer according to the invention is a copolymer containing (a) a repeating unit having a carboxylic acid. As the repeating unit (a) having a carboxylic acid group, a repeating unit represented by formula (I) shown below is preferably used.

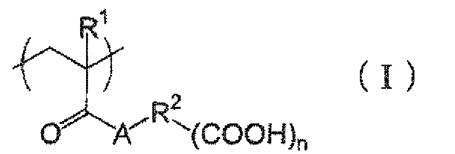

(in formula (I), R¹ represents a hydrogen atom or a methyl group, R² represents a single bond or an n+1 valent connecting group. A represents an oxygen atom or -NR³-, wherein R³ represents a hydrogen atom or a monovalent hydrocarbon group having from 1 to 10 carbon atoms, n represents an integer from 1 to 5.)

The connecting group represented by R² in formula (I) is constructed from a hydrogen atom, an oxygen atom, a nitrogen atom, a sulfur atom and a halogen atom and a number of atoms included therein exclusive of substituent(s) is preferably from 1 to 30. Specifically, an alkylene group, a substituted alkylene group, an arylene group, a substituted arylene group and the like are exemplified, and the connecting group may have a structure wherein a plurality of such divalent groups is connected to each other via an amido bond or an ester bond. R² is preferably a single bond, an alkylene group or a substituted alkylene group, particularly preferably a single bond, an alkylene group having from 1 to 5 carbon atoms or a substituted alkylene group having from 1 to 5 carbon atoms, and most preferably a single bond, an alkylene group having from 1 to 3 carbon atoms or a substituted alkylene group having from I to 3 carbon atoms.
The substituent includes a monovalent non-metallic atomic group exclusive of a hydrogen atom, for example, a halogen atom (e.g., -F, -Br, -Cl or -I), a hydroxy group, an alkoxy group, an aryloxy group, a mercapto group, an acyl group, a carboxyl group and a conjugate base group thereof, an alkoxycarbonyl group, an aryloxycarbonyl group, a carbamoyl group, an aryl group, an alkenyl group or an alkynyl group.

R³ is preferably a hydrogen atom or a hydrocarbon group having from 1 to 5 carbon atoms, particularly preferably a hydrogen atom or a hydrocarbon group having from 1 to 3 carbon atoms, and most preferably a hydrogen atom or a methyl group, n is preferably from 1 to 3, particularly preferably 1 or 2, and most preferably 1.

Specific examples of the repeating unit represented by formula (I) include those represented by (a-3) to (a-11) set forth below and the like, but the invention should not be construed as being limited thereto.

As other repeating unit in the copolymer containing the repeating unit (a) having a carboxylic acid, for example, monomers described in Kobunshi Data Handbook Kisohen (edited by The society of Polymer Science, Japan, Baifukan Co., Ltd., 1986) are exemplified. Such copolymerization components may be used in one kind or two or more kinds in combination.

Preferable copolymerization component includes a radical polymerizable compound selected from an acrylate, a methacrylate, an N,N-disubstituted acrylamide, an N,N-disubstituted methacrylamide, a styrene, acrylonitrile, methacrylonitrile and the like.

Specifically, for example, an acrylate, for example, an alkyl acrylate (preferably having from 1 to 20 carbon atoms in the alkyl group thereof) (specifically, e.g., methyl acrylate, ethyl acrylate, propyl acrylate, butyl acrylate, amyl acrylate, ethylhexyl acrylate, octyl acrylate, tert-octyl acrylate, chloroethyl acrylate, 2,2-dimethylhydroxypropyl acrylate, 5-hydroxypentyl acrylate, trimetylolpropane monoacrylate, pentaerythritol monoacrylate, glycidyl acrylate, benzyl acrylate, methoxybenzyl acrylate, furfuryl acrylate or tetrahydrofurfuryl acrylate) or an aryl acrylate (e.g., phenyl acrylate),

a methacrylate, for example, an alkyl methacrylate (preferably having from 1 to 20 carbon atoms in the alkyl group thereof) (e.g., methyl methacrylate, ethyl methacrylate, propyl methacrylate, isopropyl methacrylate, amyl methacrylate, hexyl methacrylate, cyclohexyl methacrylate, benzyl methacrylate, chlorobenzyl methacrylate, octyl methacrylate, 4-hydroxybutyl methacrylate, 5-hydroxypentyl methacrylate, 2,2-dimethyl-3-hydroxypropyl methacrylate, trimetylolpropane monomethacrylate, pentaerythritol monomethacrylate, glycidyl methacrylate, furfuryl methacrylate or tetrahydrofurfuryl methacrylate) or an aryl methacrylate (e.g., phenyl methacrylate, cresyl methacrylate or naphthyl methacrylate),

styrene, a styrene derivative, for example, an alkylstyrene (e.g., methylstyrene, dimethylstyrene, trimethylstyrene, ethylstyrene, diethylstyrene, isopropylstyrene, butylstyrene, hexylstyrene, cyclohexylstyrene, decylstyrene, benzylstyrene, chloromethylstyrene, trifluoromethylstyrene, ethoxymethylstyrene or acetoxymethylstyrene), an alkoxystyrene (e.g., methoxystyrene, 4-methoxy-3-methylstyrene or dimethoxystyrene), or a halogenostyrene (e.g., chlorostyrene, dichlorostyrene, trichlorostyrene, tetrachlorostyrene, pentachlorostyrene, bromostyrene, dibromostyrene, iodostyrene, fluorostyrene, trifluorostyrene, 2-bromo-4-trifluoromethylstyrene or 4-fluoro-3-trifluoromethylstyrene), acrylonitrile and methacrylonitrile are exemplified.

Of the radical polymerizable compounds, those preferably used include acrylates, methacrylates and styrenes. In particular, alkyl (meth)acrylates are preferred and the alkyl esters having from 1 to 5 carbon atoms in the alkyl group are particularly preferred.
The radical polymerizable compounds may be used in one kind or two or more kinds.

Another preferable example of the binder polymer for use in the invention is a copolymer containing (b) a repeating unit imparting a radical crosslinking property in addition to the repeating unit (a) having a carboxylic acid. Specific examples of the repeating unit (a) having a carboxylic acid (hereinafter, also referred to as repeating unit (a)) include the structures represented by (a-1) to (a-12) set forth below, but the invention should not be construed as being limited thereto.

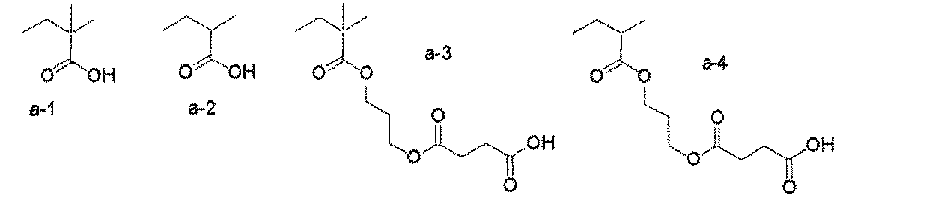

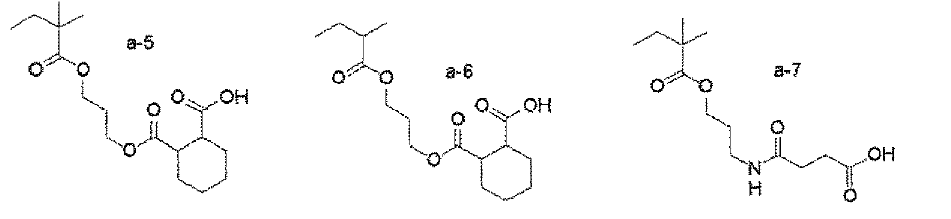

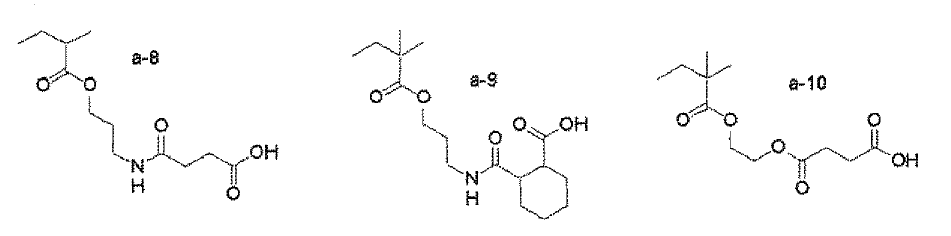

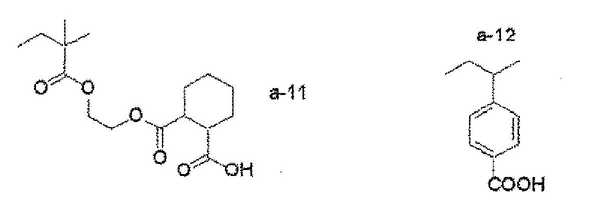

The content of the repeating unit (a) is from 5 to 50, preferably from 5 to 25, more preferably from 5 to 15, taking the number of the total repeating units as 100.
As a radical crosslinkable group of the repeating unit (b) imparting a radical crosslinking property (hereinafter, also referred to as repeating unit (b)), a terminal unsaturated bond is preferred, and an ethylenically double bong is preferred. From the standpoint of reactivity, an acryloyl group, a methacryloyl group, an aryl group, a vinyl ether group or a styrene group is preferred. Particularly, radical crosslinkable groups represented by formulae (1A) to (3A) described below are preferably used. Specific examples of the repeating unit (b) imparting a radical crosslinking property include the structures represented by (b-1) to (b-11) set forth below, but the invention should not be construed as being limited thereto.

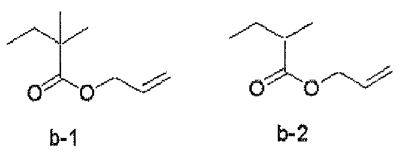

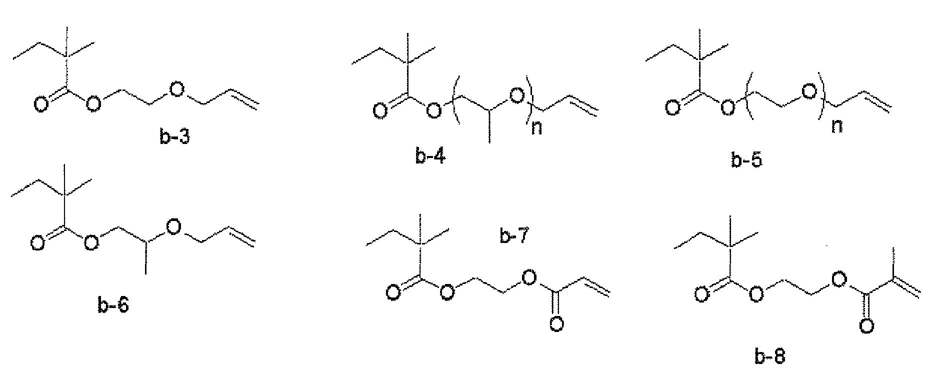

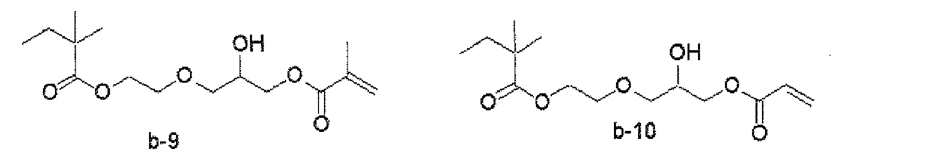

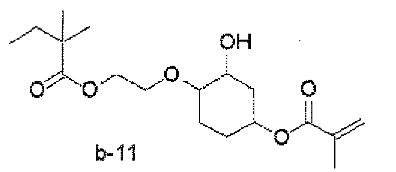

The content of the repeating unit (b) is from 5 to 90, preferably from 20 to 85, more preferably from 40 to 80, taking the number of the total repeating units as 100.

The binder polymer for use in the invention may have a repeating unit (hereinafter, also referred to as repeating unit (1)) represented by formula (1) shown below.

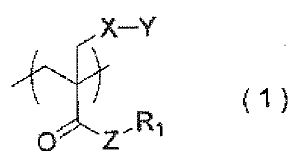

In formula (1), X represents an oxygen atom, a sulfur atom or a -NH- group, Y represents a hydrogen atom, an alkyl group having from 1 to 12 carbon atoms, a alicyclic alkyl group having from 5 to 12 carbon atoms or a group including an aromatic ring having from 6 to 20 carbon atoms, Z represents an oxygen atom, a sulfur atom or a -NH- group, and R₁ represents an alkyl group having from 1 to 18 carbon atoms, an alkyl group including an alicyclic structure having from 5 to 20 carbon atoms or a group containing an aromatic ring having from 6 to 20 carbon atoms.
Specific examples of the repeating unit (1) include the structures represented by (1-1) to (1-9) set forth below, but the invention should not be construed as being limited thereto,

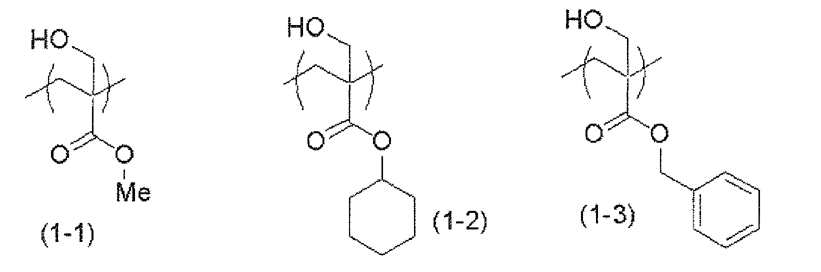

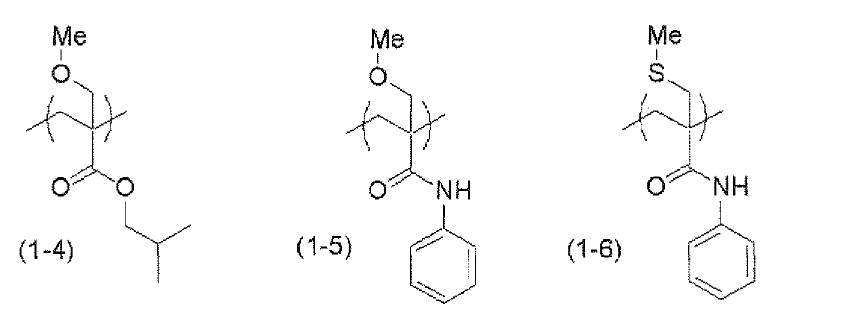

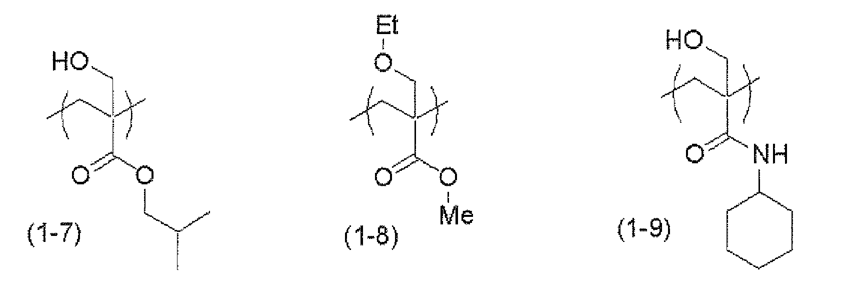

The content of the repeating unit (1) is from 1 to 40, preferably from 3 to 25, more preferably from 5 to 15, taking the number of the total repeating units as 100.

Specific examples of the binder polymer comprising preferable combination of the repeating units (a), (b) and (1) include Nos. (PP-1) to (PP-11) shown in Table 1 below, but the invention should not be construed as being limited thereto.

**TABLE 1**

| Specific Example No. | Repeating Unit (1) | Repeating Unit (a) | Repeating Unit (b) |
|---|---|---|---|
| PP-1 | 1-3 | a-1 | b-1 |
| PP-2 | 1-3 | a-1 | b-8 |
| PP-3 | 1-2 | a-1 | b-1 |
| PP-4 | 1-2 | a-1 | b-8 |
| PP-5 | 1-2 | a-1 | b-11 |
| PP-6 | 1-9 | a-5 | b-1 |
| PP-7 | 1-5 | a-3 | b-1 |
| PP-8 | 1-5 | a-3 | b-8 |
| PP-9 | 1-1 | a-3 | b-1 |
| PP-10 | 1-1 | a-5 | b-8 |
| PP-11 | 1-9 | a-3 | b-1 |

It is preferred that a urethane resin used as the binder polymer in the invention contains a crosslinkab1e group. The term "crosslinkable group" as used herein means a group capable of crosslinking the binder polymer in the process of a radical polymerization reaction which is caused in the image-recording layer, when the lithographic printing plate precursor is exposed to light. The crosslinkable group is not particularly restricted as long as it has such a function and includes, for example, an ethylenically unsaturated bond group, an amino group or an epoxy group as a functional group capable of undergoing an addition polymerization reaction. Also, a functional group capable of forming a radical upon irradiation with light may be used and such a crosslinkable group includes, for example, a thiol group, a halogen atom and an onium salt structure. Among them, the ethylenically unsaturated bond group is preferred, and functional groups represented by formulae (1A) to (3A) shown below are particularly preferred.

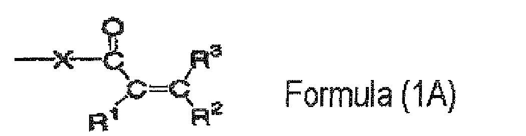

In formula (1A), R¹ to R³ each independently represents a hydrogen atom or a monovalent organic group. R¹ preferably includes a hydrogen atom, an alkyl group which may have a substituent or the like. Among them, a hydrogen atom or a methyl group is preferred because of high radical reactivity. R² and R³ each independently preferably includes a hydrogen atom, a halogen atom, an amino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, an arylsulfonyl group which may have a substituent and the like. Among them, a hydrogen atom, a carboxyl group, an alkoxycarbonyl group, an alkyl group which may have a substituent or an aryl group which may have a substituent is preferred because of high radical reactivity.

X represents an oxygen atom, a sulfur atom or -N(R¹²)-, and R¹² represents a hydrogen atom or a monovalent organic group. The monovalent organic group represented by R¹² includes an alkyl group which may have a substituent and the like. Among them, R₁₂ is preferably a hydrogen atom, a methyl group, an ethyl group or an isopropyl group because of high radical reactivity.

Examples of the substituent which can be introduced include an alkyl group, an alkenyl group, an alkynyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amido group, an akylsulfonyl group and an arylsulfonyl group.

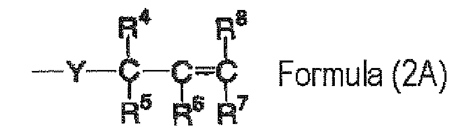

In formula (2A), R⁴ to R⁸ each independently represents a hydrogen atom or a monovalent organic group. R⁴ to R⁸ each independently preferably includes a hydrogen atom, a halogen atom, an amino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, an arylsulfonyl group which may have a substituent and the like. Among them, a hydrogen atom, a carboxyl group, an alkoxycarbonyl group, an alkyl group which may have a substituent or an aryl group which may have a substituent is preferred.

Examples of the substituent which can be introduced include those described in formulae (1A). Y represents an oxygen atom, a sulfur atom or -N(R¹²)-, and R¹² has the same meaning as R¹² defined in formulae (1A). Preferable examples for R¹² are also same as those described in formula (1A).

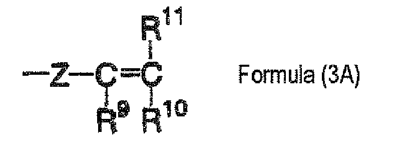

In formula (3A), R⁹ to R¹¹ each independently represents a hydrogen atom or a monovalent organic group. R⁹ preferably includes a hydrogen atom, an alkyl group which may have a substituent and the like. Among them, a hydrogen atom or a methyl group is preferred because of high radical reactivity. R¹⁰ and R¹¹ each independently represents a hydrogen atom, a halogen atom, an amino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent, an arylsulfonyl group which may have a substituent and the like. Among them, a hydrogen atom, a carboxyl group, an alkoxycarbonyl group, an alkyl group which may have a substituent or an aryl group which may have a substituent is preferred because of high radical reactivity.

Examples of the substituent introduced include those described in Formula (1A). Z represents an oxygen atom, a sulfur atom, -N(R¹²)- or a phenylene group which may have a substituent. R¹² has the same meaning as R¹² defined in formula (1A). Preferable examples for R¹² are also same as those described in formula (1A).

The polyurethane resin for use in the invention preferably contains in its side chain an aqueous week alkali-soluble group, for example, a carboxyl group as well as the crosslinkable group. The polyurethane resin is preferred in view of satisfying both good stain resistance and high printing durability because the development damage in the exposed area can be prevented without accompanying with deterioration of the developing property in the unexposed area, even when the acid value of the image-recording layer is low.

The polyurethane resin preferably used in the invention is a resin obtained by a polyaddition reaction of (i) a diisocyanate compound, (ii) a diol compound having a carboxyl group, (iii) a diisocyanate compound having a crosslinkable group and, if desired, (iv) a diol compound containing no carboxyl group.
The diisocyanate compound and diol compound which are starting materials of the polyurethane resin will be described below.

### (i) Diisocyanate compound

The diisocyanate compound includes a diisocyanate compound represented by formula (4) shown below.

OCN-L-NCO (4)

In formula (4), L represents a divalent aliphatic or aromatic hydrocarbon group which may have a substituent. If desired, L may contain other functional group which does not react with the isocyanate group, for example, a carbonyl group, an ester group, a urethane group, an amido group or a ureido group. More specifically, L represents a single bond or a divalent aliphatic or aromatic hydrocarbon group which may have a substituent (preferably, for example, an alkyl group, an aralkyl group, an aryl group, an alkoxy group or a halogen atom), preferably an alkylene group having from 1 to 20 carbon atoms or an arylene group having from 6 to 15 carbon atoms, more preferably an alkylene group having from 1 to 8 carbon atoms. Also, if desired, L may contain other functional group which does not react with the isocyanate group, for example, a carbonyl group, an ester group, a urethane group, an amido group, a ureido group or an ether group,
Specifically, those set forth below are exemplified. Specifically, an aromatic diisocyanate compound, for example, 2,4-tolylene diisocyanate, dimer of 2,4-tolylene diisocyanate, 2,6-tolylene diisocyanate, p-xylylene diisocyanate, m-xylylene diisocyanate, 4,4'-diphenylmethane diisocyanate, 1,5-naphtalene diisocyanate, or 3,3'-climethylbiphenyl-4,4'-diisocyanate; an aliphatic diisocyanate compound, for example, hexamethylene diisocyanate, trimethylhexamethylene diisocyanate, lysine diisocyanate or dimeric acid diisocyanate; an alicyclic diisocyanate compound, for example, isophorone diisocyanate, 4,4'-methylenebis(cyclohexyl isocyanate), methylcyclohexane-2,4(or 2,6)-diisocyanate or 1,3-(isocyanatomethyl)cyclohexane; and a diisocyanate compound obtained by a reaction of diol with diisocyanate, for example, an adduct of 1 mole of 1,3-butylene glycol with 2 moles of tolylene diisocyanate are exemplified.
The diisocyanate compounds may be used individually or in combination of two or more thereof. In view of the balance between printing durability and stain resistance, it is preferred to use two or more of the diisocyanate compounds in combination, and it is particularly preferred to use at least one of the aromatic diisocyanate compounds (L represents an aromatic group) and at least one of the aliphatic diisocyanate compounds (L represents an aliphatic group).
With respect to the amount of the diisocyanate compound used, a molar ration of the diisocyanate compound to the diol compound is preferably from 0.8 to 1.2, and more preferably from 0.9 to 1.1. In the case where an isocyanate group remains at a polymer terminal because of using an excess amount of the diisocyanate compound to the diol compound, it is preferred to treat the compound after the urethanization reaction with an alcohol or an amine to finally synthesize a compound having no residual isocyanate group at the terminal.

### (ii) Diol compound having at least one carboxyl group

The diol compound having at least one carboxyl group includes diol compounds represented by formulae (5), (6) and (7) shown below and a compound obtained by ring opening of a tetracarboxylic acid dianhydride with a diol compound.

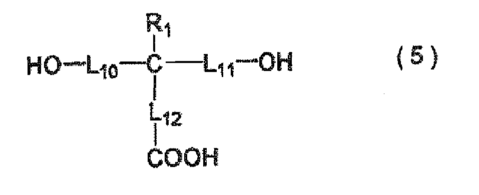

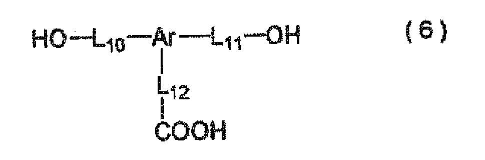

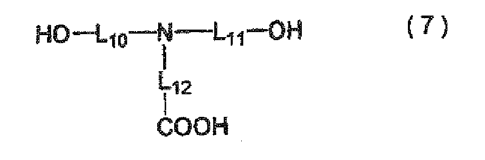

R₁ represents a hydrogen atom, an alkyl group, an aralkyl group, an aryl group, an alkoxy group or an aryloxy group, each of which may have a substituent (for example, a cyano group, a nitro group, a halogen atom (e.g., -F, -Cl, -Br or -I), -CONH₂, -COOR₁₁₃, -OR₁₁₃, -NHCONHR₁₁₃, -NHCOOR₁₁₃, -NHCOR₁₁₃ or -OCONHR₁₁₃ (wherein R₁₁₃ represents an alkyl group having from 1 to 10 carbon atoms or an aralkyl group having from 7 to 15 carbon atoms)), preferably a hydrogen atom, an alkyl group having from 1 to 8 carbon atoms or an aryl group having from 6 to 15 carbon atoms. L₁₀, L₁₁ and L₁₂, which may be the same or different, each represents a single bond or a divalent aliphatic or aromatic hydrocarbon group which may have a substituent (preferably, for example, an alkyl group, an aralkyl group, an aryl group, an alkoxy group or a halogen atom), preferably an alkylene group having from 1 to 20 carbon atoms or an arylene group having from 6 to 15 carbon atoms, more preferably an alkylene group having from 1 to 8 carbon atoms. Also, if desired, L₁₀, L₁₁ and L₁₂ each may contain other functional group which does not react with the isocyanate group, for example, a carbonyl group, an ester group, a urethane group, an amido group, a ureido group or an ether group. Further, two or three of R₁, L₁₀, L₁₁ and L₁₂ may be taken together to form a ring. Ar represents a trivalent aromatic hydrocarbon group which may have substituent, preferably an aromatic group having from 6 to 15 carbon atoms.

The diol compound having a carboxyl group represented by formula (5), (6) or (7) specifically includes the compounds shown below.

Specifically, 3,5-dihydroxybenzoic acid, 2,2-bis(hydroxymethyl)propionic acid, 2,2-bis(2-hydroxyethyl)propionic acid, 2,2-bis(3-hydroxypropyl)propionic acid, bis(hydroxymethyl) acetic acid, bis(4-hydroxyphenyl)acetic acid, 2,2-bis(hydroxymethyl)butyric acid, 4,4-bis(4-hydroxyphenyl)pentanoic acid, tartaric acid, N,N-dihydroxyethylglycine and N,N-bis(2-hydroxyethyl)-3-carboxypropionamide are exemplified.

Preferable examples of the tetracarboxylic acid dihydrate, which is used in the preparation of the diol compound having at least one carboxy group, include compounds represented by formulae (8), (9) and (10) shown below.

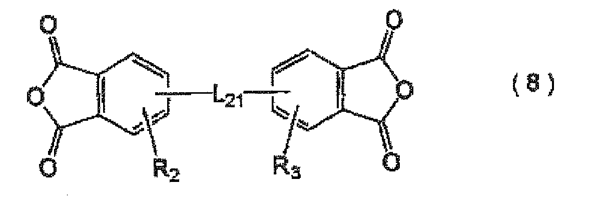

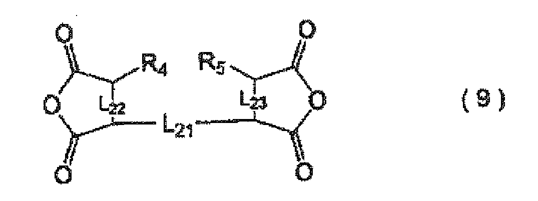

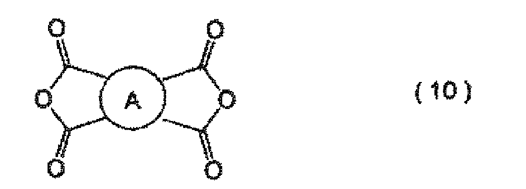

In the formulae, L₂₁ represents a single bond, a divalent aliphatic or aromatic hydrocarbon group which may have a substituent (preferably, for example, an alkyl group, an aralkyl group, an aryl group, an alkoxy group, a halogen atom, an ester group or an amido group), -CO-, -SO-, -SO₂-, -O- or -S-, preferably a single bond, a divalent aliphatic hydrocarbon group having from 1 to 15 carbon atoms, -CO-, -SO₂-, -O- or -S-. R₂ and R₃, which may be the same or different, each represents a hydrogen atom, an alkyl group, an aralkyl group, an aryl group, an alkoxy group or a halogen atom, preferably a hydrogen atom, ain alkyl group having from 1 to 8 carbon atoms, an aryl group having from 6 to 15 carbon atoms, an alkoxy group having from 1 to 8 carbon atoms or a halogen atom. Alternatively, two of L₂₁, R₂ and R₃ may be combined with each other to form a ring. R₄ and R₅, which may be the same or different, each represents a hydrogen atom, an alkyl group, an aralkyl group, an aryl group or a halogen atom, preferably a hydrogen atom, an alkyl group having from 1 to 8 carbon atoms or an aryl group having from 6 to 15 carbon atoms. Alternatively, two of L₂₁, R₄ and R₅ may be combined with each other to form a ring. L₂₂ and L₂₃, which may be the same or different, each represents a single bond, a double bond or a divalent aliphatic hydrocarbon group, preferably a single bond, a double bond or a methylene group. A represents a monocyclic or polycyclic aromatic ring, preferably an aromatic ring having from 6 to 18 carbon atoms.

The compound represented by formula (8), (9) or (10) specifically includes the compounds shown below.

Specifically, an aromatic tetracarboxylic acid dihydride, for example, pyromellitic acid dihydride, 3,3',4,4'-benzophenonetetracarboxylic acid dihydride, 3,3',4,4'-diphenyltetracarboxylic acid dihydride, 2,3,6,7-naphthalenetetracarboxylic acid dihydride, 1,4,5,8-naphthalenetetracarboxylic acid dihydride, 4,4'-sulfonyldiphthalic acid dihydride, 2,2-bis(3,4-dicarboxyphenyl)propane dihydride, bis(3,4-dicarboxyphenyl)ether dihydride, 4,4'-[3,3'-(alkylphosphoryldiphenylene)-bis(iminocarbonyl)]diphthalic acid dihydride, adduct of hydroquinonediacetate and trimellitic acid anhydride or adduct of diacetyldiamine and trimellitic acid anhydride; an alicyclic tetracarboxylic acid dihydride, for example, 5-(2,5-dioxotetrahydrofuryl)-3-methyl-3-cyclohexene-1,2-dicarboxylic acid dihydride (EPICRON B-4400, produced by Dainippon Ink & Chemicals, Inc.), 1,2,3,4-cyclopentanetetracarboxylic acid dihydride, 1,2,4,5-cyclohexanetetracarboxylic acid dihydride or tetrahydrofurantetracarboxylic acid dihydride; and an aliphatic tetracarboxylic acid dihydride, for example, 1,2,3,4-butanetetracarboxylic acid dihydride or 1,2,4,5-pentanetetracarboxylic acid dihydride are exemplified.

By ring-opening of the tetracarboxylic acid dianhydride with a diol compound, (ii) the diol compound having at least one carboxyl group can be synthesized. It is also possible that a reaction between the diol compound and (i) the diisocyanate compound is initially conducted and the resulting reaction product is reacted with the tetracarboxylic acid dianhydride to synthesize the polyurethane resin according to the invention. This method is also included in the concept of the invention. Specifically, the method of introducing a structural unit resulting from the tetracarboxylic acid dianhydride and the diol compound into the polyurethane resin includes the following methods:

a) Method wherein an alcohol-terminated compound obtained by ring-opening of the tetracarboxylic acid dianhydride with a diol compound is reacted with the diisocyanate compound and
b) Method wherein an alcohol-terminated urethane compound obtained by reacting the diisocyanate compound under excess of the diol compound is reacted with the tetracarboxylic acid dianhydride.

Of the diol compounds having at least one carboxyl group, the compounds represented by formula (5) are more preferred because of high solvent solubility and ease of synthesis. Also, the diol compound having at least one carboxyl group is introduced into the polyurethane resin binder in an amount so that the polyurethane resin binder contains from 0.2 to 4.0 meq/g, preferably from 0.3 to 3.0 meq/g, more preferably from 0.4 to 2.0 meq/g, particularly preferably from 0.5 to 1.5 meq/g, most preferably from 0.6 to 1.2 meq/g, of the carboxyl group. Therefore, although the content of the structure derived from the diol compound having at least one carboxylic group in the polyurethane resin binder can be appropriately determined after considering a number of the carboxyl group in the diol compound, other diol compound used in combination, an acid value or a molecular weight of the resulting polyurethane resin binder, a composition or pH of developer and the like, it is, for example, from 5 to 45% by mole, preferably from 10 to 40% by mole, and more preferably from 15 to 35% by mole.

### (iii) Diisocyanate compound having crosslinkable group

The diisocyanate compound having a crosslinkable group includes, for example, a reaction product obtained by an addition reaction of a triisocyanate compound with one equivalent of a monofunctional alcohol or monofunctional amine compound having a crosslinkable group.
As the triisocyanate compound, for example, the compounds set forth below are exemplified, but the invention should not be construed as being limited thereto.

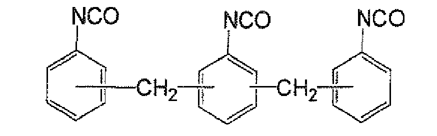

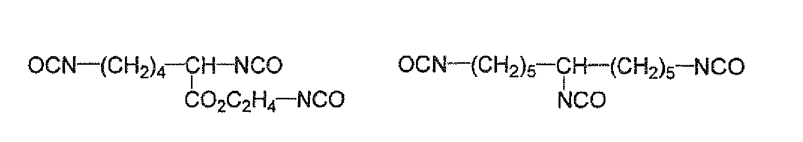

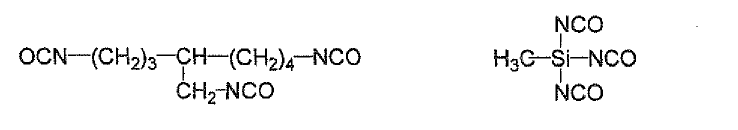

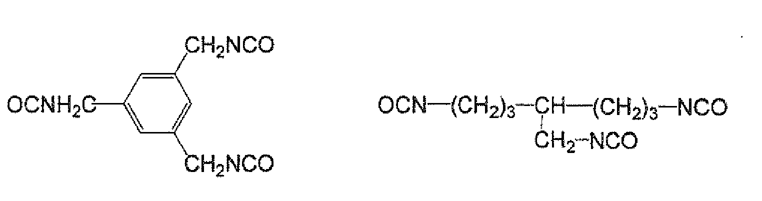

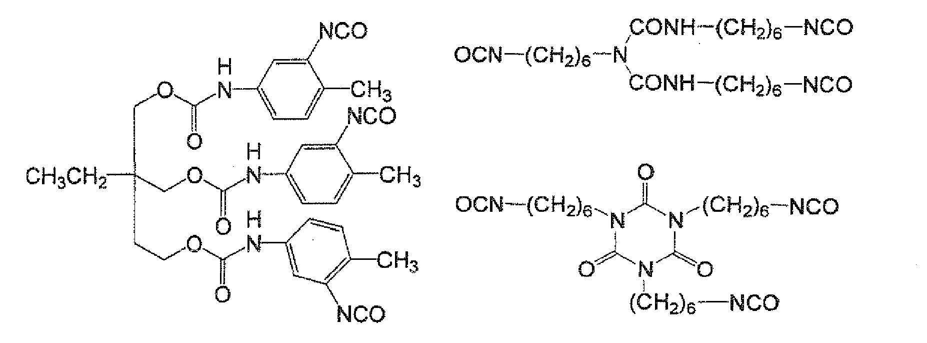

As the monofunctional alcohol or monofunctional amine compound having a crosslinkable group, for example, the compounds set forth below are exemplified, but the invention should not be construed as being limited thereto.

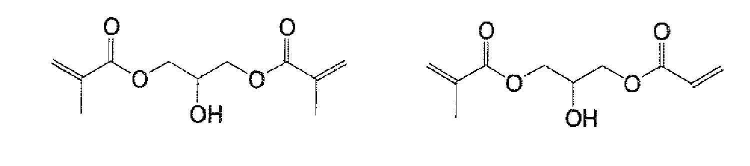

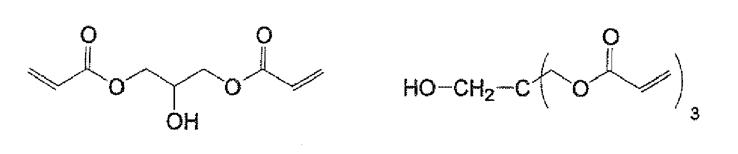

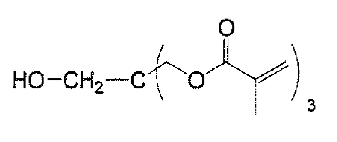

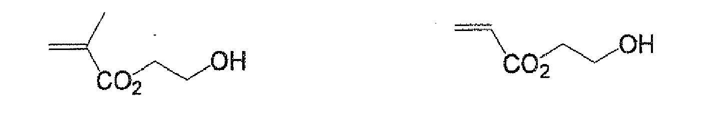

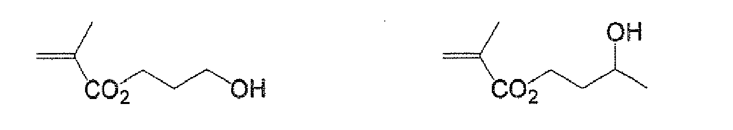

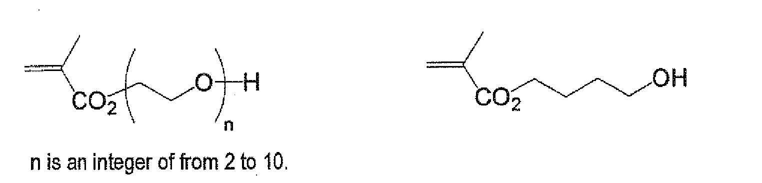

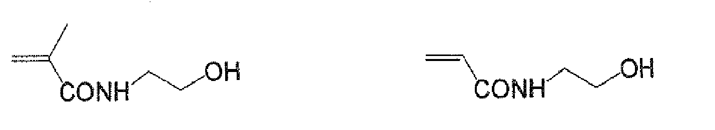

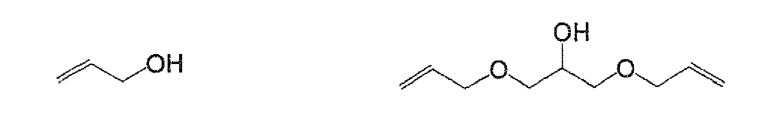

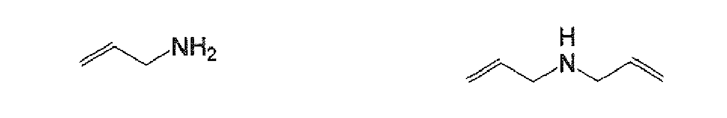

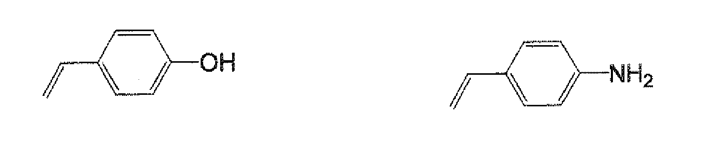

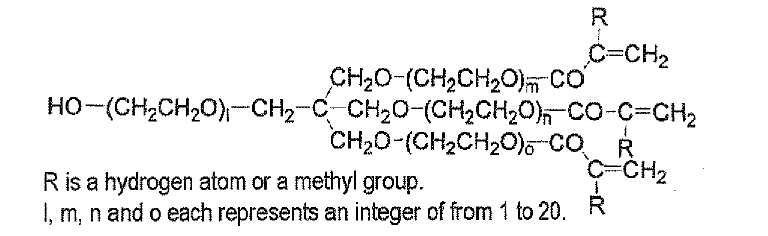

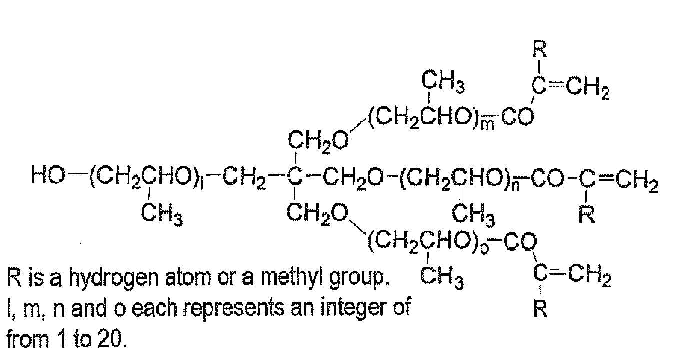

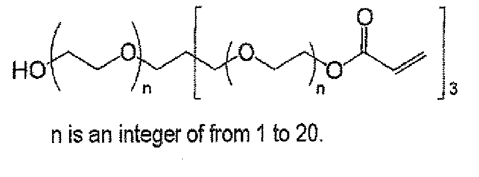

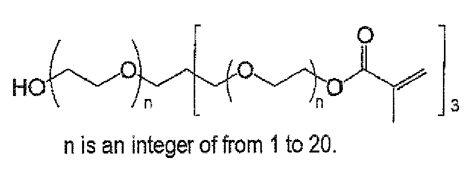

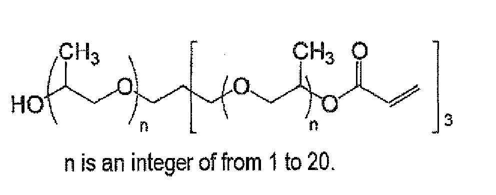

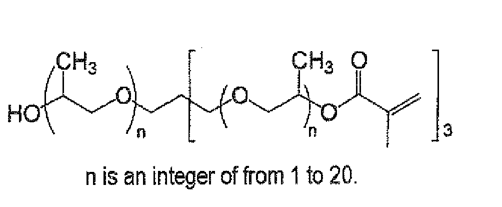

As a method for introducing a crosslinkable group into the side chain of the polyurethane resin, a method of using as a raw material for the production of polyurethane resin, the diisocyanate compound having the crosslinkable group in its side chain is preferred. As the diisocyanate compound having a crosslinkable group in its side chain obtained by an addition reaction of a triisocyanate compound with one equivalent of a monofunctional alcohol or monofunctional amine compound having the crosslinkable group, the compounds set forth below are exemplified, but the invention should not be construed as being limited thereto.

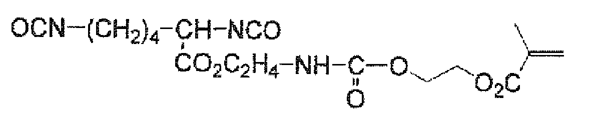

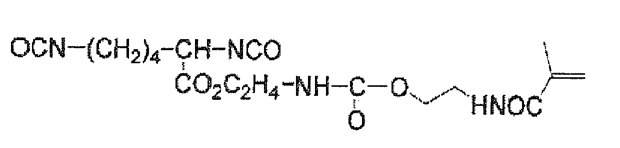

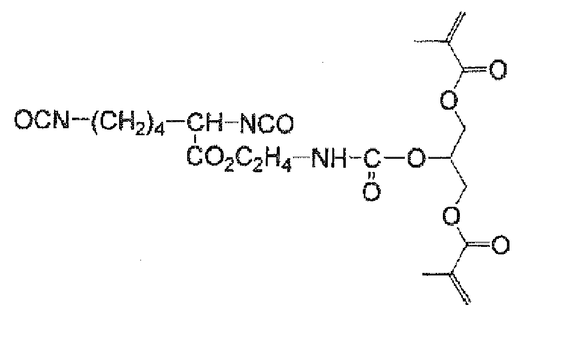

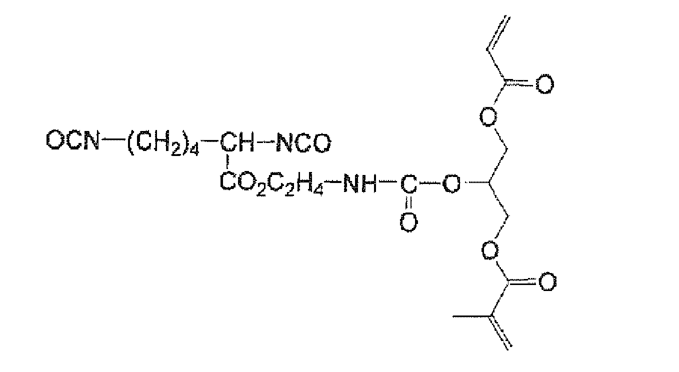

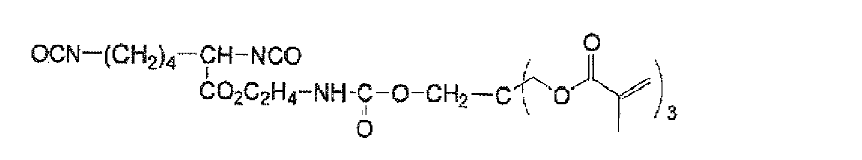

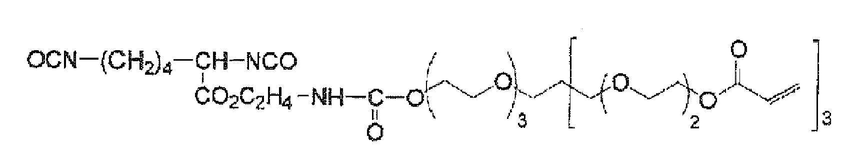

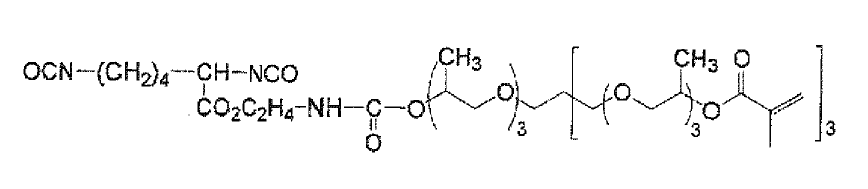

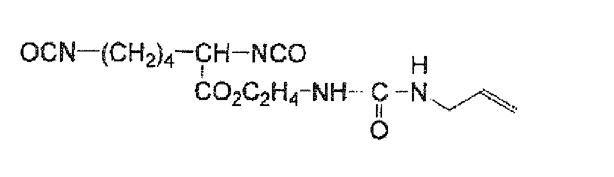

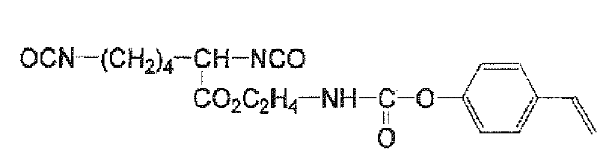

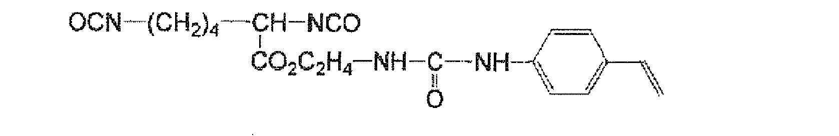

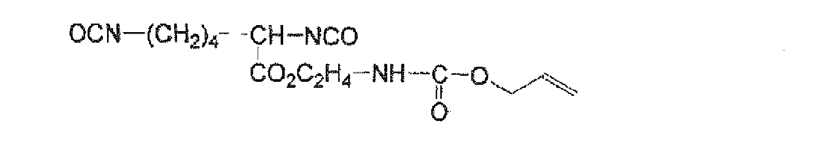

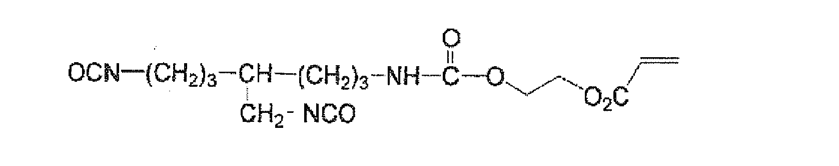

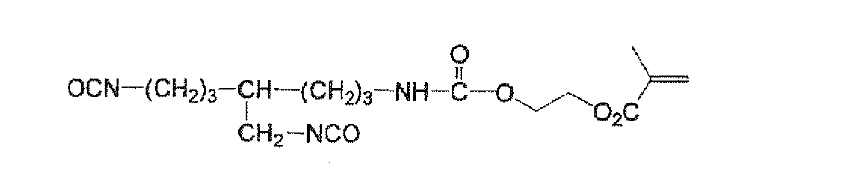

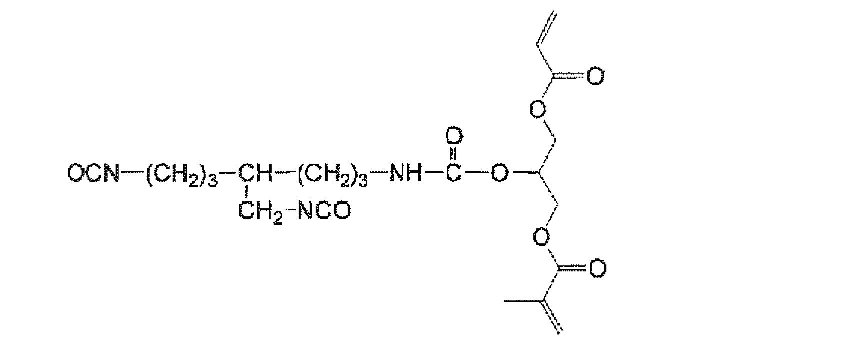

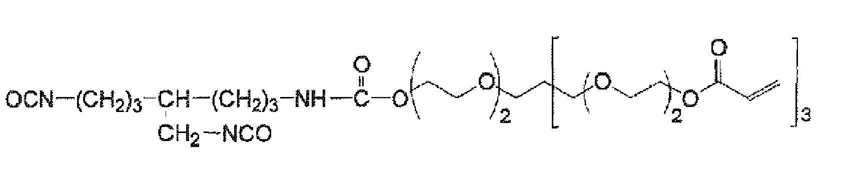

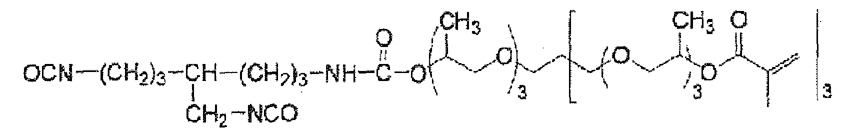

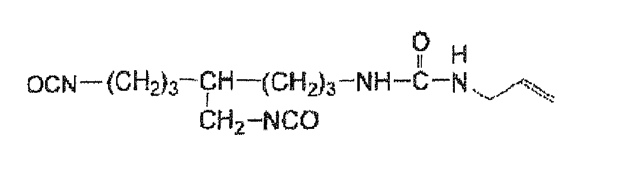

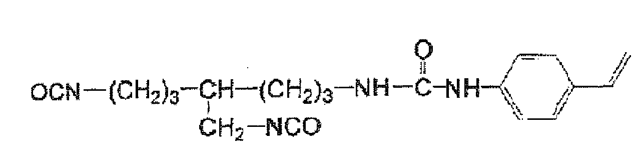

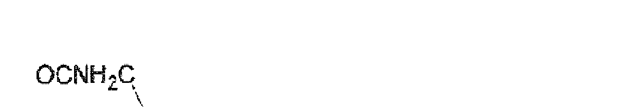

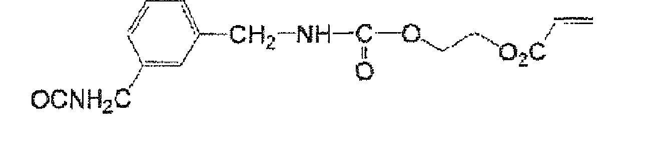

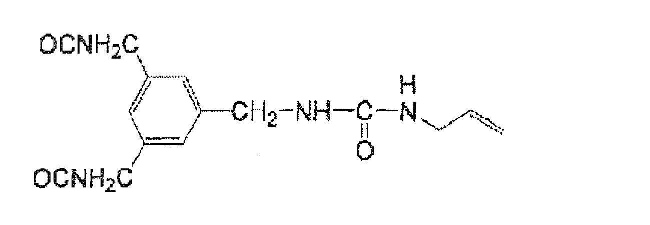

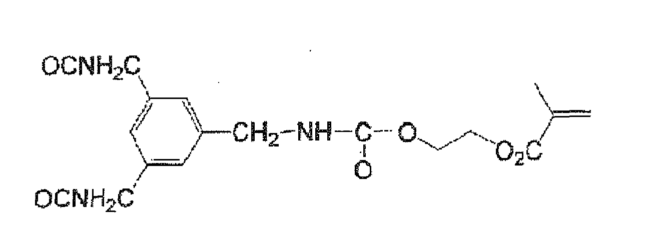

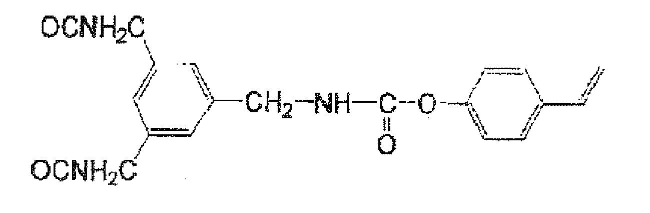

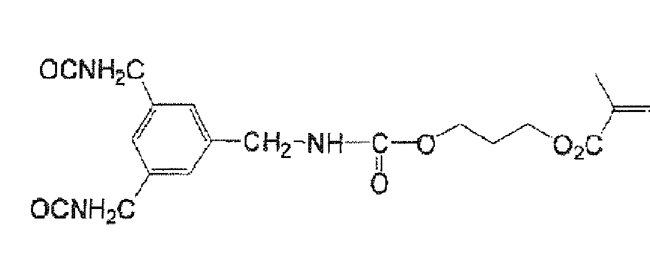

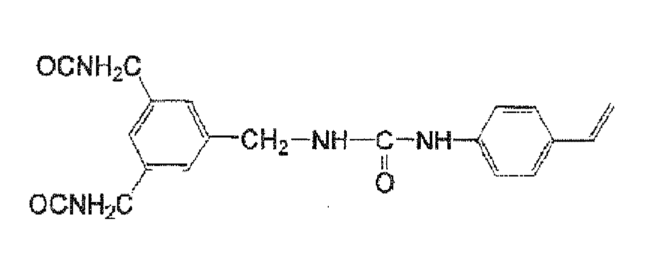

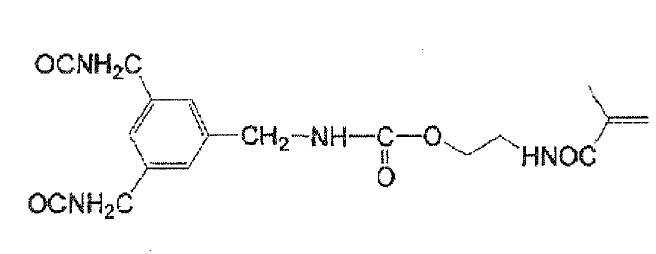

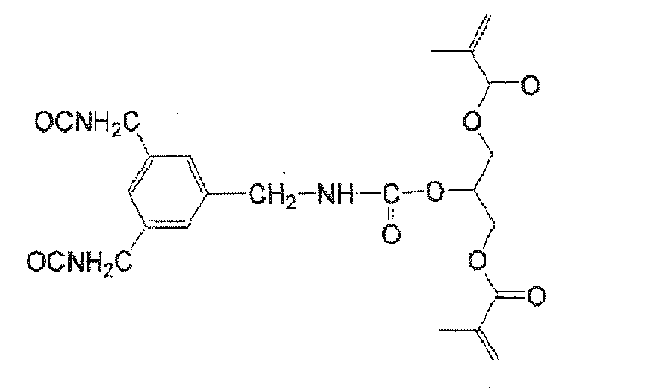

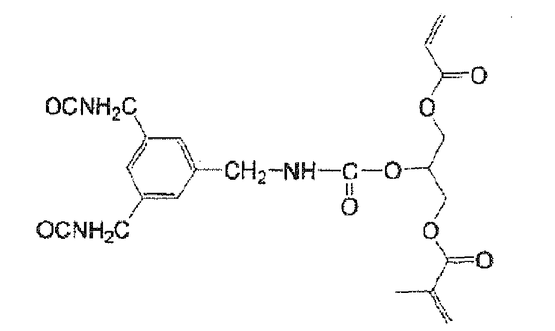

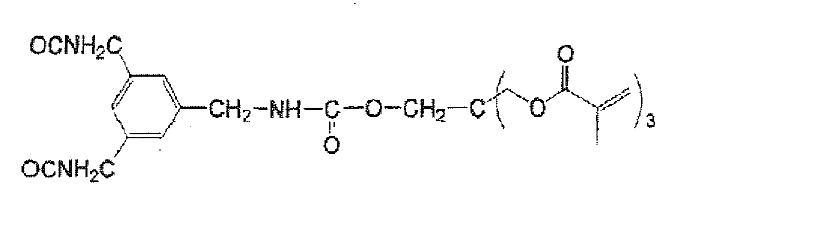

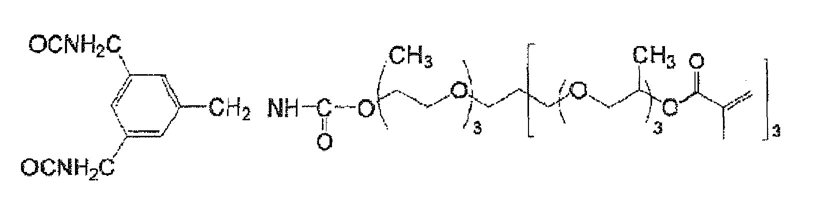

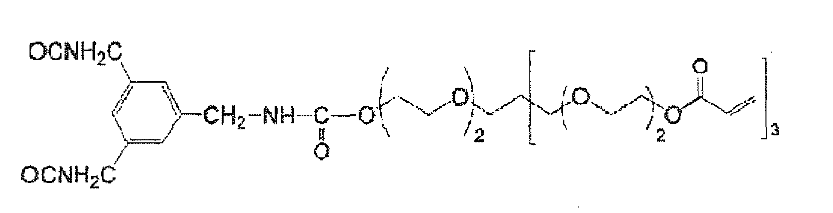

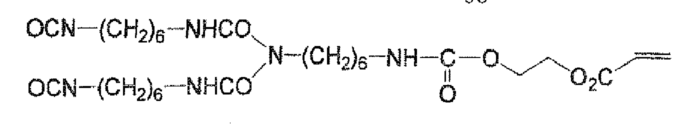

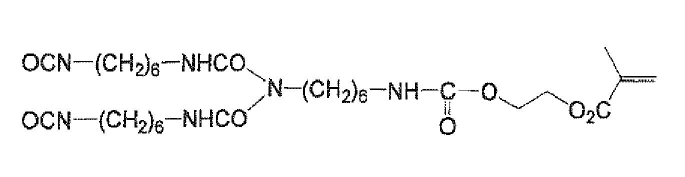

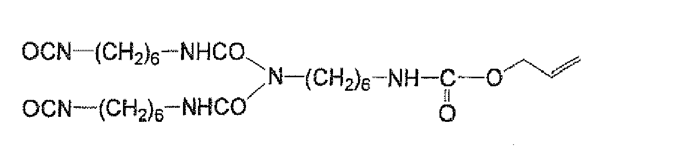

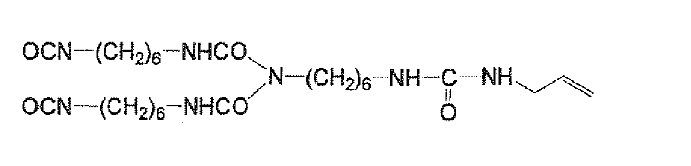

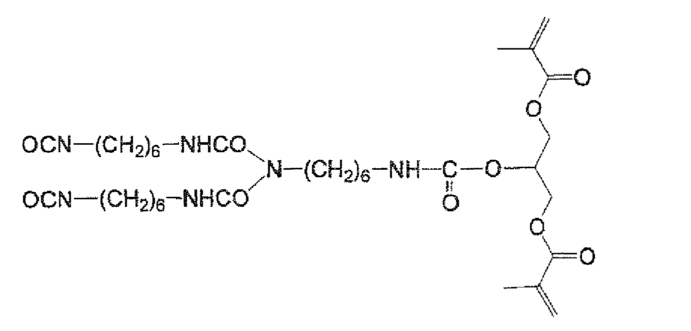

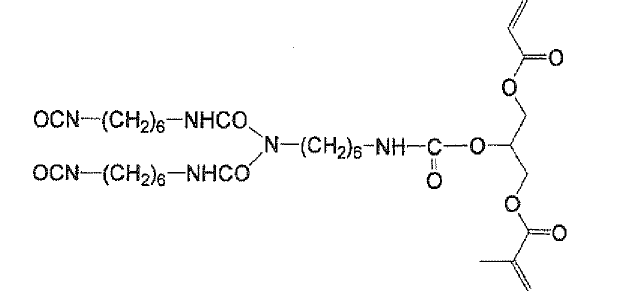

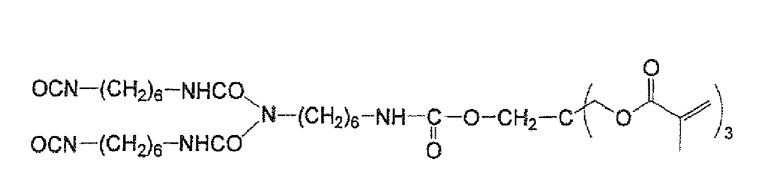

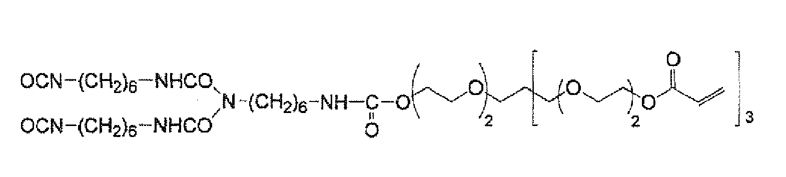

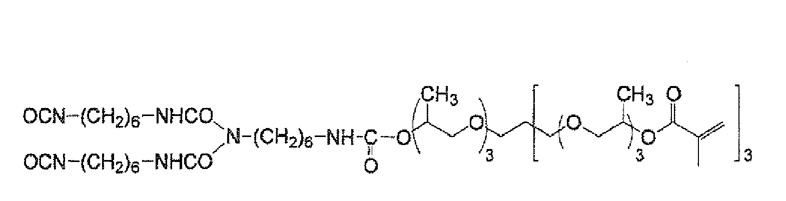

### (iv) Other diol compound

A method of using a diol compound having an unsaturated group in its side chain as a raw material for the production of polyurethane resin is also preferred as well as the method described above as the method of introducing the unsaturated group into the side chain of the polyurethane resin. Such a diol compound may be a commercially available compound, for example, trimethylolpropane monoallyl ether or a compound easily produced by a reaction of a halogenated diol compound, a triol compound or an aminodiol compound with a carboxylic acid, acid chloride, isocyanate, alcohol, amine, thiol or halogenated alkyl compound each having an unsaturated group. As specific examples of the diol compound having an unsaturated group, the compounds set forth below are exemplified, but the invention should not be construed as being limited thereto.

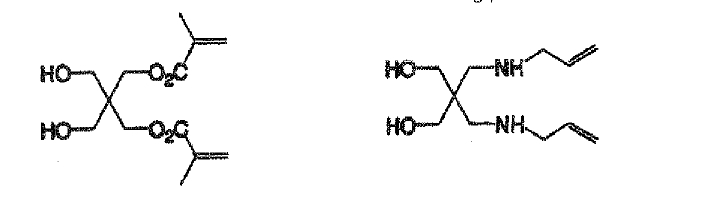

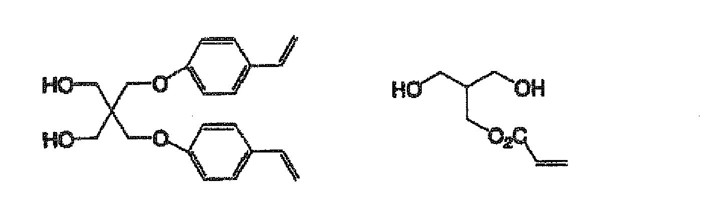

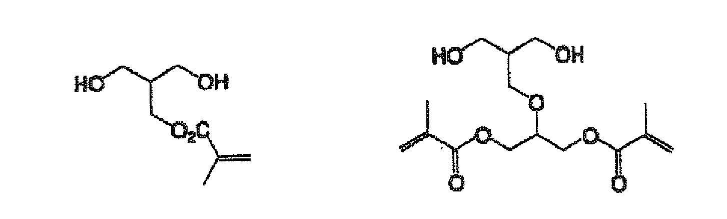

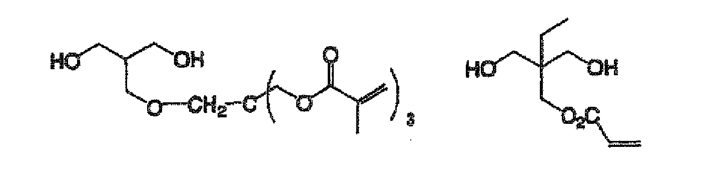

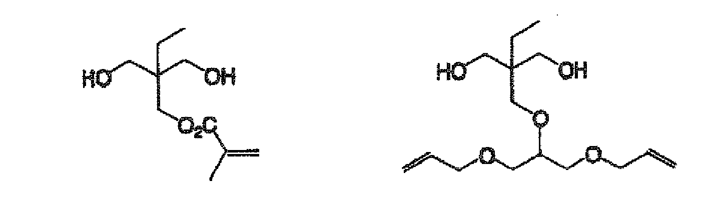

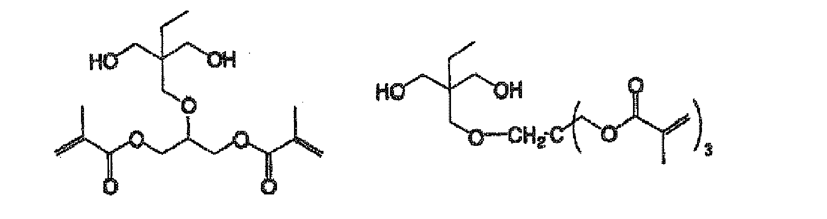

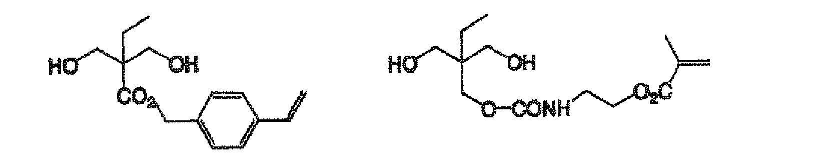

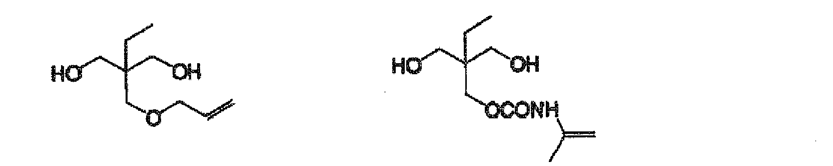

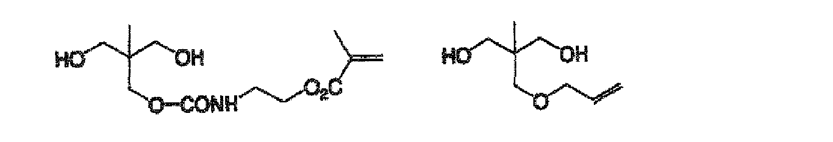

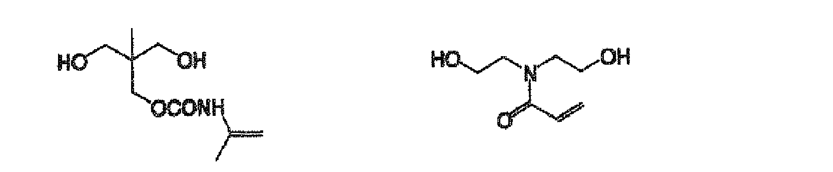

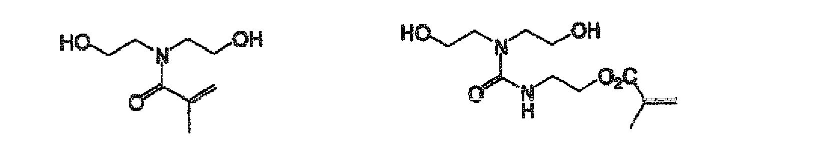

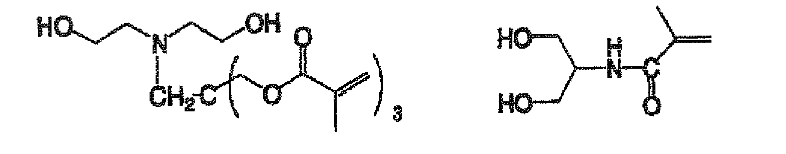

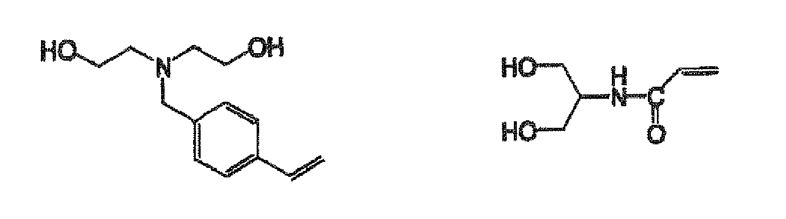

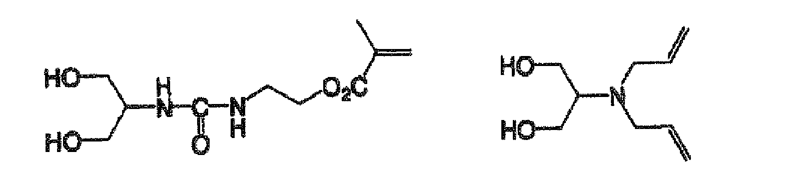

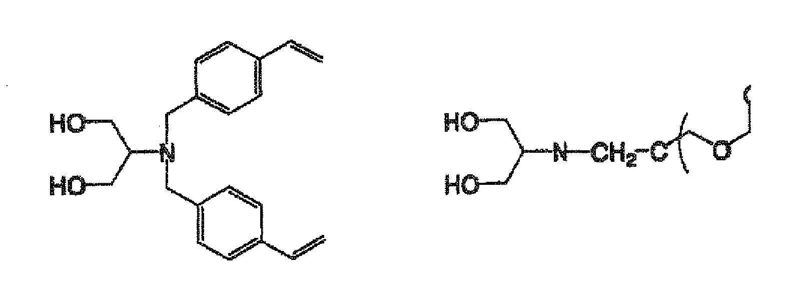

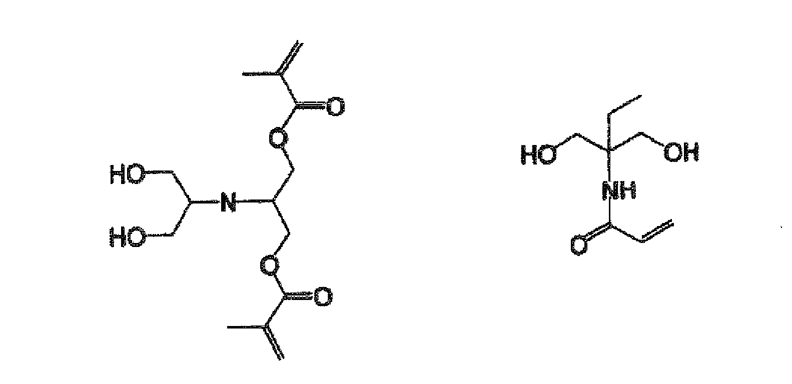

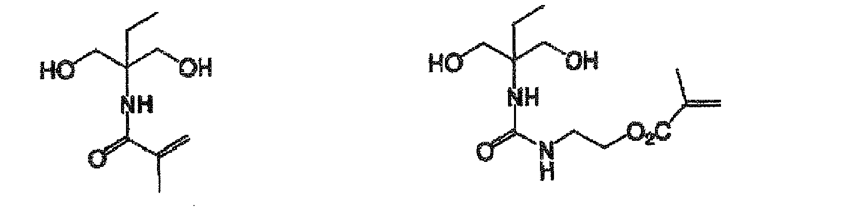

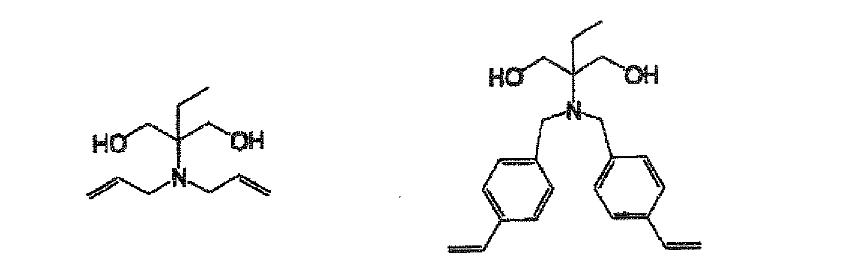

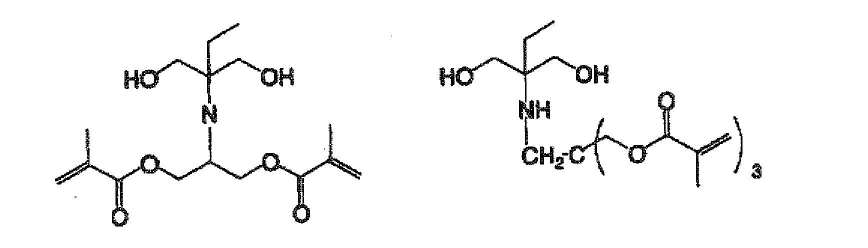

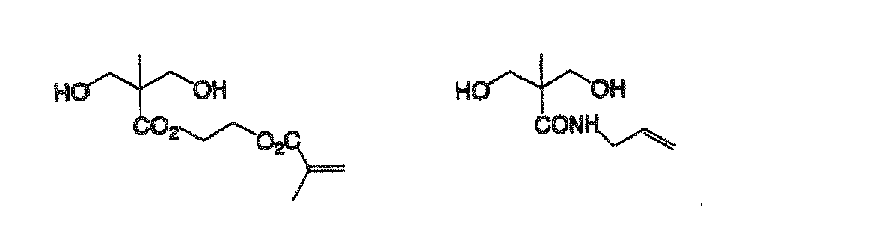

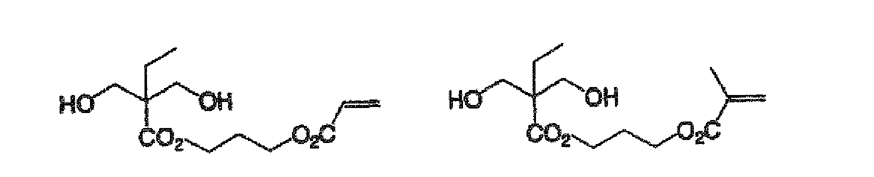

Further, as other diol compounds, ethylene glycol compounds represented by formula (A') shown below are exemplified.

HO-(CH₂CH₂O)ₙ-H (A')

(in the formula, n represents an integer of 1 or more.)

Also, random copolymers and block copolymers between ethylene oxide and propylene oxide having hydroxy groups at the terminals are exemplified.

Further, an ethylene oxide adduct of bisphenol A (addition number of the ethylene oxide is from 27 to 100), an ethylene oxide adduct of bisphenol F (addition number of the ethylene oxide is from 22 to 100), an ethylene oxide adduct of hydrogenated bisphenol A (addition number of the ethylene oxide is from 23 to 100) and an ethylene oxide adduct of hydrogenated bisphenol F (addition number of the ethylene oxide is from 18 to 100) are also used. More specifically, the ethylene glycol compounds represented by formula (A') are preferred in view of the stain property. The ethylene glycol compounds represented by formula (A') wherein n is form 2 to 50 are more preferred, the ethylene glycol compounds wherein n is form 3 to 30 are still more preferred, and the ethylene glycol compounds wherein n is form 4 to 10 are particularly preferred.

Specific examples thereof include 1,2-propylene glycol, di-1,2-propylene glycol, tri-1,2-propylene glycol, tetra-1,2-propylene glycol, hexa-1,2-propylene glycol, 1,3-propylene glycol, di-1,3-propylene glycol, tri-1,3-propylene glycol, tetra-1,3-propylene glycol, 1,3-butylene glycol, di-1,3-butylene glycol, tri-1,3-butylene glycol, hexa-1,3-butylene glycol, polypropylene glycol having an average molecular weight of 400, polypropylene glycol having an average molecular weight of 700, polypropylene glycol having an average molecular weight of 1,000, polypropylene glycol having an average molecular weight of 2,000, polypropylene glycol having an average molecular weight of 3,000, polypropylene glycol having an average molecular weight of 4,000, neopentyl glycol, 2-hutene-1,4-diol, 2,2,4-trimethyl-1,3-pentanediol, 1,4-bis-β-hydroxyethoxycyclohexane, 1,4-butanediol, 1,5-pentanediol, 1,6-hexanediol, 1,7-heptanediol, 1,8-octanediol, cyclohexanedimethanol, tricyclodecanedimethanol, hydrogenated bisphenol A, hydrogenated bisphenol F, an ethylene oxide adduct of bisphenol A (addition number of the ethylene oxide is 26 or less), an ethylene oxide adduct of bisphenol F (addition number of the ethylene oxide is 21 or less), an ethylene oxide adduct of hydrogenated bisphenol A (addition number of the ethylene oxide is 22 or less), an ethylene oxide adduct of hydrogenated bisphenol F (addition number of the ethylene oxide is 17 or less), a propylene oxide adduct of bisphenol A, a propylene oxide adduct of bisphenol F, a propylene oxide adduct of hydrogenated bisphenol A, a propylene oxide adduct of hydrogenated bisphenol F, hydroquinone dihydroxy ethyl ether, p-xylylene glycol, dihydroxyethylsulfone, bis(2-hydroxyethyl)-2,4-tolylenedicarbamate, 2,4-tolylene-bis(2-hydroxyethylcarbamide), bis(2-hydroxyethyl)-m-xylylenedicarbamate and bis(2-hydroxyethyl)isophthalate.

Further, polyether diol compounds of compounds represented by formulae (a), (b), (c), (d) and (e) below are preferably used.

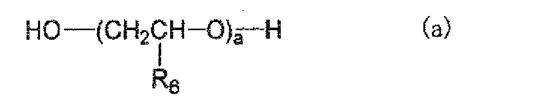

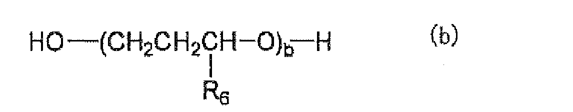

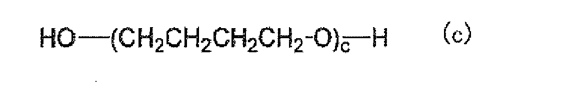

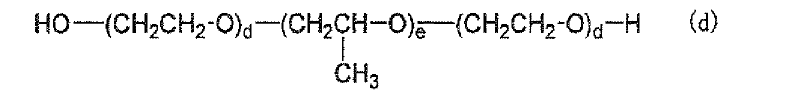

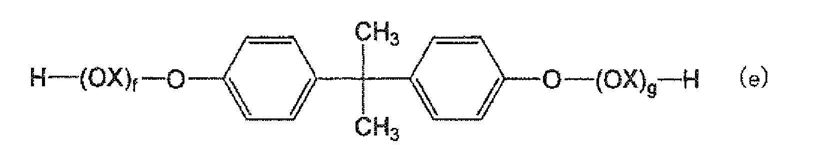

In formulae (a) to (e), R₆ represents a hydrogen atom or a methyl group, provided that R₆ in formula (a) represents a methyl group. X represents a group shown below.

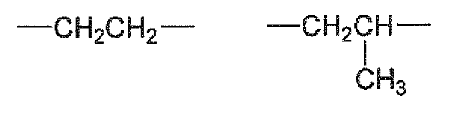

a, b, c, d, e, f and g each represents an integer of 2 or more, and preferably an integer from 2 to 100.

Polyester diol compounds represented by formulae (11) and (12) below are also enumerated as specific examples.

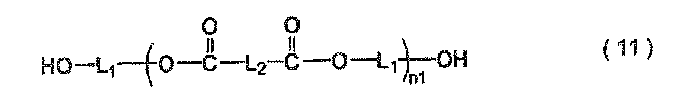

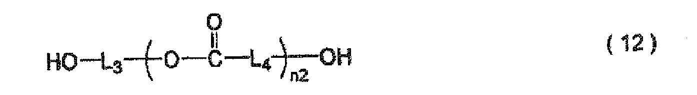

In formulae (11) and (12), L₁, L₂ and L₃, which may be the same or different, each represents a divalent aliphatic or aromatic hydrocarbon group, and L₄ represents a divalent aliphatic hydrocarbon group. Preferably, L₁, L₂ and L₃ each represents an alkylene group, an alkenylene group, an alkynylene group or an arylene group, and L₄ represents an alkylene goup. Also, L₁, L₂, L₃ and L₄ each may have other functional group which does not react with the isocyanate group, for example, an ether group, a carbonyl group, an ester group, a cyano group, an olefin group, a urethane group, an amido group, a ureido group or a halogen atom. n1 and n2 each represents an integer of 2 or more, preferably an integer from 2 to 100.

Further, polycarbonate diol compounds represented by formula (13) below are also enumerated as specific examples.

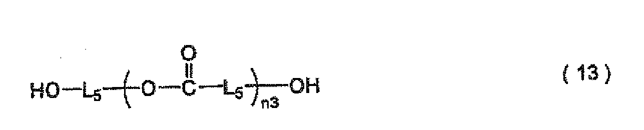

In the formula (13), L₅, which may be the same or different, each represents a divalent aliphatic or aromatic hydrocarbon group. Preferably, L₅ represents an alkylene group, an alkenylene group, an alkynylene group or an arylene group. Also, L₅ may have other functional group which does not react with the isocyanate group, for example, an ether group, a carbonyl group, an ester group, a cyano group, an olefin group, a urethane group, an amido group, a ureido group or a halogen atom. n3 each represents an integer of 2 or more, preferably an integer from 2 to 100.
Specific examples of the diol compound represented by formula (11), (12) or (13) include the compounds shown below. In the specific examples, n represents an integer of 2 or more.

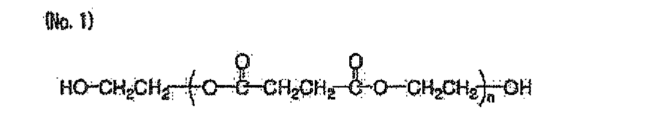

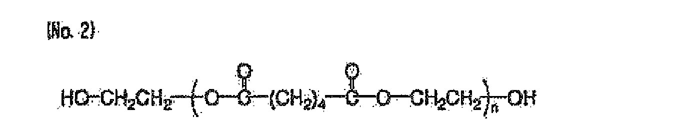

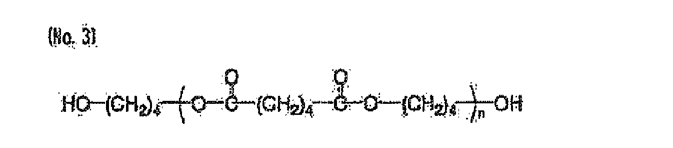

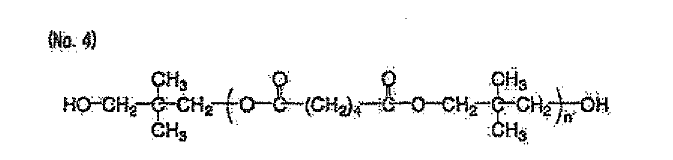

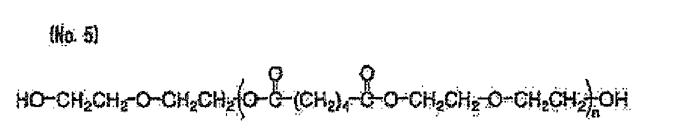

Further, diol compounds shown below are also preferably used.

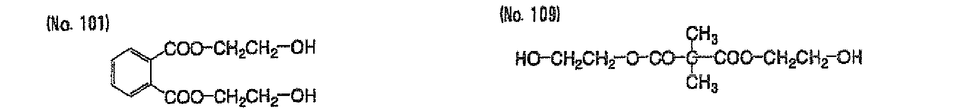

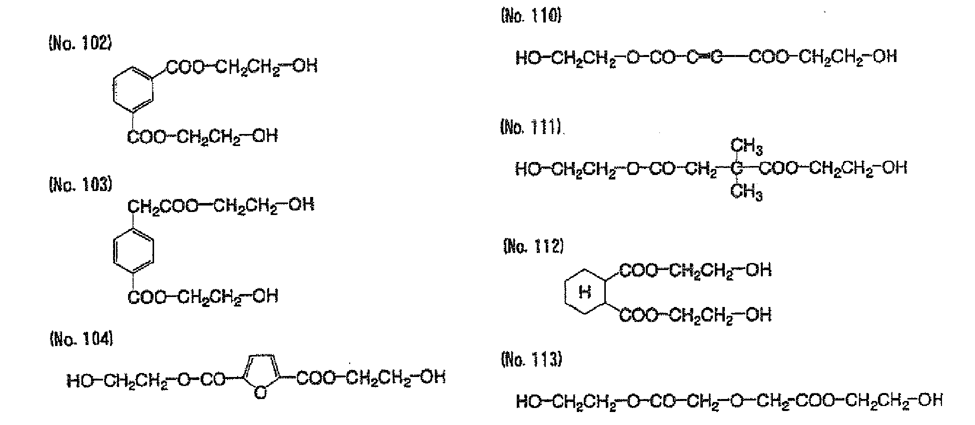

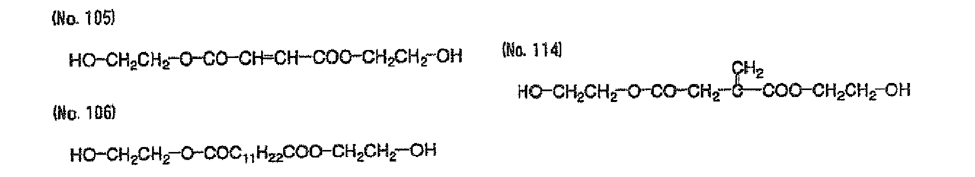

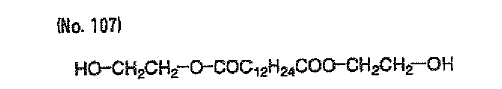

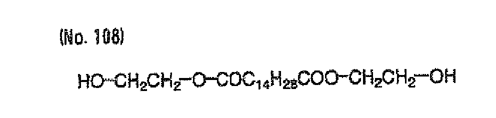

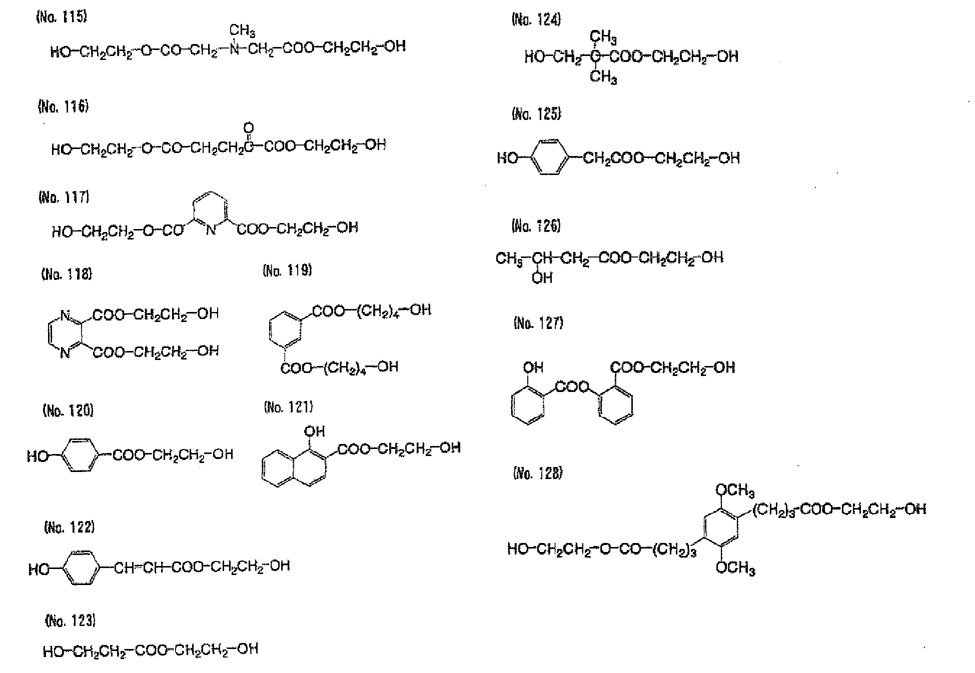

Moreover, diol compounds shown below are also preferably used.

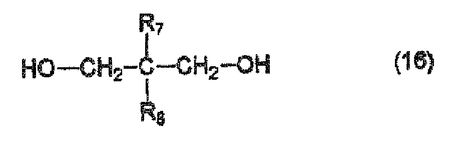

HO-GH₂-C≡C-CH₂-OH (17)

HO-CH₂-CH=CH₂-OH (18)

In the formula (16), R₇ and R₈, which may be the same or different, each represents an alkyl group which may have a substituent, preferably an alkyl group having from 1 to 10 carbon atoms which may have a substituent (for example, a cyano group, a nitro group, a halogen atom (e.g., -F, -Cl, -Br or -I), -CONH₂, -COOR or -OR (wherein R, which may be the same or different, each represents an alkyl group having from 1 to 10 carbon atoms, an aryl group having from 7 to 15 carbon atoms or an aralkyl group)).

Specific examples of the diol compound represented by formula (16) include the compounds shown below.

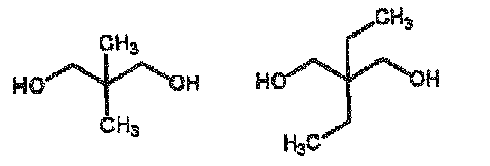

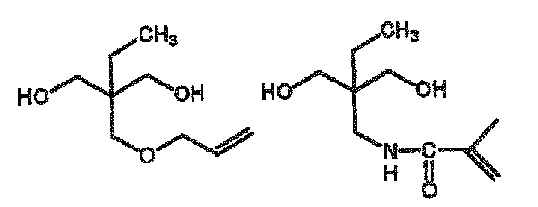

The diol compound represented by formulae (17) includes 2-butyne-1,4-diol. The diol compound represented by formula (18) includes cis-2-butene-1,4-diol, trans-2-butene-1,4-diol and the like.
Furthermore, diol compounds represented by formulae (19) and (20) shown below are also preferably used.

HO-L₈-NH-CO-L₉-CO-NH-L₈-OH (19)

HO-L₉-CO-NH-L₈-OH (20)

In the formulae, L₈ and L₉, which may be the same or different, each represents a divalent aliphatic hydrocarbon group, aromatic hydrocarbon group or heterocyclic group, each of which may have a substituent (for example, an alkyl group, an aralkyl group, an aryl group, an alkoxy group, an aryloxy group or a halogen atom (e.g., -F, -Cl, -Br or -I)). L₈ and L₉ each may have other functional group which does not react with the isocyanate group, for example, a carbonyl group, an ester group, a urethane group, an amido group or a ureido group, if desired. Alternatively, L₈ and L₉ may be combined with each other to form a ring.

Specific examples of the diol compound represented by formula (19) or (20) include the compounds shown below.

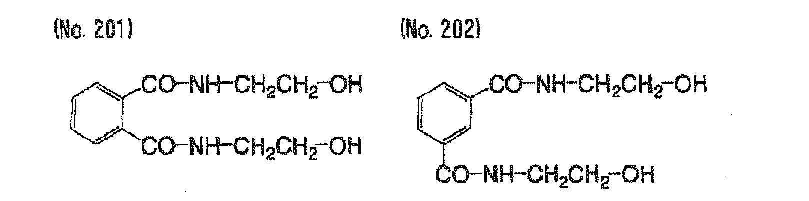

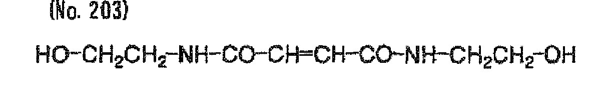

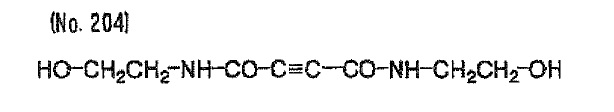

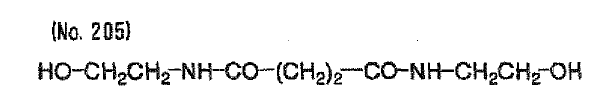

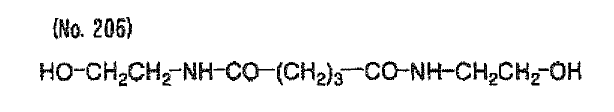

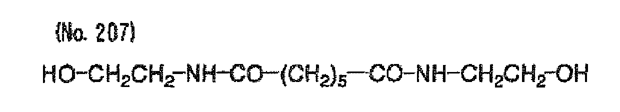

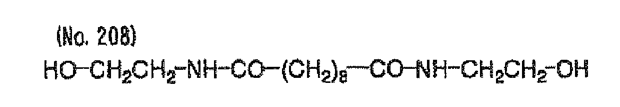

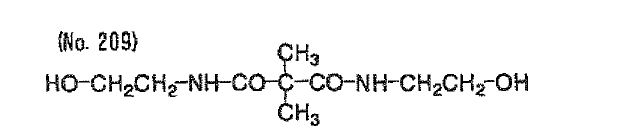

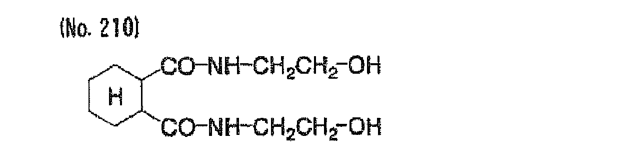

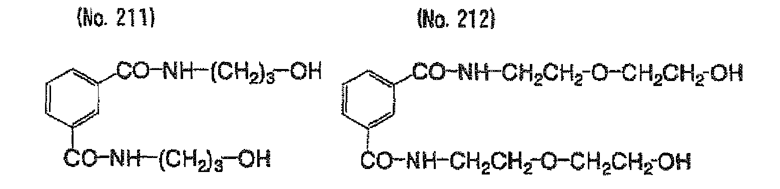

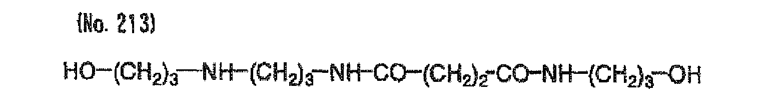

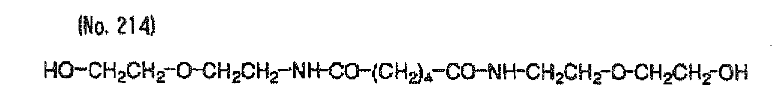

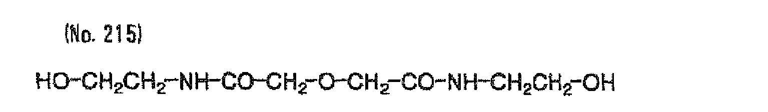

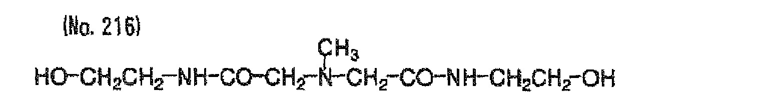

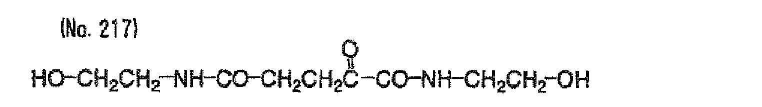

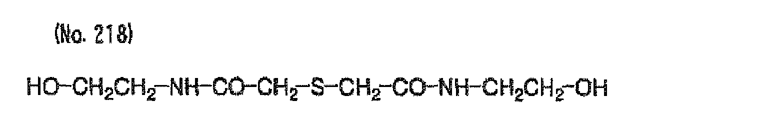

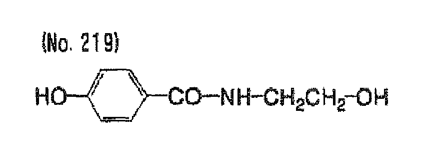

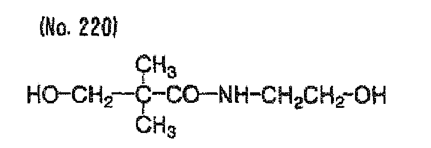

Furthermore, diol compounds represented by formulae (21) and (22) shown below are also preferably used.

HO-Ar₂-(L₁₆-Ar₃)ₙ-OH (21)

HO-Ar₂-L₁₆-OH (22)

In the formulae, L₁₆ represents a divalent aliphatic hydrocarbon group which may have a substituent (for example, an alkyl group, an aralkyl group, an aryl group, an alkoxy group, an aryloxy group or a halogen atom). L₁₆ may have other functional group which does not react with the isocyanate group, for example, an ester group, a urethane group, an amido group or a ureido group, if desired.

Ar₂ and Ar₃, which may be the same or different, each represents a divalent aromatic hydrocarbon group which may have a substituent, preferably an aromatic group having from 6 to 15 carbon atoms. n represents an integer from 0 to 10.
Specific examples of the diol compound represented by formula (21) or (22) include the compounds shown below.

Specifically, catechol, resorcine, hydroquinone, 4-methylcatechol, 4-tert-butylcatechol, 4-acetylcatechol, 3-methoxycatechol, 4-phenylcatechol, 4-methylresorcine, 4-ethylresorcine, 4-tert-butylresorcine, 4-hexylresorcine, 4-chlororesorcine, 4-benzylresorcine, 4-acetylresorcine, 4-carbomethoxyresorcine, 2-methylresorcine, 5-methylresorcine, tert-butylhydroquinone, 2,5-di-tert-butylhydroquinone, 2,5 -di-tert-amylhydroquinone, tetramethylhydroquinone, tetrachlorohydroquinone, methylcarboaminohydroquinone, methylureidohydroquinone, methylthiohydroquinone, benzonorbornene-3,6-diol, bisphenol A, bisphenol S, 3,3'-dichlorobisphenol S, 4,4'-dihydroxybenzophenone, 4,4'-dihydroxybiphenyl, 4,4'-thiodiphenol, 2,2'-dihydroxydaphenylmethane, 3,4-bis(p-hydroxyphenyl)hexane, 1,4-bis(2-p-hydroxyphenyl)propyl)brnzene, bis{4-hydroxyphenyl)methylamine, 1,3-dihydroxynaphthalene, 1,4-dihydroxynaphthalene, 1,5-dihydroxynaphthalene, 2,6-dihydroxynaphthalene, 1,5-dihydroxyanthraquinone, 2-hydroxybezyl alcohol, 4-hydroxybezyl alcohol, 2-hydroxy-3,5-di-tert-butylbezyl alcohol, 4-hydroxy-3,5-di-tert-butylbezyl alcohol, 4-hydroxyphenethyl alcohol, 2-hydroxyethyl-4-hydraxybenzoate, 2-hydroxyethyl-4-hydroxyphenylacetate and resorcine mono-2-hydroxyethyl ether are exemplified. The diol compounds shown below are also preferably used.

### (v) Other amido group-containing compound

In the polyurethane resin binder according to the invention, an amino group-containing compound represented by formula (31) or (32) shown below may be used together to react with the diisocyanate compound, thereby forming a urea structure to incorporate into the polyurethane resin.

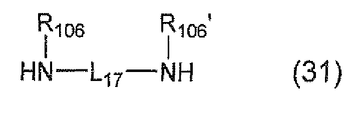

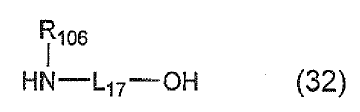

In the formulae, R₁₀₆ and R₁₀₆, which may be the same or different, each represents a hydrogen atom, an alkyl group, an aralkyl group or an aryl group, each of which may have a substituent (for example, an alkoxy group, a halogen atom (e.g., -F, -Cl, -Br or -I), an ester group or a carboxyl group), preferably a hydrogen atom, an alkyl group having from 1 to 8 carbon atoms or an aryl group having from 6 to 15 carbon atoms, each of which may have a carboxyl group as a substituent. L₁₇ represents a divalent aliphatic hydrocarbon group, aromatic hydrocarbon group or heterocyclic group, each of which may have a substituent (for example, an alkyl group, an aralkyl group, an aryl group, an alkoxy group, an aryloxy group, a halogen atom (e.g., -F, -Cl, -Br or -I) or a carboxyl group). L₁₇ may have other functional group which does not react with the isocyanate group, for example, a carbonyl group, an ester group, a urethane group or an amido group, if desired. Alternatively, two of R₁₀₆, L₁₇ and R₁₀₆ may be combined with each other to form a ring.

Specific examples of the compound represented by formula (31) or (32) include the compounds shown below.

Specifically, aliphatic diamine compounds, for example, ethylenediamine, propylenediamine, tetramethylenediamine, pentamethylenediamine, hexamethylenediamine, heptamethylenediamine, octamethylenediamine, dodecamethylenediamine, propane-1,2-diamine, bis(3-aminopropyl)methylamine, 1,3-bis(3-aminopropyl)tetramethylsiloxane, piperazine, 2,5-dimethylpiperazine, N-(2-aminoethyl)piperazine, 4-amino-2,2,6,6-tetramethylpiperidine, N,N-dimethylethylenediamine, lysine, L-cystine or isophorondiamine; aromatic diamine compounds, for example, o-phenylenediamine, m-phenylenediamine, p-phenylenediamine, 2,4-tolylenediamine, benzidine, o-ditoluidine, o-dianisidine, 4-nitro-m-phenylenediamine, 2,5-dimethoxy-p-phenylenediamine, bis(4-aminophenyl)sulfone, 4-carboxy-o-phenylenediamine, 3-carboxy-m-phenylenediamine, 4,4'-diaminophenyl ether or 1,8-naphthalenediamine; heterocyclic amine compounds, for example, 2-aminoimidazole, 3-aminotriazole, 5-amino-1H-tetrazole, 4-aminopyrazole, 2-aminobenzimidazole, 2-amino-5-carboxytriazole, 2,4-diamono-6-methyl-S-triazine, 2,6-diaminopyridine, L-hystidine, DL-tryptopban or adenine; and aminoalcohol or aminophenol compounds, for example, ethanolamine, N-methylethanolamine, N-ethylethanolamine, 1-amino-2-propanol, 1-amino-3-propanol, 2-aminaethaxyethanol, 2-aminothioethoxyethanol, 2-amino-2-methyl-1-propanol, p-aminophenol, m-aminophenol, o-aminopbenol, 4-methyl-2-aminophenol, 2-chloro-4-aminophenol, 4-methoxy-3-aminophenol, 4-hydroxybenzylamine, 4-amino-1-naphthol, 4-aminosalicylic acid, 4-hydroxy-N-phenylglycine, 2-aminobenzyl alcohol, 4-aminophenethyl alcohol, 2-carboxy-5-amino-1-naphthol or L-tyrosine are exemplified.

A polyurethane resin obtained by introducing a crosslinkable group into polyurethane having a carboxyl group by a polymer reaction as described in JP-A-2003-270775 may also be used as the binder polymer according to the invention as well as the above-described polyurethane resin obtained by introducing a crosslinkable group into a side chain at the synthesis of polyurethane.

According to the invention, a combination of a monomer having a melting point of 45°C or more with the urethane resin containing a crosslinkable group described above is particularly preferably used. Specific example of the urethane resin is set forth below, but the invention should not be construed as being limited thereto.

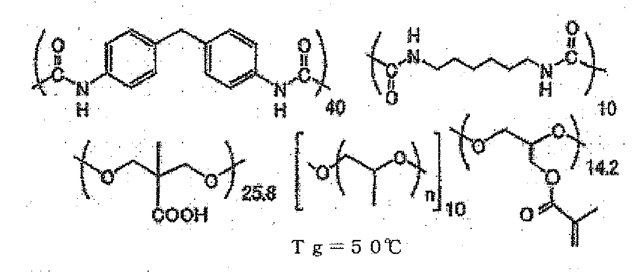

In order to maintain the developing property of the photosensitive layer, it is preferred that the binder polymer used has an appropriate molecular weight. The weight average molecular weight (Mw) thereof is preferably in a range from 5,000 to 300,000, and more preferably in a range from 20,000 to 150,000.

Although the binder polymer can be incorporated into the photosensitive layer in an appropriate amount, when the amount of the binder polymer exceeds 90% by weight of the photosensitive layer, a preferable result may not be obtained in view of image strength formed or the like in some cases. It is preferably from 10 to 90% by weight, and more preferably from 30 to 80% by weight.

Into the photosensitive layer for use in the invention, other components may be incorporated in addition to the essential components described above, if desired. For instance, the photosensitive layer may contain a dye or pigment capable of absorbing light having a wavelength of a laser emission wavelength for use in the image exposure ± 50 nm. However, such a dye or pigment is different from the sensitizing dye and does not have the function for transmitting energy to the photopolymerization initiator.

The above-described dye or pigment is not particularly restricted as long as it is a dye or pigment which is capable of absorbing light having a wavelength range of a laser emission wavelength ± 50 nm. It is preferably a dye or pigment having an absorption maximum in a wavelength range of a laser emission wavelength ± 50 nm, more preferably a dye or pigment having an absorption maximum in a wavelength range of a laser emission wavelength ± 20 nm, and still more preferably a dye or pigment having an absorption maximum at a wavelength same as a laser emission wavelength.

The exposure by a blue or violet region laser emitting light from 350 to 450 nm is particularly desirable according to the invention, and as the dye or pigment corresponding to the laser, a yellow dye or pigment is desired.

Examples of the yellow dye include yellow acid dyes. Specific examples of the yellow dye include acid dyes described in Senryo Binran and a group of C.I. Acid Yellow. Particularly effective dyes include C.I. Acid Yellow 17, C.I. Acid Yellow 19, C.I. Acid Yellow 23, C.I. Acid Yellow 38, C.I. Acid Yellow 42, C.I. Acid Yellow 61, C.I. Acid Yellow 72 and C.I. Acid Yellow 141.

The dyes set forth below are also preferably used.

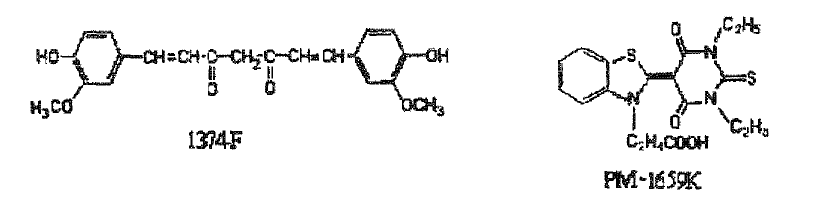

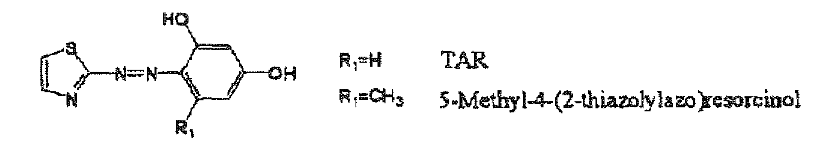

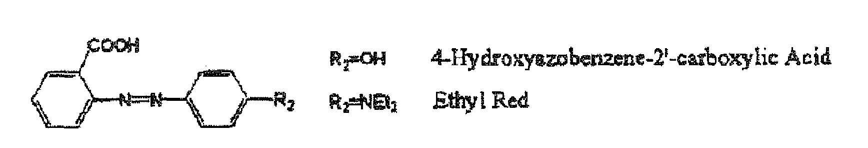

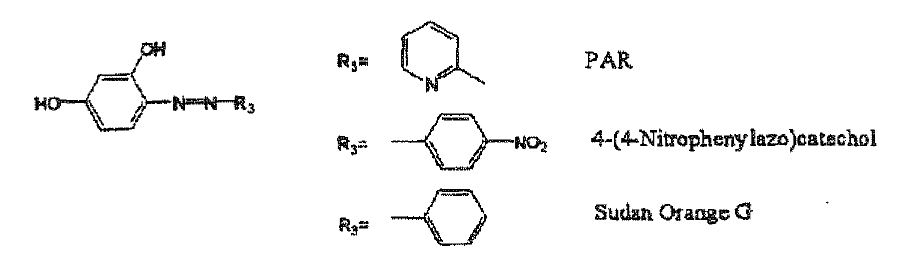

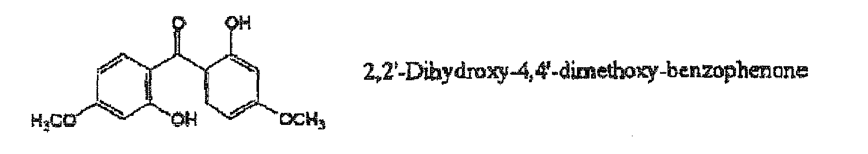

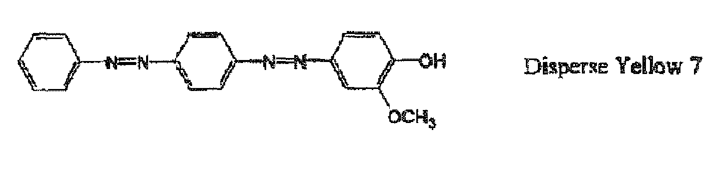

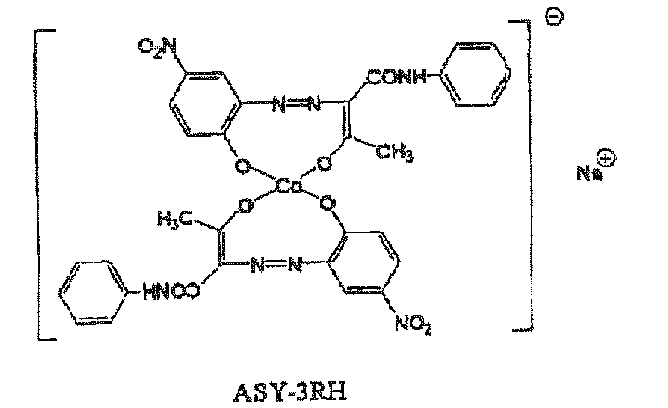

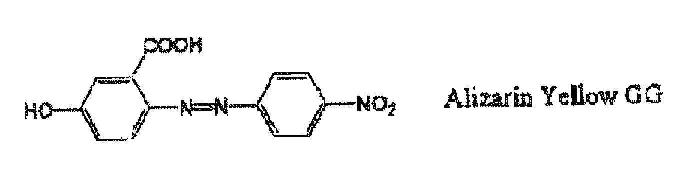

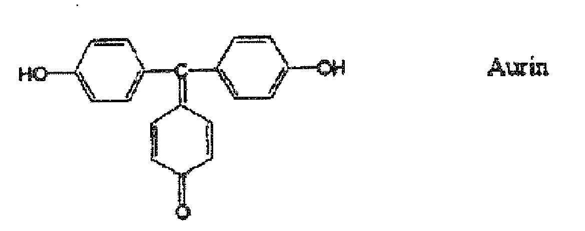

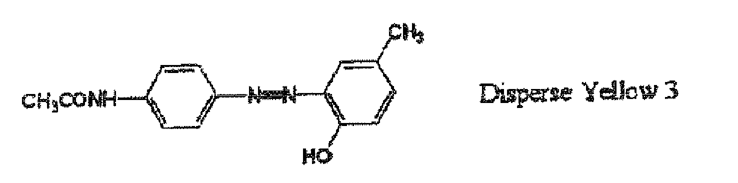

Examples of the yellow pigment include Novoperm Yellow H2G, Seikafast Yellow 2200, Seikafast Yellow 2300, Seikafast Yellow, HOSTACOPY Y501, Yellow master batch, PV Fast Yellow HG, Novoperm Yellow P-HG and Novoperm Yellow M2R.

By using the above-described dye or pigment, the effect for preventing thickening or spreading in the shadow area due to reflected light or scattered light of the laser is achieved and a lithographic printing plate can be provided, which is suitable for high definition AM screen printing or FM screen printing, and particularly, which can provide good printed materials without unevenness of halftone dots in the halftone area even in case of exposure using the FM screen.

The amount of the dye or pigment added to the photosensitive layer is preferably 0.01% by weight or more, more preferably 0.05% by weight or more, based on the weight of the photosensitive layer. Also, from the standpoint of maintaining the amount of light reaching the photosensitive layer and keeping the sensitivity in a preferable range, the amount of the dye or pigment added is preferably 10% by weight or less, more preferably 5% by weight or less.

Further, it is desired to add a small amount of a thermal polymerization inhibitor to the photosensitive layer for use in the invention in order to prevent the addition polymerizable compound having an ethylenically unsaturated double bond from undergoing undesirable thermal polymerization during the production or preservation of the composition (photopolymerization type photosensitive composition) for forming the photosensitive layer. Examples of suitable thermal polymerization inhibitor include hydroquinone, p-methoxyphenol, di-tert-butyl-p-cresol, pyrogallol, tert-butylcatechol, benzoquinone, 4,4'-thiobis(3-methyl-6-tert-butylphenol), 2,2'-methylenebis(4-methyl-6-tert-butylphenol), N-nitrosophenylhydroxyamine cerium(III) salt and N-nitrosophenylhydroxyamine aluminum salt. The amount of the thermal polymerization inhibitor added is preferably from about 0.01 to about 5% by weight based on the total components of the composition. If desired, in order to prevent polymerization inhibition due to oxygen, a higher fatty acid derivative, for example, behenic acid or behenic acid amide may be added and allowed to localize on the surface of the photosensitive layer during a drying step after the coating. The amount of the higher fatty acid derivative added is preferably from about 0.5 to about 10% by weight based on the total components of the photopolymerization type photosensitive composition.

A coloring agent may be added for the purpose of coloring the photosensitive layer. The coloring agent includes a pigment, for example, phthalocyanine-base pigment (C.I. Pigment Blue 15:3, C.I. Pigment Blue 15:4, C.I. Pigment Blue 15:6 or the like), an azo-base pigment, carbon black or titanium oxide, and a dye, for example, Ethyl Violet, Crystal Violet, an azo dye, an anthraquinone-base dye or a cyanine-base dye. The amount of the coloring agent added is preferably from about 0.5 to about 5% by weight based on the total components of the photopolymerization type photosensitive composition.
In order to improve physical properties of the cured layer, an additive, for example, inorganic filler or a plasticizer, e.g., dioctyl phthalate, dimethyl phthalate or tricresyl phosphate may be added. The amount of the additive added is preferably 10% by weight or less based on the total components of the photopolymerization type photosensitive composition.
To the composition for forming the photosensitive layer can be added a surfactant for improving surface quality of the coating. Preferable examples of the surfactant include a fluorine-based nonionic surfactant.

According to the invention, the composition for photosensitive layer is coated on the support described hereinbefore to form a photosensitive layer. In case of coating the composition for photosensitive layer on the support, the photosensitive composition is dissolved in an organic solvent to prepare a coating solution. Examples of the solvent capable of being used include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformarnide, dimethyl sulfoxide, γ-butyrolactone, methyl lactate and ethyl lactate. The solvents may be used individually or as a mixture thereof. The concentration of solid content in the coating solution is appropriately from 1 to 50% by weight.
The coating amount of the photosensitive layer of the lithographic printing plate precursor according to the invention is preferably in a range from about 0.1 to about 10 g/m², more preferably in a range from 0.3 to 5 g/m², still more preferably in a range from 0.5 to 3 g/m², in terms of weight after drying.

### [Protective layer]

On the photosensitive layer described above, an oxygen blocking protective layer (overcoat layer) is preferably provided in order to avoid polymerization inhibiting function of oxygen.
The coating amount of the protective layer is preferably in a range from 0.5 to 3.0 g/m². When the coating amount is less than 0.5 g/m², the sensitivity may decrease in some cases, whereas when it exceeds 3.0 g/m², the burden on processing process may increase in some cases. The coating amount is preferably in a range from 0.7 to 2.5 g/m².

The protective layer preferably contains a water-soluble polymer. The water-soluble polymer specifically includes, for example, polyvinyl alcohol, a partial ester, ether or acetal thereof and a copolymer thereof containing a substantial amount of an unsubstituted vinyl alcohol unit necessary for providing the water-solubility. The polyvinyl alcohol preferably has a hydrolysis degree from 71 to 100% and a polymerization degree from 300 to 2,400. Specifically, PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8, produced by Kuraray Co., Ltd. are exemplified. Further, polyvinyl acetate chloroacetate or propionate, polyvinyl formal and polyvinyl acetal each hydrolyzed to an extent from 88 to less than 100% are exemplified. Other useful water-soluble polymers include polyvinyl pyrrolidone, gelatin, gum arabic and the like. The water-soluble polymers may be used individually or in combination.
In order to obtain the particularly preferable results according to the invention, it is desired to use polyvinyl alcohol having a hydrolysis degree of 95% or more.

In the protective layer, a modified polyvinyl alcohol may also be used. In particular, an acid-modified polyvinyl alcohol is preferably used.

### (Acid-modified polyvinyl alcohol)

The acid-modified polyvinyl alcohol is not particularly restricted as long as it is a vinyl alcohol polymer containing an appropriate amount of an acid group. Particularly, a vinyl alcohol polymer including appropriate amount of a sulfonic acid group or a carboxyl group is preferably used. The former is referred to as a sulfonic acid-modified polyvinyl alcohol and the latter is referred to as a carboxylic acid-modified polyvinyl alcohol.
The acid-modified polyvinyl alcohol is preferably synthesized by a method wherein a monomer having an acid group is copolymerized with vinyl acetate and then the vinyl acetate is partially or wholly saponified to change to vinyl alcohol. However, it is also possible to synthesize by connecting a compound having an acid group to a hydroxy group of polyvinyl alcohol.

Examples of the monomer having a sulfonic acid group include ethylenesulfonic acid, allylsulfonic acid, methallylsulfonic acid, 2-acrylamido-2-methylpropanesulfonic acid and salts thereof Examples of the compound having a sulfonic acid group include an aldehyde derivative having a sulfonic acid group, for example, p-sulfonic acid benzaldehyde and salt thereof. The compound can be introduced by a conventionally known acetalization reaction.

Examples of the monomer having a carboxyl group include fumaric acid, maleic acid, itaconic acid, maleic anhydride, phthalic anhydride, trimellitic anhydride, acrylic acid and salts thereof, an acrylic acid ester, for example, methyl acrylate, and a methacrylic acid ester, for example, methyl methacrylate. Examples of the compound having a carboxyl group include a monomer, for example, acrylic acid and the compound can be introduced according to a conventionally know Michael addition reaction.
The acid-modified polyvinyl alcohol may be a compound appropriately synthesized or a commercially available compound.
The acid-modified polyvinyl alcohol can avoid degradation of the removability of photosensitive layer by development. Particularly, the acid-modified polyvinyl alcohol having a saponification degree of 9 1 % by mole or more is preferred.
Specific examples of the acid-modified polyvinyl alcohol having such a high saponification degree include as the carboxy-modified polyvinyl alcohol, for example, KL-118 (saponification degree: 97% by mole, average polymerization degree: 1,800), KM-618 (saponification degree: 94% by mole, average polymerization degree: 1,800), KM-118 (saponification degree: 97% by mole, average polymerization degree: 1,800) and KM-106 (saponification degree: 98.5% by mole, average polymerization degree: 600) produced by Kuraray Co., Ltd., Gosenal T-330H (saponification degree: 99% by mole, average polymerization degree: 1,700), Gosenal T-330 (saponification degree: 96.5% by mole, average polymerization degree: 1,700), Gosenal T-350 (saponification degree: 94% by mole, average polymerization degree: 1,700), Gosenal T-230 (saponification degree: 96.5% by mole, average polymerisation degree: 1,500), Gosenal T-215 (saponification degree: 96.5% by mole, average polymerization degree: 1,300) and Gosenal T-HS-1 (saponification degree: 99% by mole, average polymerization degree: 1,300) produced by Nippon Synthetic Chemical Industry Co., Ltd., and AF-17 (saponification degree: 96.5% by mole, average polymerization degree: 1,700) and AT-17 (saponification degree: 93.5% by mole, average polymerization degree: 1,700) produced by Japan VAM & Poval Co., Ltd.
Also, as the sulfonic acid-modified polyvinyl alcohol, for example, SK-5102 (saponification degree: 98% by mole, average polymerization degree: 200) produced by Kuraray Co., Ltd. and Goseran CKS-50 (saponification degree: 99% by mole, average polymerization degree: 300) produced by Nippon Synthetic Chemical Industry Co., Ltd. are exemplified.

Further, in view of preventing more effectively the degradation of the removability of photosensitive layer by development, it is particularly preferred to use the acid-modified polyvinyl alcohol having an average polymerization degree of vinyl alcohol unit of 100 to 800. By using the acid-modified polyvinyl alcohol having such a low polymerization degree and a high saponification degree, a protective layer which is effectively preventing the degradation of the removability of photosensitive layer by development while maintaining the excellent characteristic of oxygen-blocking property can be obtained.

As the acid-modified polyvinyl alcohol having a low polymerization degree and a high saponification degree as described above, a carboxy-modified polyvinyl alcohol modified with itaconic acid or maleic acid or sulfonic acid-modified polyvinyl alcohol having a saponification degree of 91% by mole or more and an average polymerization degree of vinyl alcohol unit from 100 to 800 is preferred.
The modification degree of the acid-modified polyvinyl alcohol means a molar ratio of unit having an acid group contained in a copolymer of the acid-modified polyvinyl alcohol. The modification degree of the acid-modified polyvinyl alcohol is preferably from 0.1 to 20% by mole, and more preferably from 0.2 to 5% by mole.

As a solvent used for preparing a coating solution for protective layer, although pure water is preferred, a mixture of pure water with an alcohol, for example, methanol or ethanol or a ketone, for example, acetone or methyl ethyl ketone may also be used. The concentration of the solid content in the coating solution is appropriately from 1 to 20% by weight. To the protective layer may be added known additives, for example, a surfactant for improving coating property or a water-soluble plasticizer for improving physical property of the coated layer. The water-soluble plasticizer includes, for example, propionamide, cyclohexanediol, glycerin, sorbitol and the like. Also, a water-soluble (meth)acrylic polymer may be added. The coating amount of the protective layer is preferably in a range from about 0.1 to about 15 g/m², more preferably in a range from 1.0 to about 5.0 g/m², in terms of weight after drying.

### [Method of preparing lithographic printing plate]

Now, a method of preparing a lithographic printing plate using the lithographic printing plate precursor according to the invention is described in detail below. The method of preparing a lithographic printing plate according to the invention substantially comprises a step (exposure step) of imagewise exposing the lithographic printing plate precursor and a step (development step) of processing the exposed lithographic printing plate precursor with an aqueous solution containing a carbonate ion, a hydrogen carbonate ion and a surfactant. The term "substantially comprises" as used herein means that the image is formed by the exposure step and development step described above and a drying step (including natural drying) conducted after the development step should not be construed as being excluded. Specifically, in the method of preparing a lithographic printing plate according to the invention, a treatment with a gum solution (a gum treatment step) is not conducted after the development step. A step of exposing to light and/or heating the entire surface of lithographic printing plate precursor may be provided between the exposure step and the development step and/or after the development step, if desired.

The image exposure of the lithographic printing plate precursor is performed by a method of exposing through a transparent original having a line image, a halftone dot image or the like or a method of scanning of laser beam based on digital data. The desirable wavelength of the light source is from 350 to 450 nm.

As for the available laser light source emitting light from 350 to 450 nm, the followings can be utilized. As a gas laser, Ar ion laser (364 nm, 351 nm, 10 mW to 1 W), Kr ion laser (356 nm, 351 nm, 10 mW to 1 W) and He-Cd laser (441 nm, 325 nm, 1 mW to 100 mW); as a solid laser, a combination of Nd:YAG (YVO₄) with SHG crystals×twice (355 nm, 5 mW to 1 W) and a combination of Cr:LiSAF with SHG crystal (430 nm, 10 mW); as a semiconductor laser system, a KNbO₃ ring resonator (430 nm, 30 mW), a combination of a waveguide-type wavelength conversion element with an AlGaAs or InGaAs semiconductor (380 nm to 450 nm, 5 mW to 100 mW), a combination of a waveguide-type wavelength conversion element with an AlGaInP or AlGaAs semiconductor (300 nm to 350 nm, 5 mW to 100 mW) and AlGaInN (350 nm to 450 nm, 5 mW to 30 mW); and as a pulse laser, N₂ laser (337 nm, pulse 0.1 to 10 mJ) and XeF (351 nm, pulse 10 to 250 mJ). Among them, an AlGaInN semiconductor laser (commercially available InGaN semiconductor laser, 400 to 410 nm, 5 to 30 mW) is preferred in view of the wavelength characteristics and cost.

As for the exposure device for the lithographic printing plate precursor of scanning exposure system, the exposure mechanism may be any of an internal drum system, an external drum system and a flat bed system. As the light source, among the light sources described above, those capable of conducting continuous oscillation can be preferably utilized.

Further, as other examples of the exposure light source usable in the invention, an ultra-high pressure, high pressure, medium pressure or low pressure mercury lamp, a chemical lamp, a carbon arc lamp, a xenon lamp, a metal halide lamp, various visible or ultraviolet laser lamps, a fluorescent lamp, a tungsten lamp, sunlight and the like are exemplified.

Now, the development step is described in detail. A conventional processing process comprises removing a protective layer in a pre-water washing step, conducting alkali development, removing the alkali in a post-water washing step, conducting gum treatment in a gumming step and drying in a drying step. On the contrary, according to the invention, it is characterized to conduct the pre-water washing, development and gumming at the same time by using an aqueous solution containing a carbonate ion, a hydrogen carbonate ion and a surfactant. Thus, the pre-water washing step is not particularly necessary, and after conducting the pre-water washing, development and gumming only using one solution, further with one bath, the drying step can be performed. After the development, the excess processing solution is preferably removed using a squeeze roller or the like, followed by conducting drying.

The development step is preferably performed by an automatic processor equipped with a rubbing member. As the automatic processor, for example, an automatic processor in which a lithographic printing plate precursor after image exposure is subjected to a rubbing treatment while it is transported described in JP-A-2-220061 and JP-A-60-59351, and an automatic processor in which a lithographic printing plate precursor after image exposure placed on a cylinder is subjected to a rubbing treatment while rotating the cylinder described in U.S. Patients 5,148,746 and 5,568,768 and British Patent 2,297,719 are exemplified. Among them, the automatic processor using a rotating brush roller as the rubbing member is particularly preferred.

The rotating brush roller which can be used in the invention can be appropriately selected by taking account of scratch resistance of the image area, and further, nerve strength of the support of the lithographic printing plate precursor and the like. As for the rotating brush roller, a known rotating brush roller produced by implanting a brush material in a plastic or metal roller can be used. For example, a rotating brush roller described in JP-A-58-159533 and JP-A-3-100554, or a brush roller in which a metal or plastic groove-type member having implanted therein in rows a brush material is closely radially wound around a plastic or metal roller acting as a core as described in JP-U-B-62-167253 can be used.
As the brush material, a plastic fiber (for example, a polyester-based, e.g., polyethylene terephthalate or polybutylene terephthalate, a polyamide-based, e.g., nylon 6.6 or nylon 6.10, a polyacrylic based, e.g., polyacrylonitrile or polyalkyl (meth)acrylate, and a polyolefin-based, e.g., polypropylene or polystyrene) can be used. For instance, a brush material having a fiber bristle diameter from 20 to 400 µm and a bristle length from 5 to 30 mm can be preferably used.
The outer diameter of the rotating brush roller is preferably from 30 to 200 mm, and the peripheral velocity at the tip of the brush rubbing the plate surface is preferably from 0.1 to 5 m/sec. It is preferred to use a plurality of the rotating brush rollers.

The rotary direction of the rotating brush roller may be the same direction or the opposite direction with respect to the transporting direction of the lithographic printing plate precursor, but when two or more rotating brush rollers are used, it is preferred that at least one rotating brush roller rotates in the same direction and at least one rotating brush roller rotates in the opposite direction with respect to the transporting direction. By such arrangement, the non-image area of the photosensitive layer is more certainly removed. Further, it is also effective to rock the rotating brush roller in the rotation axis direction of the brush roller.

After the development step, a drying step is preferably provided continuously or discontinuously. The drying is conducted using hot air, an infrared ray, a far-infrared ray or the like.

An example of the configuration of automatic processor preferably used in the method of preparing a lithographic printing plate according to the invention is schematically shown in Fig. 1. The automatic processor shown in Fig. 1 comprises basically a developing unit 6 and a drying unit 10. A lithographic printing plate precursor 4 is subjected to the development and gumming in a developing tank 20 and dried in the drying unit 10.

A processing solution (hereinafter, also referred to as a developer) for use in the development step is an aqueous solution containing a carbonate ion, a hydrogen carbonate ion and a surfactant. Due to the presence of a carbonate ion and a hydrogen carbonate ion, a buffer function is expressed and fluctuation of the pH can be prevented even when the developer is used for a long period of time. Thus, the deterioration of developing property resulting from the fluctuation of pH, the occurrence of development scum and the like are restrained. In order for a carbonate ion and a hydrogen carbonate ion to be present in a developer, a carbonate and a hydrogen carbonate may be added to the developer or a carbonate ion and a hydrogen carbonate ion may be generated by adding a carbonate or a hydrogen carbonate to a developer and then adjusting the pH. The carbonate or hydrogen carbonate used is not particularly restricted and it is preferably an alkali metal salt thereof. As the alkali metal, lithium, sodium and potassium are exemplified and sodium is particularly preferred. The alkali metals may be used individually or in combination of two or more thereof.
The pH of the developer is not particularly restricted as long as it is pH at which the buffer function is expressed and is preferably in a range from 8.5 to 10.8. When the pH is lower than 8.5, the developing property of the non-image area is degraded. When the pH is higher 10.8, the processing ability is degraded due to the influence of carbon dioxide in the atmosphere.

The total amount of the carbonate ion and hydrogen carbonate is preferably from 0.3 to 20% by weight, more preferably from 0.5 to 10% by weight, particularly preferably from 1 to 5% by weight, based on the weight of the aqueous alkali solution. When the total amount is 0.3% by weight or more, the developing property and processing ability are not degraded. When the total amount is 20% by weight or less, precipitates and crystals hardly generate and since gelation at neutralization of waste liquid of the developer hardly occur, treatment of the waste liquid can be carried out without trouble.

Further, for the purpose of finely adjusting the alkali concentration or aiding dissolution of the photosensitive layer in the non-image area, other alkali agent, for example, an organic alkali agent may be supplementarily used together. The organic alkali agent includes monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, tetramethylammonium hydroxide and the like. The supplementary alkali agents may be used individually or in combination of two or more thereof.

The surfactant for use in the processing solution according to the invention is any of anionic, nonionic, cationic and amphoteric surfactants. The surfactant contributes to improvement in the processing property.
The anionic surfactant includes fatty acid salts, abietic acid salts, hydroxyalkanesulfonic acid salts, alkanesulfonic acid salts, dialkylsulfosuccinic acid salts, straight-chain alkylbenzenesulfonic acid salts, branched alkylbenzenesulfonic acid salts, alkylnaphthalenesulfonic acid salts, alkylphenoxy polyoxyethylene propylsulfonic acid salts, polyoxyethylene alkylsulfophenyl ether salts, N-methyl-N-oleyltaurine sodium salt, N-alkylsulfosuccinic acid monoamide disodium salts, petroleum sulfonic acid salts, sulfated castor oil, sulfated beef tallow oil, sulfate ester slats of fatty acid alkyl ester, alkyl sulfate ester salts, polyoxyethylene alkyl ether sulfate ester salts, fatty acid monoglyceride sulfate ester salts, polyoxyethylene alkyl phenyl ether sulfate ester salts, polyoxyethylene styryl phenyl ether sulfate ester salts, alkyl phosphate ester salts, polyoxyethylene alkyl ether phosphate ester salts, polyoxyethylene alkyl phenol ether phosphate ester salts, partially saponified products of styrene-maleic anhydride copolymer, partially saponified products of olefin-maleic anhydride copolymer, naphthalene sulfonate formalin condensates, aromatic sulfonic acid salts, aromatic substituted polyoxyethylenesulfonic acid salts and the like. Of the compounds, dialkylsulfosuccinic acid salts, alkyl sulfate ester salts and alkylnaphthalenesulfonic acid salts are particularly preferably used.

The cationic surfactant is not particularly limited and conventionally known cationic surfactants can be used. For example, alkylamine salts, quaternary ammonium salts, polyoxyethylene alkyl amine salts and polyethylene polyamine derivatives are exemplified.

The nonionic surfactant include polyethylene glycol type higher alcohol ethylene oxide addacts, alkylphenol ethylene oxide addacts, polyethylene glycol addacts of aromatic compounds, fatty acid ethylene oxide addacts, polyhydric alcohol fatty acid ester ethylene oxide addacts, higher alkylamine ethylene oxide addacts, fatty acid amide ethylene oxide addacts, ethylene oxide addacts of fat, polypropylene glycol ethylene oxide addacts, dimethylsiloxane-ethylene oxide block copolymers, dimethylsiloxane-(propylene oxide-ethylene oxide) block copolymers, fatty acid esters of polyhydric alcohol type glycerol, fatty acid esters of pentaerythritol, fatty acid esters of sorbitol and sorbitan, fatty acid esters of sucrose, alkyl ethers of polyhydric alcohols, fatty acid amides of alkanolamines and the like.

In the invention, ethylene oxide addacts of sorbitol and/or sorbitan fatty acid esters, polypropylene glycol ethylene oxide addacts, dimethylsiloxane-ethylene oxide block copolymers, dimethylsiloxane-(propylene oxide-ethylene oxide) block copolymers and fatty acid esters of polyhydric alcohols are more preferred.

Further, from the standpoint of stable solubility in water or opacity, with respect to the nonionic surfactant, the HLB (hydrophile-lipophile balance) value thereof is preferably 6 or more, and more preferably 8 or more. Moreover, an oxyethylene adduct of acetylene glycol type or acetylene alcohol type or a surfactant of fluorine-based, silicon-based or the like can also be used.

The amphoteric surfactant for use in the developer according to the invention is a compound having an anionic site and a cationic site in its molecule as well known in the field of surfactant and includes amphoteric surfactants of amino acid type, betain type, amine oxide type and the like. As the amphoteric surfactant used in the developer according to the invention, a compound represented by formula <1> shown below and a compound represented by formula <2> shown below are preferred.

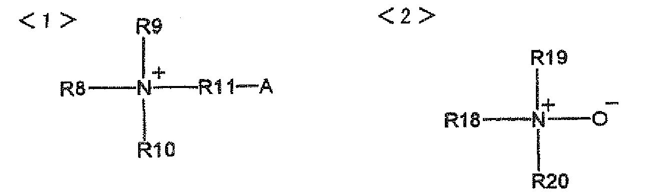

In formula <1>, R8 represents an alkyl group, R9 and R10 each represents a hydrogen atom or an alkyl group, R11 represents an alkylene group, and A represents a carboxylate ion or a sulfonate ion.
In formula <2>, R18, R19 and R20 each represents a hydrogen atom or an alkyl group, provided that all of R18, R19 and R20 are not hydrogen atoms at the same time.

In formula <1>, the alkyl group represented by R8, R9 or R10 or the alkylene group represented by R11 may be a straight chain or branched structure, may also contain a connecting group in the chain thereof and may further have a substituent. As the connecting group, a connecting group containing a hetero atom, for example, an ester bond, an amido bond or an ether bond is preferred. Further, as the substituent, a hydroxy group, an ethylene oxide group, a phenyl group, an amido group, a halogen atom or the like is preferred. Alternatively, R8, R9 and R10 may be connected with each other in the sate of a ring. As the state of a ring, a state of forming a 5-membered or 6-membered ring is preferred, and a state where the ring is a heterocyclic ring containing a hetero atom is particularly preferred. The hetero atom is preferably an oxygen atom, a nitrogen atom or a sulfur atom is preferred. In particular, a cationic structure of a substituted imidazole ring, a substituted imidazoline ring, a substituted imidazolidine or the like is preferred. In the compound represented by formula <1>, as the total number of carbon atoms increases, the hydrophobic portion becomes large and dissolution of the compound in an aqueous developer becomes difficult. In such a case, the dissolution is improved by adding a dissolution auxiliary agent, for example, an organic solvent, e.g., an alcohol. However, when the total number of carbon atoms excessively increases, the surfactant can not be dissolved in the proper amount in some cases. Therefore, the total number of carbon atoms included in R8 to R11 is preferably from 8 to 25, and more preferably from 11 to 21.

In formula <2>, the alkyl group represented by R18, R19 or R20 may be a straight chain or branched structure, may also contain a connecting group in the chain thereof and may further have a substituent. As the connecting group, a connecting group containing a hetero atom, for example, an ester bond, an amido bond or an ether bond is preferred. Further as the substituent, a hydroxy group, an ethylene oxide group, a phenyl group, an amido group, a halogen atom or the like is preferred.
In the compound represented by formula <2>, as the total number of carbon atoms increases, the hydrophobic portion becomes large and dissolution of the compound in an aqueous developer becomes difficult. In such a case, the dissolution is improved by adding a dissolution auxiliary agent, for example, an organic solvent, e.g., an alcohol. However, when the total number of carbon atoms excessively increases, the surfactant can not be dissolved in the proper amount in some cases. Therefore, the total number of carbon atoms included in R18 to R20 is preferably from 8 to 22, and more preferably from 10 to 20.

The total number of carbon atoms in the amphoteric surfactant may be influenced depending on property of the materials used in the photosensitive layer, especially, a binder polymer. When the binder polymer having high hydrophilicity is used, it tends to be preferred that the total number of carbon atoms is relatively small. When the binder having low hydrophilicity is used, it tends to be preferred that the total number of carbon atoms is relatively large.

Preferable specific examples of the amphoteric surfactant for use in the developer are set forth below, but the invention should not be construed as being limited thereto.

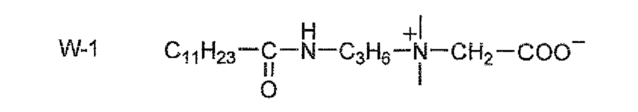

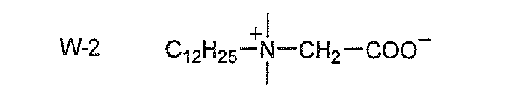

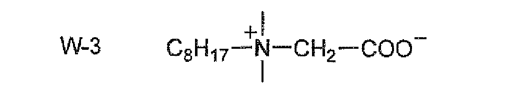

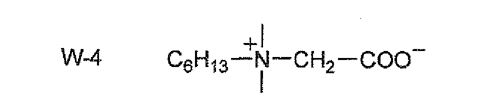

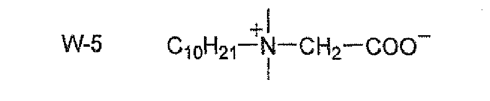

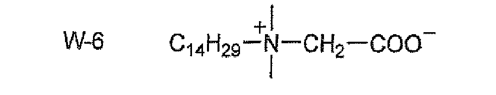

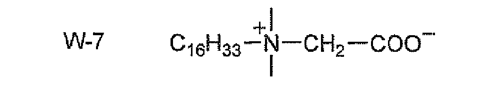

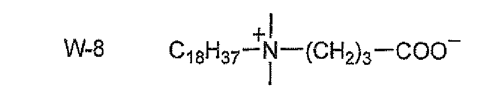

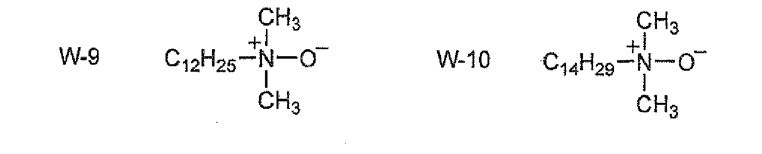

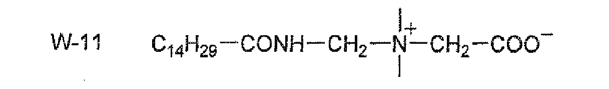

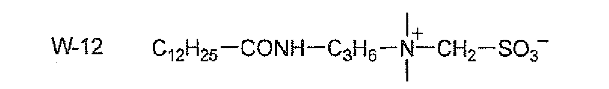

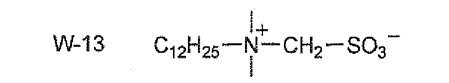

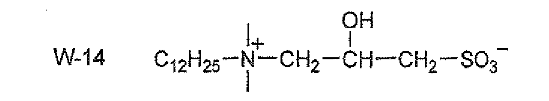

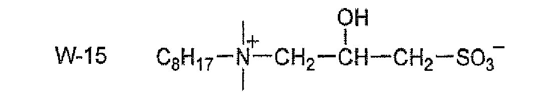

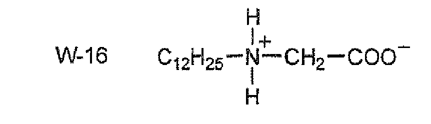

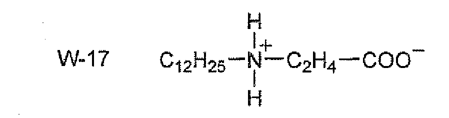

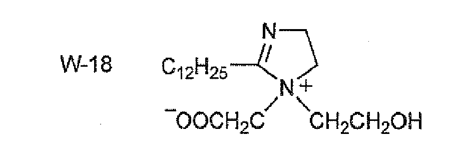

As the surfactant for use in the processing solution according to the invention, an anionic surfactant is preferred and an anionic surfactant containing a sulfonic acid or a sulfonic acid salt is particularly preferred.
The surfactants may be used individually or in combination. The content of the surfactant in the developer is preferably from 0.01 to 10% by weight, and more preferably from 0.01 to 5% by weight.

The processing solution in the invention may contain a wetting agent, an antiseptic agent, a chelating agent, a defoaming agent, an organic acid, an organic solvent, an inorganic acid, an inorganic salt or the like in addition the components described above. However, a water-soluble polymer compound is preferably not added, because in case of adding the water-soluble polymer compound, in particular, when the processing solution fatigues, the tackiness of plate surface tends to occur.

As the wetting agent, ethylene glycol, propylene glycol, triethylene glycol, butylene glycol, hexylene glycol, diethylene glycol, dipropylene glycol, glycerin, trimethylol propane, diglycerin or the like is preferably used. The wetting agents may be used individually or in combination of two or more thereof. The wetting agent is ordinarily used in an amount from 0.1 to 5% by weight based on the total weight of the processing solution.

As the antiseptic agent, phenol or a derivative thereof, formalin, an imidazole derivative, sodium dehydroacetate, a 4-isothiazolin-3-one derivative, benzisotiazolin-3-one, 2-methyl-4-isothiazolin-3-one, a benzotriazole derivative, an amidine guanidine derivative, a quaternary ammonium salt, a derivative of pyridine, quinoline, guanidine or the like, diazine, a triazole derivative, oxazole, an oxazine derivative, a nitrobromoalcohol-based compound, e.g., 2-brorno-2-nitropropane-1,3-diol, 1,1-dibromo-1-nitro-2-ethanol, 1,1-dibromo-1-nitro-2-propanol or the like is preferably used. It is preferred to use two or more kinds of the antiseptic agents so as to exert the effect to various molds and bacteria. The amount of the antiseptic agent added is an amount stably exerts the effect to bacterium, molds, yeast or the like. Although the amount of the antiseptic agent added may be varied depending on the kind of the bacterium, molds, yeast or the like, it is preferably in a range from 0.01 to 4% by weight based on the processing solution.

As the chelating agent, for example, ethylenediaminetetraacetic acid, potassium salt thereof, sodium salt thereof; diethylenetriaminepentaacetic acid, potassium salt thereof, sodium salt thereof; triethylenetetraminehexaacetic acid, potassium salt thereof, sodium salt thereof; hydroxyethylethylenediaminetriacetic acid, potassium salt thereof, sodium salt thereof; nitrilotriacetic acid, sodium salt thereof; an organic phosphonic acid, for example, 1-hydroxyethane-1,1-diphosphonic acid, potassium salt thereof, sodium salt thereof, aminotri(methylenephosphonic acid), potassium salt thereof, sodium salt thereof or a phosphonoalkanetricarboxylic acid is exemplified. A salt of an organic amine is also effectively used in place of the sodium salt or potassium salt in the chelating agent. The chelating agent is so selected that it is stably present in the processing solution and does not impair the printing property. The content of the chelating agent is preferably from 0.001 to 1.0% by weight based on the processing solution.

As the defoaming agent, a conventional silicone-based self-emulsifying type or emulsifying type defoaming agent, a nonionic compound having HLB of 5 or less or the like is used. The silicone defoaming agent is preferably used. Any of emulsifying dispersing type, solubilizing type and the like can be used. The content of the defoaming agent is preferably from 0.001 to 1.0% by weight based on the processing solution.

As the organic acid, citric acid, acetic acid, oxalic acid, malonic acid, salicylic acid, caprylic acid, tartaric acid, malic acid, lactic acid, levulinic acid, p-toluenesulfonic acid, xylenesulfonic acid, phytic acid, an organic phosphoric acid or the like is exemplified. The organic acid can also be used in the form of an alkali metal salt or an ammonium salt. The content of the organic acid is preferably from 0.01 to 0.5% by weight based on the processing solution.

As the organic solvent, for example, an aliphatic hydrocarbon (e.g., hexane, heptane, ISOPAR E, ISOPAR H, ISOPAR G (produced by ESSO Chemical Co., Ltd.), gasoline or kerosene), an aromatic hydrocarbon (e.g., toluene or xylene), a halogenated hydrocarbon (e.g., methylene dichloride, ethylene dichloride, trichlene or monochlorobenzene) or a polar solvent is exemplified.

As the polar solvent, an alcohol (e.g., methanol, ethanol, propanol, isopropanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, methyl phenyl carbinol, n-amyl alcohol or methylamyl alcohol), a ketone (e.g., acetone, methyl ethyl ketone, ethyl butyl ketone, methyl isobutyl ketone or cyclohexanone), an ester (e.g., ethyl acetate, propyl acetate, butyl acetate, amyl acetate, benzyl acetate, methyl lactate, butyl lactate, ethylene glycol monobutyl acetate, polyethylene glycol monomethyl ether acetate, diethylene glycol acetate, diethyl phthalate or butyl levulinate), others (e.g., triethyl phosphate, tricresyl phosphate, N-phenylethanolamine or N-phenyldiethanolamine) or the like is exemplified.

Further, when the organic solvent is insoluble in water, it may be employed by being solubilized in water using a surfactant or the like. In the case where the developer contains the organic solvent, the concentration of the organic solvent is desirably less than 40% by weight in view of safety and inflammability.

As the inorganic acid or inorganic salt, phosphoric acid, methaphosphoric acid, ammonium primary phosphate, ammonium secondary phosphate, sodium primary phosphate, sodium secondary phosphate, potassium primary phosphate, potassium secondary phosphate, sodium tripolyphosphate, potassium pyrophosphate, sodium hexamethaphosphate, magnesium nitrate, sodium nitrate, potassium nitrate, ammonium nitrate, sodium sulfate, potassium sulfate, ammonium sulfate, sodium sulfite, ammonium sulfite, sodium hydrogen sulfate, nickel sulfate or the like is exemplified. The content of the inorganic salt is preferably from 0.01 to 0.5% by weight based on the total weight of the processing solution.

The temperature of the development is ordinarily 60°C or lower, and preferably from about 15 to about 40°C. In the case of conducting the development processing using an automatic developing machine, the developer becomes fatigued in accordance with the processing amount, and hence the processing ability may be restored using a replenisher or a fresh developer.

In the method of preparing a lithographic printing plate according to the invention, the entire surface of the lithographic printing plate precursor may be heated between the exposure and the development, if desired. By the heating, the image-forming reaction in the image-recording layer is accelerated and advantages, for example, improvements in the sensitivity and printing durability and stabilization of the sensitivity may be achieved.

The conditions of the heating can be appropriately determined in a range for achieving such effects. As the heating means, a conventional convection oven, an IR irradiation apparatus, an IR laser, a microwave apparatus, a Wisconsin oven or the like is exemplified. For instance, the heat treatment can be conducted by maintaining the lithographic printing plate precursor at a plate surface temperature ranging from 70 to 150°C for a period from one second to 5 minutes, preferably at 80 to 140°C for 5 to one minute, more preferably at 90 to 130°C for 10 to 30 seconds. The above-described range is preferred because the effects described above are efficiently achieved and an adverse affect, for example, change in shape of the lithographic printing plate precursor due to the heat can be preferably avoided.
It is preferred that a heat treatment means used in the heat treatment step is connected with a plate setter used in the exposure step and a development apparatus used in the development processing step and the lithographic printing plate precursor is subjected to automatically continuous processing. Specifically, a plate making line wherein the plate setter and the development apparatus are connected with each other by transport means, for example, a conveyer is exemplified. Also, the heat treatment means may be placed between the plate setter and the development apparatus or the heat treatment means and the development apparatus may constitute a unit apparatus.

In case where the lithographic printing plate precursor used is apt to be influenced by surrounding light under a working environment, it is preferred that the plate making line is blinded by a filter, a cover or the like.
The entire surface of lithographic printing plate after development may be exposed to active ray, for example, ultraviolet light to accelerate curing of the image area. As a light source for the entire surface exposure, for example, a carbon arc lamp, a mercury lamp, a gallium lamp, a metal halide lamp, a xenon lamp, a tungsten lamp or various laser beams is exemplified. In order to obtain sufficient printing durability, the amount of the entire surface exposure is preferably 10 mJ/cm² or more, and more preferably 100 mJ/cm² or more.
Heating may be performed at the same time with the entire surface exposure. By performing the heating, further improvement in the printing durability is recognized. Examples of the heating means include a conventional convection oven, an IR irradiation apparatus, an IR laser, a microwave apparatus or a Wisconsin oven. The plate surface temperature at the heating is preferably from 30 to 150°C, more preferably from 35 to 130°C, and still more preferably from 40 to 120°C. Specifically, a method described in JP-A-2000-89478 can be utilized.
Further, for the purpose of increasing printing durability, the lithographic printing plate after development can be heated under very strong conditions. The heat temperature is ordinarily in a range from 200 to 500°C. When the temperature is too low, a sufficient effect of strengthening the image may not be obtained, whereas when it is excessively high, problems of deterioration of the support and thermal decomposition of the image area may occur sometimes.
The lithographic printing plate thus-obtained is mounted on an off-set printing machine to use for printing a large number of sheets.

### EXAMPLES

The invention will be described in more detail with reference to the following examples, but the invention should not be construed as being limited thereto.

### <Examples 1 to 27 and Comparative Examples 1 to 3>

### [Preparation of support]

An aluminum plate (JIS A1050) having a thickness of 0.03 mm was subjected to surface treatment shown below.

### (a) Mechanical surface roughening treatment

Mechanical surface roughening treatment of an aluminum plate was conducted by means of rotating roller-form nylon brush while supplying a suspension having specific gravity of 1.12 of an abrasive (pumice) in water as an abrasion slurry liquid to a surface of the aluminum plate. The average particle size of the abrasive was 30 µm and the maximum particle size was 100 µm. The material of the nylon brush was 6·10 nylon and the brush has a bristle length of 45 mm and a bristle diameter of 0.3 mm. The nylon brush was made by making holes in a stainless steel cylinder having a diameter of 300 mm and densely filling the brush bristles. Three of the rotating nylon brushes were used. Two supporting rollers (each having a diameter of 200 mm) were provided under the brush rollers at 300 mm intervals. The brush rollers were pressed against the aluminum plate till the load applied to a driving motor for rotating the brush became 7 kW greater than the load before pressing the brush rollers against the aluminum plate. The rotating direction of the brushes was the same as the moving direction of the aluminum plate. The rotation number of the brushes was 200 rpm.

### (b) Alkali etching treatment

Alkali etching treatment of the aluminum plate was conducted by spraying an aqueous solution having a sodium hydroxide concentration of 26% by weight, aluminum ion concentration of 6.5% by weight and temperature of 70°C to dissolve the aluminum plate in an amount of 10 g/m². Subsequently, the plate was washed with water by spraying.

### (c) Desmut treatment

Desmut treatment of the aluminum plate was conducted by spraying an aqueous solution having a nitric acid concentration of 1% by weight (containing 0.5% by weight of aluminum ion) and temperature of 30°C, followed by washing with water by spraying.

### (d) Electrochemical surface roughening treatment

Electrochemical surface roughening treatment of the aluminum plate was continuously conducted by applying 60 Hz alternating current voltage. The electrolytic solution used was an aqueous solution containing 10.5 g/liter of nitric acid (containing 5 g/liter of aluminum ion and 0.007% by weight of ammonium ion) and the solution temperature was 50°C. The electrochemical surface roughening treatment was conducted using a trapezoidal rectangular wave alternating current where time (TP) for reaching the current to its peak from zero was 0.8 msec and a duty ratio was 1: 1, and using a carbon electrode as a counter electrode. A ferrite was used as an auxiliary anode. The electrolytic cell used was a radial cell type. The current density was 30 A/dm² at the peak current, and the electric quantity was 220 C/dm² in terms of the total electric quantity during the aluminum plate functioning as an anode. To the auxiliary anode, 5% of the current from the electric source was divided. Subsequently, the plate was washed with water by spraying.

### (e) Alkali etching treatment

Alkali etching treatment of the aluminum plate was conducted at 32°C by spraying an aqueous solution having a sodium hydroxide concentration of 26% by weight and an aluminum ion concentration of 6.5% by weight to dissolve the aluminum plate in an amount of 0.50 g/m². Thus, the smut component mainly comprising aluminum hydroxide formed in the precedent step of electrochemical surface roughening treatment using alternating current was removed and an edge portion of the pit formed was dissolved to smoothen the edge portion. Subsequently, the plate was washed with water by spraying.

### (f) Desmut treatment

Desmut treatment of the aluminium plate was conducted by spraying an aqueous solution having a sulfuric acid concentration of 15% by weight (containing 4.5% by weight of aluminum ion) and temperature of 30°C. followed by washing with water by spraying.

### (g) Electrochemical surface roughening treatment

Electrochemical surface roughening treatment of the aluminum plate was continuously conducted by applying 60 Hz alternating current voltage. The electrolytic solution used was an aqueous solution containing 5.0 g/liter of hydrochloric acid (containing 5 g/liter of aluminum ion) and the solution temperature was 35°C. The electrochemical surface roughening treatment was conducted using a trapezoidal rectangular wave alternating current where time (TP) for reaching the current to its peak from zero was 0.8 msec and a duty ratio was 1:1, and using a carbon electrode as a counter electrode. A ferrite was used as an auxiliary anode. The electrolytic cell used was a radial cell type. The current density was 25 A/dm² at the peak current, and the electric quantity was 50 C/dm² in terms of the total electric quantity during the aluminum plate functioning as an anode. Subsequently, the plate was washed with water by spraying.

### (h) Anodizing treatment

Anodizing treatment of the aluminum plate was conducted using an anodizing treatment apparatus according to a two-stage feeding electrolytic treatment method (lengths of a first electrolytic unit and a second electrolytic unit: 6 m each; lengths of a first feeding unit and a second feeding unit: 3 m each; lengths of a first feeding electrode unit and a second feeding electrode unit: 2.4 m each). The electrolytic solutions supplied to the first electrolytic unit and second electrolytic unit had a sulfuric acid concentration of 50 g/liter (containing 0.5% by weight of aluminum ion) and temperature of 20°C, respectively. Subsequently, the plate was washed with water by spraying. The amount of the final anodic oxide film was 2.7 g/m².

The aluminum plate subjected to conducting all steps (a) to (h) was referred to as Support 1. The aluminium plate subjected to conducting only steps (d) to (h) was referred to as Support 2. The aluminum plate subjected to conducting only steps (d) to (f) and (h) was referred to as Support 3. The center line average roughness (Ra indication according to JIS B0601) of each support was measured using a stylus having a diameter of 2 µm and it was found that the center line average roughness of Support 1, Support 2 and Support 3 were 0.52 µm, 0.28 µm and 0.25 µm, respectively.

Supports 1 to 3 were immersed in an aqueous solution containing 4 g/liter of polyvinylphosphonic acid of 40°C for 10 seconds, washed with tap water of 20°C for 2 seconds and dried to prepare Supports 4 to 6, respectively.
On Supports 1 to 3 was coated Undercoat solution 1 shown below using a bar coater so as to have a dry coating amount of 2 mg/m², followed by drying at 80°C for 20 seconds to prepare Supports 7 to 9, respectively.

| [Undercoat solution 1] | |
|---|---|
| Polymer (SP1) shown below (Mw = 50,000) | 0.3 g |
| Pure water | 60.0 g |
| Methanol | 939.7 g |

### Polymer (SP1)

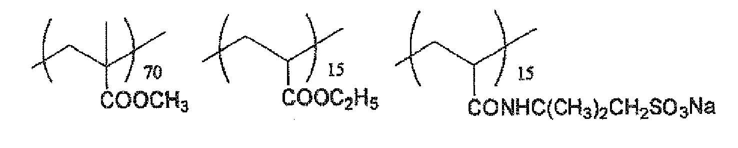

On Supports 1 to 3 was coated Undercoat solution 2 shown below using a bar coater so as to have a dry coating amount of 20 mg/m², followed by drying at 80°C for 20 seconds to prepare Supports 10 to 12, respectively.

| [Undercoat solution 2] | |
|---|---|
| Sol solution shown below | 200 g |
| Methanol | 800 g |

| (Sol solution) | |
|---|---|
| PHOSMER PE (produced by Uni-Chemical Co., Ltd) | 52 g |
| Methanol | 44 g |
| Water | 14 g |
| Phosphoric acid (85% by weight) | 11 g |
| Tetraethoxysilane | 36 g |
| 3-Methacryloxypropyltrimethoxysilane | 12 g |

On Supports 1 to 3 was coated Undercoat solution 3 shown below using a bar coater so as to have a dry coating amount of 2 mg/m², followed by drying at 80°C for 20 seconds to prepare Supports 13 to 15, respectively.

| | |
|---|---|
| [Undercoat solution 3] | |
| Polymer (SP2) shown below (Mw = 30,000) | 0.3 g |
| Pure water | 60.0 g |
| Methanol | 939.7 g |

### Polymer (SP2)

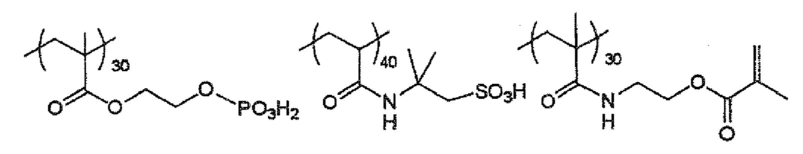

### [Formation of Photosensitive layer]

### <Photosensitive layer 1>

Coating solution 1 for photosensitive layer having the composition shown below was coated on a support using a bar coater and dried at 90°C for one minute to form Photosensitive layer 1. The dry coating amount of the photosensitive layer was 1.35 g/m².

| (Coating solution 1 for photosensitive layer) | |
|---|---|
| Polymerizable compound (PLEX 6661-O, produced by Degussa AG) | 1.69 parts by weight |
| Binder polymer PP-3 described hereinbefore | 1.87 parts by weight |
| Sensitizing dye (D40) described hereinbefore | 0.13 parts by weight |
| Polymerization initiator shown below (produced by Kurogane Kasei Co., Ltd.) | 0.46 parts by weight |
| 25% Methyl ethyl ketone dispersion of ε-Phthalocyanine(F1) shown below | 1.70 parts by weight |
| Mercapto group-containing heterocyclic compound (SH-8) described hereinbefore | 0.34 parts by weight |
| Fluorine-based nonionic surfactant (MEGAFAC F-780F, produced by Dainippon Ink & Chemicals, Inc.) | 0.03 parts by weight |
| CUPFERRON AL (produced by Wako Pure Chemical Industries, Ltd)(10% tricresyl phosphate solution) | 0.12 parts by weight |
| Methyl ethyl ketone | 27.0 parts by weight |
| Propylene glycol monomethyl ether | 26.7 parts by weight |
| NOVOPERM YELLOW H2G (produced by Clariant Corp.) | 0.20 parts by weight |

Binder Polymer PP-3 used in the coating solution for photosensitive layer had a molar ratio of the repeating units of 10:14:76 in order from the left and a weight average molecular weight of 90,000.

### ε-Phthalocyanine (F1)

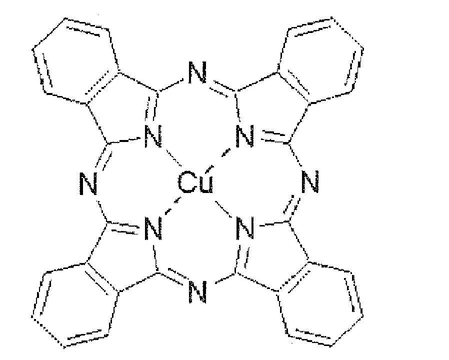

### Polymerization initiator

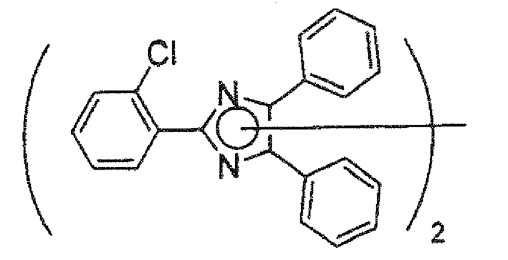

### <Photosensitive layer 2>

Coating solution 2 for photosensitive layer having the composition shown below was coated on a support so as to have a dry coating amount of 1.4 g/m² and dried at 100°C for one minute to form Photosensitive layer 2.

| | |
|---|---|
| (Coating solution 2 for photosensitive layer) | |
| Polymerizable compound (Compound A) | 4.0 parts by weight |
| Binder polymer (Binder A) (Mw =1 100,000) | 2.0 parts by weight |
| Sensitizing dye (C-1) shown below | 0.32 parts by weight |
| Polymerization initiator (D-1) shown below | 0.61 parts by weight |
| Chain transfer agent (E-1) shown below | 0.57 parts by weight |
| N-Nitrosophenylhydroxylamine aluminum salt | 0.020 part by weight |
| Dispersion of ε-phthalocyanine pigment (pigment: 15 parts by weight; dispersing agent (Polymer (1) shown below): 10 parts by weight; solvent (cyclohexanone/methoxypropyl acetate/1-methoxy-2-propanol = 15 parts by weight/20 parts by weight/40 parts by weight)) | 0.71 parts by weight |
| Fluorine-based nonionic surfactant (MEGAFAC F-780, produced by Dainippon Ink & Chemicals, Inc.) | 0.016 part by weight |
| Methyl ethyl ketone | 47 parts by weight |
| Propylene glycol monomethyl ether | 45 parts by weight |

### Compound A

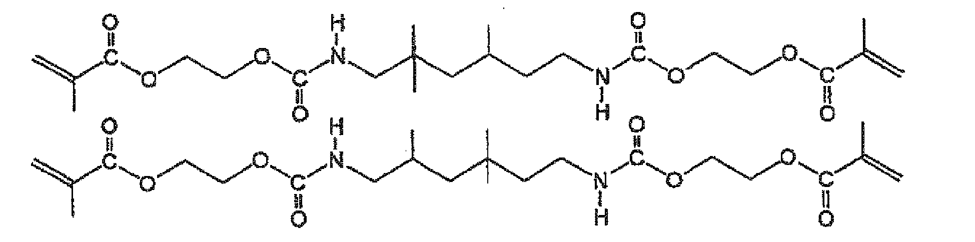

Mixture of the isomers shown above

### Binder A

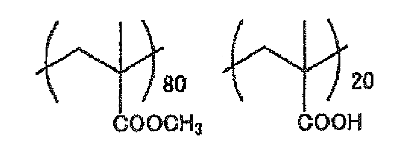

### Sensitizing dye (C-1)

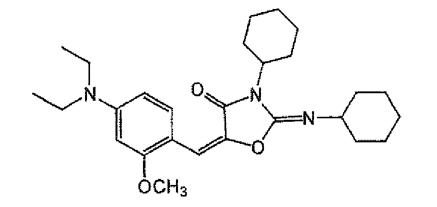

### Polymerization initiator (D-1)

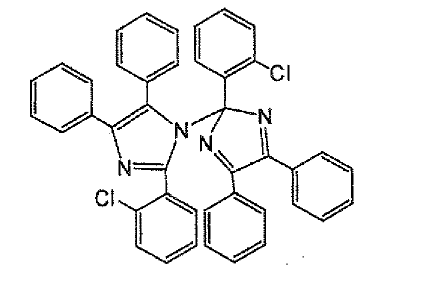

### Chain transfer agent (E-1)

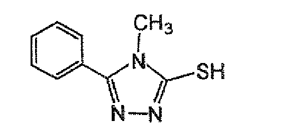

### <Photosensitive layer 3>

Coating solution 3 for photosensitive layer having the composition shown below was coated on a support using a bar and dried in an oven at 100°C for 44 seconds to form Photosensitive layer 3 having a dry coating amount of 1.3 g/m².

| (Coating solution 3 for photosensitive layer) | |
|---|---|
| Binder polymer PU-A shown below | 0.45 g |
| Polymerizable Compound (1) shown below | 0.52 g |
| (PLEX 6661-O, produced by Degussa Japan) | |
| Sensitizing dye (1) shown below | 0.04 g |
| Polymerization initiator (1) shown below | 0.08 g |
| Co-sensitizer (1) shown below | 0.05 g |
| Dispersion of ε-phthalocyanine pigment | 0.40 g |
| (pigment: 15 parts by weight; dispersing agent (Polymer (1) shown below): 10 parts by weight; solvent (cyclohexanone/methoxypropyl acetate/1-methoxy-2-propanol = 15 parts by weight/20 parts by weight/40 parts by weight)) | |
| Thermal polymerization inhibitor | 0.006 g |
| (N-nitrosophenylhydroxylamine aluminum salt) | |
| Fluorine-based surfactant (1) shown below | 0.002 g |
| 1-Methoxy-2-propanol | 8.0 g |
| Methyl ethyl ketone | 8.0 g |

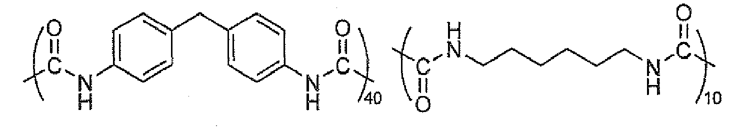

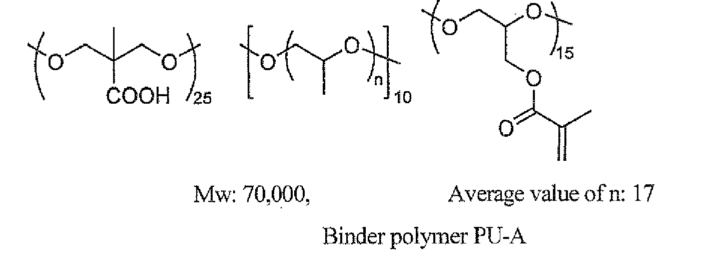

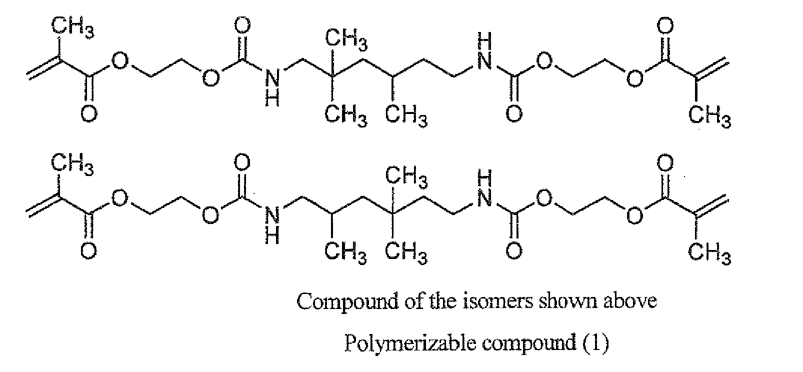

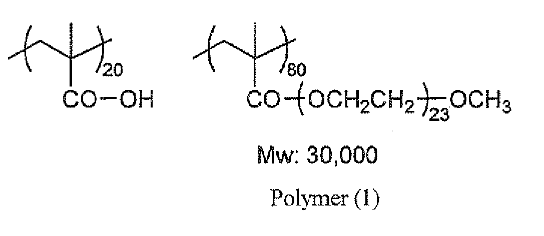

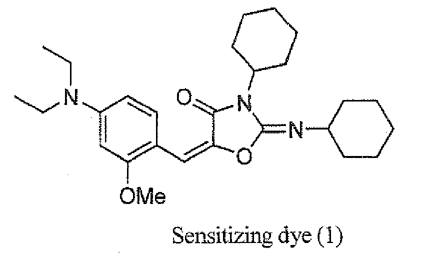

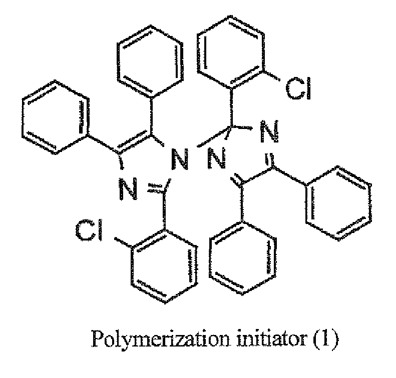

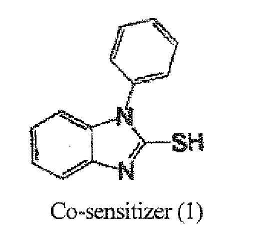

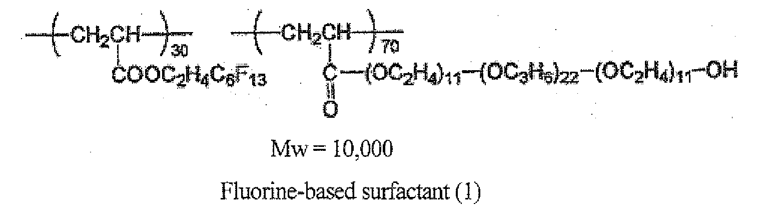

### <Photosensitive layer 4>

Photosensitive layer 4 was formed in the same manner as in the formation of Photosensitive layer 1 except for using Sensitizing dye (A) shown below in place of Sensitizing dye (D40) used in Coating solution 1 for photosensitive layer.

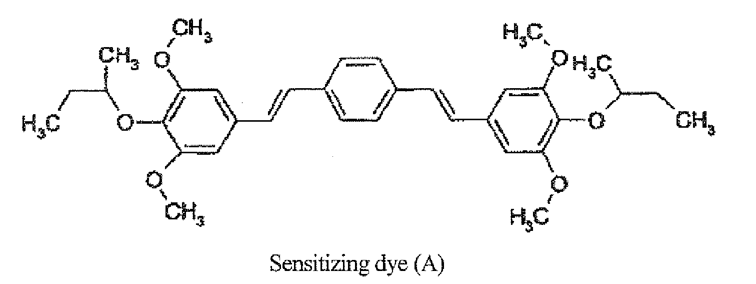

### <Photosensitive layer 5>

Photosensitive layer 5 was formed in the same manner as in the formation of Photosensitive layer 1 except for using Sensitizing dye (B) shown below in place of Sensitizing dye (D40) used in Coating solution 1 for photosensitive layer.

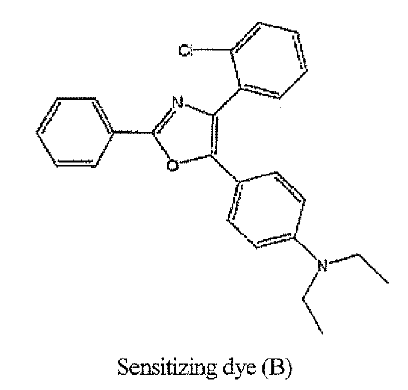

### [Formation of protective layer]

### <Protective layer 1>

Coating solution for protective layer having the composition shown below was coated on a photosensitive layer using a bar coater so as to have a dry coating amount of 2.5 g/m² and dried at 120°C for one minute to form Protective layer 1.

| (Coating solution for protective layer) | |
|---|---|
| PVA 105 (saponification degree: 98% by mole, produced by Kuraray Co., Ltd.) | 1.80 parts by weight |
| Polyvinylpyrrolidone | 0.40 parts by weight |
| EMALEX 710 (nonionic surfactant, produced by Nihon Emulsion Co., Ltd.) | 0.04 parts by weight |
| PIONIN D230 (surfactant, produced by Takemoto Oil & Fat Co., Ltd.) | 0.05 parts by weight |
| LUVISKOL V64W (produced by BASF) | 0.06 parts by weight |
| 13% Aqueous solution of polymer (Mw = 50,000) shown below | 0.36 parts by weight |
| Pure water | 36.0 parts by weight |

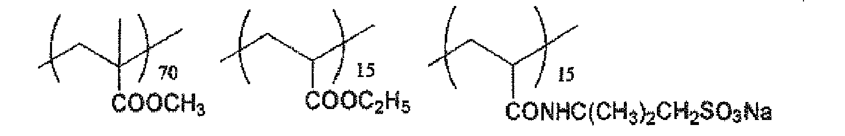

### <Protective layer 2>

Protective layer 2 was prepared in the same manner as in the formation of Protective layer 1 except for changing PVA 105 used in Protective layer 1 to GOSERAN CKS-50 (produced by Nippon Synthetic Chemical Industry Co., Ltd., saponification degree: 99% by mole; average polymerization degree: 300; modification degree: about 0.4% by mole).

### <Protective layer 3>

A mixed aqueous solution of 80% by weight of polyvinyl alcohol (saponification degree: 98% by mole, polymerization degree: 500), 17% by weight of polyvinylpyrrolidone (LUVISKOL K-30, produced by BASF), 1.0% by weight of EMALEX 710 (nonionic surfactant, produced by Nihon Emulsion Co., Ltd.) and 2% by weight of a surfactant (PIONIN D230, produced by Takemoto Oil & Fat Co., Ltd.) was coated on a photosensitive layer using a wire bar and dried by a hot air drying device at 125°C for 75 seconds to form Protective layer 3 having a dry coating amount of 2.45 g/m².

### <Protective layer 4>

Coating solution for protective layer having the composition shown below was coated on a photosensitive layer using a bar and dried in an oven at 125°C for 70 seconds to form Protective layer 4 having a dry coating amount of 1.25 g/m².

| (Coating solution for protective layer) | |
|---|---|
| Dispersion of mica shown below | 0.6 g |
| Sulfonic acid-modified polyvinyl alcohol (GOSERAN CKS-50, produced by Nippon Synthetic Chemical Industry Co., Ltd., saponification degree: 99% by mole, average polymerization degree: 300, modification degree: about 0.4% by mole) | 0.8 g |
| Vinyl pyrrolidone/vinyl acetate (1/1) copolymer (molecular weight: 70,000) | 0.001 g |
| Surfactant (EMALEX 710, produced by Nihon Emulsion Co., | 0.002 g |
| Ltd.) | |
| Water | 13 g |

### (Dispersion of mica)

In 368 g of water was added 32 g of synthetic mica (SOMASIF ME-100, produced by CO-OP Chemical Co., Ltd., aspect ratio: 1,000 or more) and the mixture was dispersed using a homogenizer until the average particle diameter (measured by a laser scattering method) became 0.5 µm to obtain the dispersion of mica.

Supports 4 to 15, Photosensitive layers 1 to 5 and Protective layers 1 to 4 described above were used in the combination as shown in Table A below to prepare 15 kinds of lithographic printing plate precursors.

### [Exposure, Development and Printing]

Each lithographic printing plate precursor was subjected to image exposure by Violet Semiconductor Laser Plate Setter Vx9600 (equipped with InGaN semiconductor laser (emission wavelemgth: 405 nm ± 10 nm/output: 30 mW)) produced by FFEI, Ltd. The image drawing was performed using an FM screen (TAFFETA 20, produced by FUJIFILM Corp.) at resolution or 2,438 dpi. and in a plate surface exposure amount of 0.05 mJ/cm².
Then, the exposed lithographic printing plate precursor was pre-heated at 100°C for 30 seconds and subjected to development processing (one solution and one bath processing) by an automatic development processor having a structure as shown in Fig. 1 using each processing solution having the composition shown below. The automatic development processor had a 25 liter developing tank and one brush roller having an outer diameter of 50 mm and being implanted with fiber of polybutylene terephthalate (bristle diameter: 200 µm, bristle length: 17 mm), and the brush roller was rotated at 200 rpm in the same direction as the transporting direction (peripheral velocity at the tip of brush: 0.52 m/sec). The temperature of the processing solution was 30°C. The transportation of the lithographic printing plate precursor was performed at transporting speed of 100 cm/min. After the development processing, drying was conducted in a drying unit. The temperature of the drying was 80°C.

| Processing solution 1 (pH: 9.7) | |
|---|---|
| Water | 9279.8 g |
| Sodium carbonate | 130 g |
| Sodium hydrogen carbonate | 70 g |
| NEWCOL B13 | 500 g |
| (polyoxyalkylene aryl ether (nonionic surfactant produced by Nippon Nyukazai Co., Ltd.)) | |
| Ammonium primary phosphate | 20 g |
| 2-Bromo-2-nitropropane-1,3-diol | 0.1 g |
| 2-Methyl-4-isothiazolin-3-one | 0.1 g |

| Processing solution 2 (pH: 9.7) | |
|---|---|
| Water | 8963.8 g |
| Sodium carbonate | 200 g |
| Sodium hydrogen carbonate | 100 g |
| NEWCOL B4SN (61 % aqueous solution) (polyoxyethylene naphthyl ether sulfate (anionic surfactant produced by Nippon Nyukazai Co., Ltd.)) | 656 g |
| EDTA 4Na | 80 g |
| 2-Bromo-2-nitropropane-1,3-diol | 0.1 g |
| 2-Methyl-4-isothiazolin-3-one | 0.1 g |

| Processing solution 3 (pH: 9.7) | |
|---|---|
| Water | 8665 g |
| Potassium carbonate | 150 g |
| Potassium hydrogen carbonate | 80 g |
| ELEMINOL MON (47% aqueous solution) | 745 g |
| (sodium dodecyldiphenyl ether disulfonate (anionic surfactant produced by Sanyo Chemical Industries, Ltd.)) | |
| Ammonium primary phosphate | 180 g |
| Sodium hexametaphosphate | 180g |

| Processing solution 4 (pH: 9.5) | |
|---|---|
| Water | 9009.8 g |
| Sodium carbonate | 200 g |
| Sodium hydrogen carbonate | 140 g |
| PIONIN D311 0 | 450 g |
| (polyoxyethylene laurylamino ether (nonionic surfactant produced by Takemoto Oil & Fat Co., Ltd.)) | |
| Sodium citrate | 100 g |
| Ammonium primary phosphate | 20 g |
| Propylene glycol | 80 g |
| 2-Bromo-2-nitropropane-1,3-diol | 0.1 g |
| 2-Methyl-4-isothiazolin-3-one | 0.1 g |

| Processing solution 5 (pH: 9.8) | |
|---|---|
| Water | 8150.8 g |
| Sodium carbonate | 200 g |
| Sodium hydrogen carbonate | 80 g |
| PELEX NBL (35% aqueous solution) | 1429 g |
| (sodium alkylnaphthalenesulfonate (anionic surfactant produced by Kao Corp.)) | |
| Citric acid | 40 g |
| Ammonium primary phosphate | 20 g |
| Propylene glycol | 80 g |
| 2-Bromo-2-nitropropane-1,3-diol | 0.1 g |
| 2-Methyl-4-isothiazolin-3-one | 0.1 g |

| Processing solution 6 (pH: 9.5) | |
|---|---|
| Water | 8250 g |
| Sodium carbonate | 160 g |
| Sodium hydrogen carbonate | 160 g |
| PIONIN C157K (40% aqueous solution) (amphoteric surfactant, W-2 | 1250 g |
| described hereinbefore) | |
| Sodium hexametaphosphate | 180 g |

| Processing solution 7 (pH: 9.4) | |
|---|---|
| Water | 7099.8 g |
| Sodium carbonate | 130 g |
| Sodium hydrogen carbonate | 70 g |
| TAKESURF C-157-L (30% aqueous solution) (amphoteric surfactant produced by Takemoto Oil & Fat Co., Ltd., W-2 described hereinbefore) | 2500 g |
| 2-Bromo-2-nitropropane-1,3-diotl | 0.1 g |
| 2-Methyl-4-isothiazolin-3-one | 0.1 g |
| Sodium citrate | 150 g |
| EDTA 4Na | 50 g |

| Processing solution 8 (pH: 9.7) | |
|---|---|
| Water | 9219.8 g |
| Potassium carbonate | 130 g |
| Potassium hydrogen carbonate | 70 g |
| W-1 | 560 g |
| (betaine surfactant) | |
| Ammonium primary phosphate | 20 g |
| 2-Bromo-2-nitropropane-1,3-diol | 0.1 g |
| 2-Methyl-4-isothiazolin-3-one | 0.1 g |

| Processing solution 9 (pH: 9.7) | |
|---|---|
| Water | 8969.8 g |
| Potassium carbonate | 200 g |
| Potassium hydrogen carbonate | 100 g |
| W-18 | 650 g |
| EDTA 4Na | 80 g |
| 2-Bromo-2-nitropropane-1,3-diol | 0.1 g |
| 2-Methyl-4-isothiazolin-3-one | 0.1 g |

| Processing solution 10 (pH: 8.6) | |
|---|---|
| Water | 9219.8 g |
| Potassium carbonate | 10 g |
| Potassium hydrogen carbonate | 200 g |
| W-1 | 560 g |
| (betaine surfactant) | |
| Ammonium primary phosphate | 20 g |
| 2-Bromo-2-nitropropane-1,3-diol | 0.1 g |
| 2-Methyl-4-isothiazolin-3 -one | 0.1 g |

| Processing solution 11 (pH: 10.5) | |
|---|---|
| Water | 9219.8 g |
| Sodium carbonate | 180 g |
| Sodium hydrogen carbonate | 20 g |
| W-1 | 560 g |
| (betaine surfactant) | |
| Ammonium primary phosphate | 20 g |
| 2-Bromo-2-nitropropane-1,3-diol | 0.1 g |
| 2-Methyl-4-isothiazolin-3-one | 0.1 g |

| Comparative processing solution 1 (pH: 9.7) | |
|---|---|
| Water | 9779.8 g |
| Sodium carbonate | 130 g |
| Sodium hydrogen carbonate | 70 g |
| Ammonium primary phosphate | 20 g |
| 2-Bromo-2-nitropropane-1,3-diol | 0.1 g |
| 2-Methyl-4-isothiazolin-3-one | 0.1 g |

| Comparative processing solution 2 (pH: 11.9) | |
|---|---|
| Water | 9448.8 g |
| Potassium carbonate | 17 g |
| KOH (48%) | 14 g |
| NEWCOL B13 | 500g |
| Ammonium primary phosphate | 20 g |
| 2-Bromo-2-nitropropane-1,3-diol | 0.1 g |
| 2-Methyl-4-isothiazolin-3-one | 0.1 g |

| Comparative processing solution 3 (pH: 11.9) | |
|---|---|
| Water | 7799.8 g |
| SURFYNOL 465 | 500 g |
| (ethoxylated 2,4,7,9-tetramethyl-5-decyn-4,7-diol (nonionic surfactant produced by Airproducts and Chemicals Inc.)) | |
| Sodium tertiary phosphate | 500 g |
| EMDEX 30AN45 | 1200 g |
| (dextrin derived from potato starch, produced by Emsland Staerke GmbH) | |
| 2-Bromo-2-nitropropane-1,3-diol | 0.1 g |
| 2-Methyl-4-isothiazolin-3-one | 0.1 g |

The lithographic printing plate obtained was mounted on a printing machine (SOR-M, produced by Heidelberg) and printing was performed at a printing speed of 6,000 sheets per hour using dampening water (EU-3 (etching solution, produced by FUJIFILM Corp.))/water/isopropyl alcohol = 1/89/10 (by volume ratio)) and TRANS-G(N) black ink (produced by Dai-Nippon Ink & Chemicals, Inc.).

### [Evaluation]

Using each lithographic printing plate precursor, the developing property, processing property and printing durability were evaluated in the manner described below.

### <Processing property>

After each lithographic printing plate precursor was subjected to development processing under the conditions described above in an amount of 500 m² taking one week, the occurrence of scum adhered on the tank wall of the automatic development processor was visually observed. The scum occurred was mainly caused by the binder of the protective layer. The evaluation was conducted according to the following criteria:
O: Case where the scum did not occur.
Δ: Case where although the scum occurred, it was at the acceptable level.
X: Case where the occurrence of scum was severe.

### <Tackiness of plate surface>

After the development processing of 500 m² described above, the last plate was touched with hards to compare the degree of tackiness of the plate surface. The evaluation was conducted as relative comparison according to the following criteria:
O: Case where the plate surface was dry.
X: Case where the plate surface was tacky.
Δ: Case of intermediate degree.

### <Printing durability>

As increase in the number of printed materials, the image area of the photosensitive layer formed on the lithographic printing plate was gradually abraded to cause decrease in the ink receptivity, resulting in decrease in ink density of the image on the printed material. A number of printed materials obtained until the ink density (reflection density) decreased by 0.1 from that at the initiation of printing was determined to evaluate the printing durability (just after preparation). Also, after the preparation of the lithographic printing plate, it was allowed to stand under ain environment of temperature of 25°C and humidity of 60% for one week and then subjected to the printing under the conditions described above to evaluate the printing durability (after one week preservation) in the same manner.
The results of the evaluation are shown in Table A.

**TABLE 2**

| | Support | Photosensitive Layer | Protective Layer | Processing Solution | Processing Property | Tackiness of Plate Surface | Printing Durability (x 10³ sheets)) | |
|---|---|---|---|---|---|---|---|---|
| | | | | | | | Just after Preparation | After One Week Preservation |
| Example 1 | 5 | 1 | 2 | 1 | O | O | 50 | 45 |
| Example 2 | 5 | 1 | 2 | 2 | O | O | 55 | 50 |
| Example 3 | 5 | 1 | 2 | 3 | O | O | 50 | 50 |
| Example 4 | 5 | 1 | 2 | 4 | O | O | 55 | 50 |
| Example 5 | 5 | 1 | 2 | 5 | O | O | 50 | 45 |
| Example 6 | 5 | 1 | 2 | 6 | O | O | 55 | 50 |
| Example 7 | 5 | 1 | 2 | 7 | O | O | 50 | 50 |
| Example 8 | 4 | 1 | 2 | 1 | O | O | 55 | 50 |
| Example 9 | 6 | 1 | 2 | 1 | O | O | 50 | 45 |
| Example 10 | 7 | 1 | 2 | 1 | O | O | 60 | 55 |
| Example 11 | 8 | 1 | 2 | 1 | O | O | 55 | 50 |
| Example 12 | 9 | 1 | 2 | 1 | O | O | 45 | 45 |
| Example 13 | 10 | 1 | 2 | 1 | O | O | 65 | 55 |
| Example 14 | 11 | 1 | 2 | 1 | O | O | 60 | 55 |
| Example 15 | 12 | 1 | 2 | 1 | O | O | 50 | 45 |
| Example 16 | 13 | 1 | 2 | 1 | O | O | 50 | 50 |
| Example 17 | 14 | 1 | 2 | 1 | O | O | 55 | 55 |
| Example 18 | 15 | 1 | 2 | 1 | O | O | 55 | 50 |
| Example 19 | 5 | 1 | 1 | 1 | O | O | 50 | 50 |
| Example 20 | 5 | 2 | 3 | 1 | O | O | 55 | 50 |
| Example 21 | 5 | 3 | 4 | 1 | O | O | 55 | 55 |
| Example 22 | 5 | 4 | 2 | 1 | O | O | 55 | 50 |
| Example 23 | 5 | 5 | 2 | 1 | O | O | 50 | 45 |
| Example 24 | 5 | 1 | 2 | 8 | O | O | 50 | 50 |
| Example 25 | 5 | 1 | 2 | 9 | O | O | 60 | 55 |
| Example 26 | 5 | 1 | 2 | 10 | O | O | 55 | 55 |
| Example 27 | 5 | 1 | 2 | 11 | O | O | 50 | 45 |
| Comparative Example 1 | 5 | 1 | 2 | Comparative Processing Solution 1 | X | O | 50 | 50 |
| Comparative Example 2 | 5 | 1 | 2 | Comparative Processing Solution 2 | X | Δ | 40 | 15 |
| Comparative Example 3 | 5 | 1 | 2 | Comparative Processing Solution 3 | Δ | X | 45 | 50 |

From the results shown in Table A, it can be seen that according to the method of preparing a lithographic printing plate of the invention, despite the one bath processing with the weak alkaline developer, the occurrence of scum in the developing tank is prevented, the processing property is excellent, and the tackiness of the surface of printing plate is prevented. Further, the deterioration of the printing durability caused by preservation of lithographic printing plate after the development processing is hardly recognized.

### INDUSTRIAL APPLICABILITY

The method of preparing a lithographic printing plate according to the invention is excellent in the processing property and provides a lithographic printing plate free from the tackiness on the surface thereof. Further, even when the lithographic printing plate is preserved after the development until printing, deterioration of the printing durability does not occur. Moreover, since it becomes possible to conduct one solution development with a weak alkaline processing solution, advantages, for example, simplification of processing steps, consideration for global environment and adaptation for space saving and low running cost can be achieved.

Although the invention has been described in detail and by reference to specific embodiments, it is apparent to those skilled in the art that it is possible to add various alterations and modifications insofar as the alterations and modifications do not deviate from the spirit and the scope of the invention.
This application is based on a Japanese patent application filed on August 22, 2008 (Japanese Patent Application No. 2008-214507) and a Japanese patent application filed on December 4, 2008 (Japanese Patent Application No. 2008-309666), and the contents thereof are incorporated herein by reference.

### DESCRIPTION OF REFERENCE NUMERALS AND SIGNS

- 4: Lithographic printing plate precursor
- 6: Developing unit
- 10: Drying unit
- 16: Transport roller
- 20: Developing tank
- 22: Transport roller
- 24: Brush roller
- 26: Squeeze roller
- 28: Backup roller
- 36: Guide roller
- 38: Skewer roller

## Claims

1. A method of preparing a lithographic printing plate, substantially comprising:
imagewise exposing a negative lithographic printing plate precursor comprising an image-recording layer containing the following (i), (ii), (iii) and (iv) on a support; and
processing the exposed lithographic printing plate precursor with an aqueous solution containing a carbonate ion, a hydrogen carbonate ion and a surfactant,
(i) a sensitizing dye,
(ii) a photopolymerization initiator,
(iii) an addition polymerizable compound having an ethylenically unsaturated double bond,
(iv) a binder polymer.

2. The method of preparing a lithographic printing plate as claimed in claim 1, wherein the aqueous solution does not contain a water-soluble polymer compound.

3. The method of preparing a lithographic printing plate as claimed in claim 1 or 2, wherein the sensitizing dye (i) has an absorption maximum in a wavelength range from 350 to 450 nm.

4. The method of preparing a lithographic printing plate as claimed in claim 3, wherein the sensitizing dye (i) is a sensitizing dye represented by one of the following formulae (1) to (5): 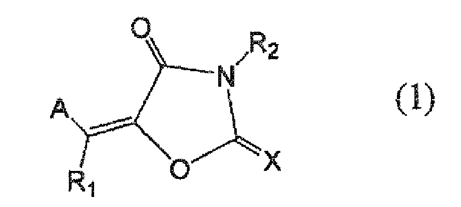 wherein, in the formula (1), A represents an aromatic cyclic group which may have a substituent or a heterocyclic group which may have a substituent, X represents an oxygen atom, a sulfur atom or N-(R₃), and R₁, R₂ and R₃ each independently represents a monovalent non-metallic atomic group, or A and R₁ or R₂ and R₃ may be combined with each other to form an aliphatic or aromatic ring; 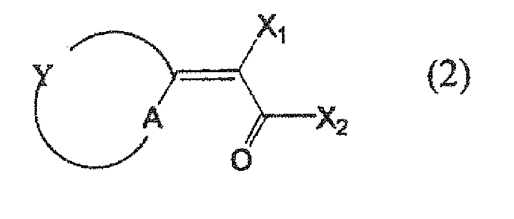 wherein in the formula (2), A represents a sulfur atom or NR₆, R₆ represents a monovalent non-metallic atomic group, Y represents a non-metallic atomic group necessary for forming a basic nucleus of the dye together with adjacent A and the adjacent carbon atom, and X₁ and X₂ each independently represents a monovalent non-metallic atomic group or X₁ and X₂ may be combined with each other to form an acidic nucleus of the dye; 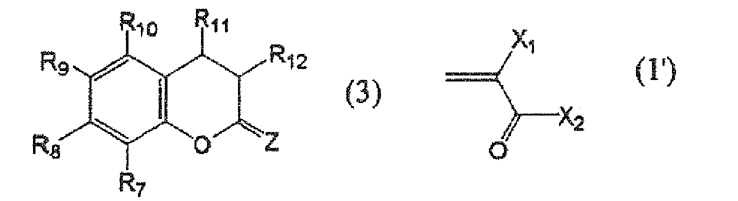 wherein, in the formula (3), =Z represents an oxo group, a thioxo group, an imino group or an alkylydene group represented by the foregoing partial structural formula (1'), X₁ and X₂ have the same meanings as defined in the formula (2) respectively, and R₇ to R₁₂ each independently represents a monovalent non-metallic atomic group; 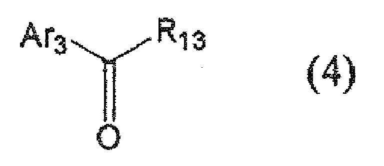 wherein, in the formula (4), Ar₃ represents an aromatic group which may have a substituent or a heteroaromatic group which may have a substituent, R₁₃ represents a monovalent neon-metallic atomic group, or Ar₃ and R₁₃ may be combined with each other to form a ring; 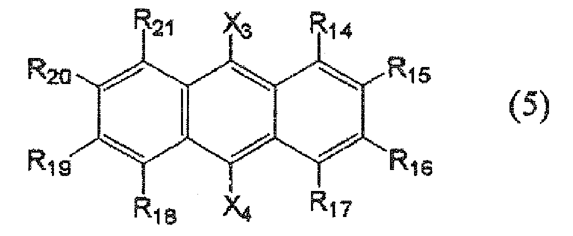 wherein, in the formula (5), X₃, X₄ and R₁₄ to R₂₁ each independently represents a monovalent non-metallic atomic group.

5. The method of preparing a lithographic printing plate as claimed in claim 3, wherein the sensitizing dye (i) is a sensitizing dye represented by the following formula (I), (II) or (III): 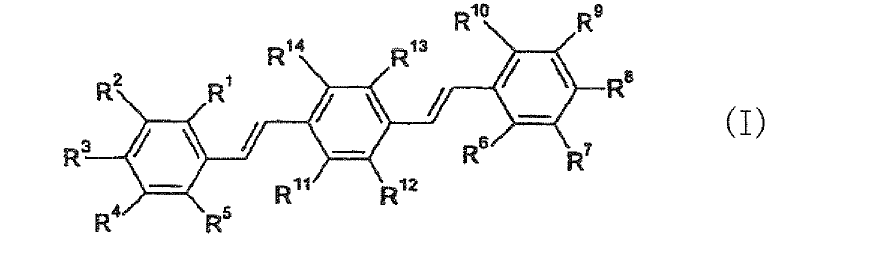 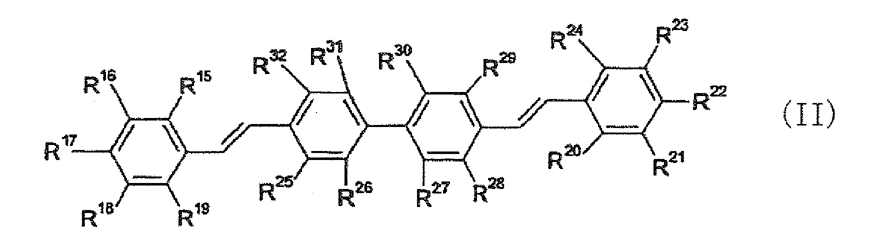 wherein, in the formula (I), R¹ to R¹⁴ each independently represents a hydrogen atom, an alkyl group, an alkoxy group, a cyano group or a halogen atom, provided that at least one of R¹ to R¹⁰ represents an alkoxy group having 2 or more carbon atoms, in the formula (II), R¹⁵ to R³² each independently represents a hydrogen atom, an alkyl group, an alkoxy group, a cyano group or a halogen atom, provided that at least one of R¹⁵ to R²⁴ represents an alkoxy group having 2 or more carbon atoms, 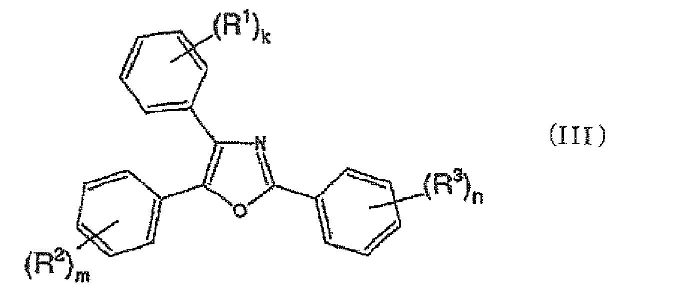 wherein in the formula (III), R¹, R² and R³ each independently represents a halogen atom, an alkyl group which may have a substituent, an aryl group which may have a substituent, an aralkyl group which may have a substituent, an NR⁴R⁵ group or an -OR⁶ group, R⁴, R⁵ and R⁶ each independently represents a hydrogen atom, an alkyl group which may have a substituent, an aryl group which may have a substituent or an aralkyl group which may have a substituent, and k, m and n each represents an integer from 0 to 5.

6. The method of preparing a lithographic printing plate as claimed in any one of claims 1 to 5, wherein the imagewise exposing is conducted using laser emitting light from 350 to 450 nm.

7. The method of preparing a lithographic printing plate as claimed in any one of claims 1 to 6, wherein pH of the aqueous solution is from 8.5 to 10.8.

8. The method of preparing a lithographic printing plate as claimed in any one of claims 1 to 7, wherein the binder polymer (iv) has an acid group in its side chain.

9. The method of preparing a lithographic printing plate as claimed in claim 8, wherein the acid group is a carboxylic acid group.

10. The method of preparing a lithographic printing plate as claimed in any one of claims 1 to 9, wherein the lithographic printing plate precursor comprises a protective layer on the image-recording layer.

11. The method of preparing a lithographic printing plate as claimed in claim 10, wherein the protective layer contains an acid-modified polyvinyl alcohol.

12. The method of preparing a lithographic printing plate as claimed in any one of claims 1 to 11, wherein the processing with an aqueous solution is conducted with one solution.

13. The method of preparing a lithographic printing plate as claimed in any one of claims 1 to 11, wherein the processing with an aqueous solution is conducted with one bath.

14. A lithographic printing plate precursor which is used in the method of preparing a lithographic printing plate as claimed in any one of claims 1 to 13.
